# EUROPEAN PATENT SPECIFICATION

(11) **EP 3 140 367 B1**
(45) Date of publication and mention of the grant of the patent: **29.07.2020**
(21) Application number: 15789715.8
(22) Date of filing: 07.05.2015
(51) Int. Cl.: H01L 51/54, C09K 11/06, H01L 27/32

(54) **MULTI-COMPONENT HOST MATERIAL AND ORGANIC ELECTROLUMINESCENT DEVICE COMPRISING THE SAME**
MEHRKOMPONENTIGES HOST-MATERIAL UND ORGANISCHE ELEKTROLUMINESZENZVORRICHTUNG DAMIT
MATÉRIAU HÔTE À CONSTITUANTS MULTIPLES ET DISPOSITIF ÉLECTROLUMINESCENT ORGANIQUE COMPRENANT LEDIT MATÉRIAU

(30) Priority: 07.05.2014 KR 20140053997; 06.05.2015 KR 20150063037
(43) Date of publication of application: 15.03.2017
(73) Proprietor: Rohm And Haas Electronic Materials Korea Ltd., Chungcheongnam-do 331-980 (KR)
(72) Inventor: AHN, Hee-Choon, Suwon-si Gyeonggi-do 443-400 (KR); KIM, Young-Kwang, Suwon-si Gyeonggi-do 443-814 (KR); MOON, Doo-Hyeon, Hwaseong-si Gyeonggi-do 445-768 (KR); LEE, Su-Hyun, Suwon-si Gyeonggi-do 440-200 (KR); KIM, Chi-Sik, Hwaseong-si Gyeonggi-do 445-752 (KR); LEE, Seon-Woo, Cheonan-si, Chungcheongnam-do 331-980 (KR); JUN, Ji-Song, Cheonan-si, Chungcheongnam-do 331-980 (KR); PARK, Kyoung-Jin, Seongnam-si Gyeonggi-do 462-838 (KR); KIM, Nam-Kyun, Yongin-si Gyeonggi-do 448-527 (KR); CHO, Young-Jun, Seongnam-si Gyeonggi-do 463-400 (KR); CHOI, Kyung-Hoon, Hwaseong-si Gyeonggi-do 445-160 (KR); SHIM, Jae-Hoon, Chungcheongnam-do 331-980 (KR); DOH, Yoo-Jin, Gwacheon-si Gyeonggi-do 427-731 (KR)
(74) Representative: Houghton, Mark Phillip
(86) International application number: PCT/KR2015/004534
(87) International publication number: WO 2015/170882

(56) References cited:
- WO-A1-2013/112557
- WO-A1-2013/147205
- US-A1- 2011 278 555
- US-A1- 2013 234 119
- US-A1- 2014 034 940

## Description

### Technical Field

The present invention relates to a multi-component host material and an organic electroluminescent device comprising the same.

### Background Art

An electroluminescent (EL) device is a self-light-emitting device with the advantages of providing a wider viewing angle, a greater contrast ratio, and a faster response time. The first organic EL device was developed by Eastman Kodak, by using small aromatic diamine molecules and aluminum complexes as materials for forming a light-emitting layer (see Appl. Phys. Lett. 51, 913, 1987).

An organic EL device changes electric energy into light by the application of electric voltage to an organic light-emitting material, and commonly comprises an anode, a cathode, and an organic layer formed between the two electrodes. The organic layer of the organic EL device may be composed of a hole injection layer (HIL), a hole transport layer (HTL), an electron blocking layer (EBL), a light-emitting layer (EML) (containing host and dopant materials), an electron buffer layer, a hole blocking layer (HBL), an electron transport layer (ETL), an electron injection layer (EIL), etc.; the materials used in the organic layer can be classified into a hole injection material, a hole transport material, an electron blocking material, a light-emitting material, an electron buffer material, a hole blocking material, an electron transport material, an electron injection material, etc., depending on functions. In the organic EL device, holes from an anode and electrons from a cathode are injected into a light-emitting layer by electric voltage, and an exciton having high energy is produced by the recombination of holes and electrons. The organic light-emitting compound moves into an excited state by the energy and emits light from energy when the organic light-emitting compound returns to the ground state from the excited state.

The most important factor determining luminous efficiency in an organic EL device is light-emitting materials. The light-emitting materials are required to have the following features: high quantum efficiency, high movement degree of an electron and a hole, and formability of a uniform and stable layer. The light-emitting materials are classified into blue light-emitting materials, green light-emitting materials, and red light-emitting materials according to the light-emitting color, and further include yellow light-emitting materials or orange light-emitting materials. Furthermore, the light-emitting material is classified into a host material and a dopant material in a functional aspect. Recently, an urgent task is the development of an organic EL device having high efficiency and long operating lifespan. In particular, the development of highly excellent light-emitting material compared to conventional light-emitting materials is urgently required considering the EL properties necessary for medium- and large-sized OLED panels. For this, preferably, as a solvent in a solid state and an energy transmitter, a host material should have high purity and a suitable molecular weight in order to be deposited under vacuum. Furthermore, a host material is required to have high glass transition temperature and pyrolysis temperature for guaranteeing thermal stability, high electrochemical stability for long lifespan, easy formability of an amorphous thin film, good adhesion with adjacent layers, and no movement between layers.

A mixed system of a dopant/host material can be used as a light-emitting material to improve color purity, luminous efficiency, and stability. Generally, the device having the most excellent EL properties comprises the light-emitting layer, wherein a dopant is doped onto a host. If the dopant/host material system is used, the selection of the host material is important because the host material greatly influences efficiency and performance of a light-emitting device.

WO2013/112557 A1 discloses organic EL devices comprising a dopant and multi-component host. The above literature uses a host having a carbazole-carbazole skeleton as a first host and a benzothiophene, benzofuran, dibenzothiophene, or dibenzofuran-based compound as a second host.

US2011/278555 discloses a biscarbazole derivative represented by formula (1A) or (1B) discloses therein, a material for an organic electroluminescence device, and an organic electroluminescence device using those.

US2014/034940 discloses an organic optoelectronic device, an organic light emitting diode including the same, and a display device including the organic light emitting diode, the material including at least one compound represented by Formula A-1, and at least one compound represented by Chemical Formula B-1 disclosed therein.

The present inventors have found that an organic EL device which uses a multi-component host as a host, which has a bicarbazole derivative containing pyridine and a carbazole derivative including a nitrogen-containing heteroaryl group, has high efficiency and long lifespan.

### Disclosure of the Invention

### Problems to be Solved

The object of the present invention is to provide an organic EL device having high efficiency and long lifespan.

### Solution to Problems

The invention is set out in accordance with the appended claims. The above objective can be achieved by an organic EL device comprising at least one light-emitting layer between an anode and a cathode, wherein the light-emitting layer comprises a host and a phosphorescent dopant; the host consists of multi-component host compounds; at least a first host compound of the multi-component host compounds is represented by the following formula 1 which is a bicarbazole derivative containing pyridine, and a second host compound is represented by the following formula 2 which is a carbazole derivative including a nitrogen-containing heteroaryl group: 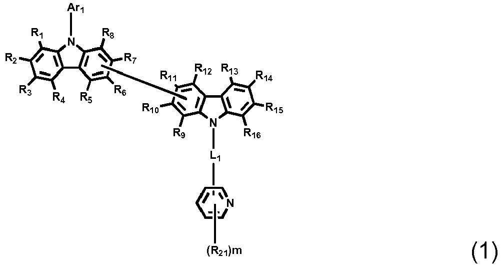 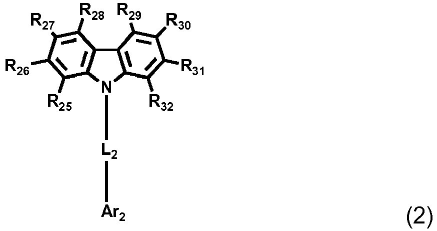 Wherein
Ar₁ represents a substituted or unsubstituted (C6-C30)aryl group;
L₁ and L₂ each independently represent a substituted or unsubstituted (C6-C18)arylene group, wherein the substituent(s) of the substituted arylene group of L₁ and L₂ is independently selected from the group consisting of hydrogen, deuterium, and an unsubstituted (C6-C60)aryl group;
R₁ to R₁₆ and R₂₁ each independently represent hydrogen, deuterium, or a substituted or unsubstituted (C6-C60)aryl group;
wherein the substituents of the substituted (C6-C60)aryl group of R₁ to R₁₆ and R₂₁ are selected from the group consisting of (C1-C30)alkyl and (C6-C30)aryl;
one of R₅ to R₈ is linked to one of Rg to R₁₂ via a single bond;
R25 to R32 each independently represent hydrogen, deuterium, a substituted or unsubstituted (C1-C30)alkyl group, a substituted or unsubstituted (C2-C30)alkenyl group, a substituted or unsubstituted (C2-C30)alkynyl group, a substituted or unsubstituted (C3-C30)cycloalkyl group, a substituted or unsubstituted (C6-C60)aryl group, a substituted or unsubstituted 3- to 30-membered heteroaryl group, wherein the 3- to 30- membered heteroaryl is selected from the group consisting of dibenzofuranyl and dibenzothiophenyl, or a substituted or unsubstituted mono- or di-(C6-C30)arylamino group; or are linked between adjacent substituents to form a substituted or unsubstituted mono- or polycyclic, (C3-C30) alicyclic or aromatic ring whose carbon atom(s) ring may be replaced with at least one hetero atom selected from nitrogen, oxygen, and sulfur;
Ar₂ represents a substituted or unsubstituted nitrogen-containing 5- to 30-membered heteroaryl group;
m represents 1; and
the heteroaryl group of Ar₂ is selected from the group consisting of triazinyl, pyrimidinyl, pyridazinyl, benzoimidazolyl, quinolyl, isoquinolyl, quinazolinyl, quinoxalinyl, naphthyridinyl and phenanthridinyl, which may be substituted with a (C6-C20)aryl group, a tri(C6-C12)arylsilyl group, a S- or O-containing 5- to 15-membered heteroaryl group, a (C6-C15)aryl group substituted with a (C1-C6)alkyl group, or a (C6-C15)aryl group substituted with a cyano group.

### Effects of the Invention

According to the present invention, an organic EL device having high efficiency and long lifespan is provided and the production of a display device or a lighting device is possible by using the organic EL device.

### Embodiments of the Invention

Hereinafter, the present invention will be described in detail. However, the following description is intended to explain the invention, and is not meant in any way to restrict the scope of the invention.

The compound of formula 1 may be represented by the following formula 3, 4, 5, or 6:

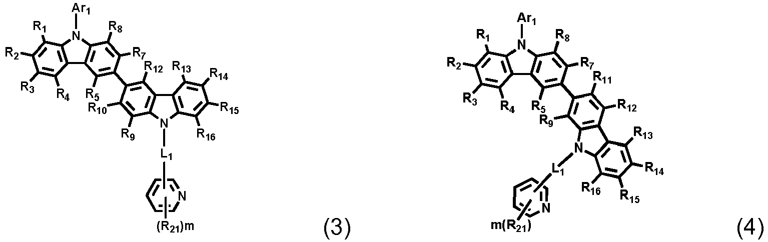

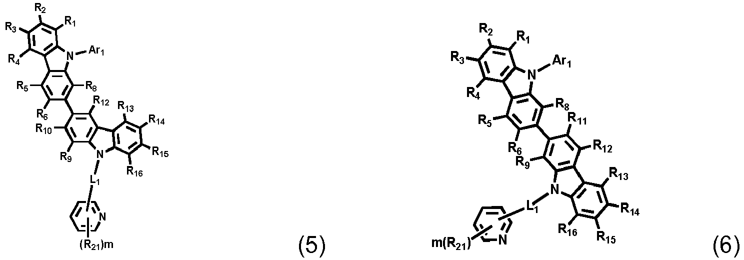

Wherein
Ar₁, L₁, R₁ to R₁₆, R₂₁, and m are as defined in claim 1.

In formula 1, Ar₁ may represent a substituted or unsubstituted (C6-C30)aryl group; preferably, a substituted or unsubstituted (C6-C18)aryl group.

In formulae 1 and 2, L₁ and L₂ each independently may represent a single bond, or a substituted or unsubstituted (C6-C30)arylene group; and preferably, a single bond, or a substituted or unsubstituted (C6-C18)arylene group.

In formula 2, Ar₂ may represent a substituted or unsubstituted nitrogen-containing 5-to 30-membered heteroaryl group; preferably, a monocyclic-based heteroaryl group, such as pyrrolyl, imidazolyl, pyrazolyl, triazinyl, tetrazinyl, triazolyl, tetrazolyl, pyridyl, pyrazinyl, pyrimidinyl, pyridazinyl, etc., or a fused ring-based heteroaryl group, such as benzoimidazolyl, isoindolyl, indolyl, indazolyl, benzothiadiazolyl, quinolyl, isoquinolyl, cinnolinyl, quinazolinyl, quinoxalinyl, carbazolyl, naphthyridinyl, phenanthridinyl, etc.; and more preferably, triazinyl, pyrimidinyl, quinolyl, quinazolinyl, quinoxalinyl, or naphthyridinyl.

In formula 2, R₂₅ to R₃₂ each independently may represent hydrogen, deuterium, a halogen, a cyano group, a substituted or unsubstituted (C1-C30)alkyl group, a substituted or unsubstituted (C2-C30)alkenyl group, a substituted or unsubstituted (C2-C30)alkynyl group, a substituted or unsubstituted (C3-C30)cycloalkyl group, a substituted or unsubstituted (C6-C60)aryl group, a substituted or unsubstituted 3- to 30-membered heteroaryl group, a substituted or unsubstituted tri(C1-C30)alkylsilyl group, a substituted or unsubstituted tri(C6-C30)arylsilyl group, a substituted or unsubstituted di(C1-C30)alkyl(C6-C30)arylsilyl group, or a substituted or unsubstituted mono- or di-(C6-C30)arylamino group; or may be linked between adjacent substituents to form a substituted or unsubstituted mono- or polycyclic, (C3-C30) alicyclic or aromatic ring whose carbon atom(s) ring may be replaced with at least one hetero atom selected from nitrogen, oxygen and sulfur; and preferably, hydrogen, a cyano group, a substituted or unsubstituted tri(C6-C10)arylsilyl group, a (C6-C15)aryl group which is unsubstituted or substituted with a tri(C6-C10)arylsilyl group, or a 10- to 20-membered heteroaryl group which is unsubstituted or substituted with a (C6-C15)aryl group.

Herein, "(C1-C30)alkyl(ene)" is meant to be a linear or branched alkyl(ene) having 1 to 30 carbon atoms, in which the number of carbon atoms is preferably 1 to 20, more preferably 1 to 10, and includes methyl, ethyl, n-propyl, isopropyl, n-butyl, isobutyl, tert-butyl, etc. "(C2-C30)alkenyl" is meant to be a linear or branched alkenyl having 2 to 30 carbon atoms, in which the number of carbon atoms is preferably 2 to 20, more preferably 2 to 10, and includes vinyl, 1-propenyl, 2-propenyl, 1-butenyl, 2-butenyl, 3-butenyl, 2-methylbut-2-enyl, etc. "(C2-C30)alkynyl" is a linear or branched alkynyl having 2 to 30 carbon atoms, in which the number of carbon atoms is preferably 2 to 20, more preferably 2 to 10, and includes ethynyl, 1-propynyl, 2-propynyl, 1-butynyl, 2-butynyl, 3-butynyl, 1-methylpent-2-ynyl, etc. "(C3-C30)cycloalkyl" is a mono- or polycyclic hydrocarbon having 3 to 30 carbon atoms, in which the number of carbon atoms is preferably 3 to 20, more preferably 3 to 7, and includes cyclopropyl, cyclobutyl, cyclopentyl, cyclohexyl, etc. "3- to 7-membered heterocycloalkyl" is a cycloalkyl having at least one heteroatom selected from the group consisting of B, N, O, S, Si, and P, preferably O, S, and N, and 3 to 7, preferably 5 to 7 ring backbone atoms, and includes tetrahydrofuran, pyrrolidine, thiolan, tetrahydropyran, etc. "(C6-C30)aryl(ene)" is a monocyclic or fused ring derived from an aromatic hydrocarbon having 6 to 30 carbon atoms, in which the number of carbon atoms is preferably 6 to 20, more preferably 6 to 15, and includes phenyl, biphenyl, terphenyl, naphthyl, fluorenyl, phenanthrenyl, anthracenyl, indenyl, triphenylenyl, pyrenyl, tetracenyl, perylenyl, chrysenyl, naphthacenyl, fluoranthenyl, etc. "3- to 30-membered heteroaryl(ene)" is an aryl group having at least one, preferably 1 to 4 heteroatom selected from the group consisting of B, N, O, S, Si, and P, and 3 to 30 ring backbone atoms; is a monocyclic ring, or a fused ring condensed with at least one benzene ring; has preferably 3 to 20, more preferably 3 to 15 ring backbone atoms; may be partially saturated; may be one formed by linking at least one heteroaryl or aryl group to a heteroaryl group via a single bond(s); and includes a monocyclic ring-type heteroaryl, such as furyl, thiophenyl, pyrrolyl, imidazolyl, pyrazolyl, thiazolyl, thiadiazolyl, isothiazolyl, isoxazolyl, oxazolyl, oxadiazolyl, triazinyl, tetrazinyl, triazolyl, tetrazolyl, furazanyl, pyridyl, pyrazinyl, pyrimidinyl, pyridazinyl, etc., and a fused ring-type heteroaryl, such as benzofuranyl, benzothiophenyl, isobenzofuranyl, dibenzofuranyl, dibenzothiophenyl, benzoimidazolyl, benzothiazolyl, benzoisothiazolyl, benzoisoxazolyl, benzoxazolyl, isoindolyl, indolyl, indazolyl, benzothiadiazolyl, quinolyl, isoquinolyl, cinnolinyl, quinazolinyl, quinoxalinyl, carbazolyl, phenoxazinyl, phenanthridinyl, benzodioxolyl, etc. "Nitrogen-containing 5- to 30-membered heteroaryl(ene) group" is an aryl group having at least one heteroatom N and 5 to 30 ring backbone atoms. 5 to 20 ring backbone atoms and 1 to 4 heteroatom are preferable, and 5 to 15 ring backbone atoms are more preferable. It is a monocyclic ring, or a fused ring condensed with at least one benzene ring; may be partially saturated; may be one formed by linking at least one heteroaryl or aryl group to a heteroaryl group via a single bond(s); and includes a monocyclic ring-type heteroaryl, such as pyrrolyl, imidazolyl, pyrazolyl, triazinyl, tetrazinyl, triazolyl, tetrazolyl, pyridyl, pyrazinyl, pyrimidinyl, pyridazinyl, etc., and a fused ring-type heteroaryl, such as benzoimidazolyl, isoindolyl, indolyl, indazolyl, benzothiadiazolyl, quinolyl, isoquinolyl, cinnolinyl, quinazolinyl, quinoxalinyl, carbazolyl, phenanthridinyl, etc. "Halogen" includes F, Cl, Br, and I.

Herein, "substituted" in the expression "substituted or unsubstituted" means that a hydrogen atom in a certain functional group is replaced with another atom or group, i.e., a substituent. Substituents of the substituted alkyl(ene) group, the substituted alkenyl group, the substituted alkynyl group, the substituted cycloalkyl group, the substituted aryl(ene) group, the substituted heteroaryl(ene) group, the substituted trialkylsilyl group, the substituted triarylsilyl group, the substituted dialkylarylsilyl group, the substituted mono- or di-arylamino group, or the substituted mono- or polycyclic, (C3-C30) alicyclic or aromatic ring in the above formulae are each independently at least one selected from the group consisting of deuterium; a halogen; a cyano group; a carboxyl group; a nitro group; a hydroxyl group; a (C1-C30)alkyl group; a halo(C1-C30)alkyl group; a (C2-C30)alkenyl group; a (C2-C30)alkynyl group; a (C1-C30)alkoxy group; a (C1-C30)alkylthio group; a (C3-C30)cycloalkyl group; a (C3-C30)cycloalkenyl group; a 3- to 7-membered heterocycloalkyl group; a (C6-C30)aryloxy group; a (C6-C30)arylthio group; a 3- to 30-membered heteroaryl group which is unsubstituted or substituted with a (C6-C30)aryl group; a (C6-C30)aryl group which is unsubstituted or substituted with a 3- to 30-membered heteroaryl group; a tri(C1-C30)alkylsilyl group; a tri(C6-C30)arylsilyl group; a di(C1-C30)alkyl(C6-C30)arylsilyl group; a (C1-C30)alkyldi(C6-C30)arylsilyl group; an amino group; a mono- or di(C1-C30)alkylamino group; a mono- or di(C6-C30)arylamino group; a (C1-C30)alkyl(C6-C30)arylamino group; a (C1-C30)alkylcarbonyl group; a (C1-C30)alkoxycarbonyl group; a (C6-C30)arylcarbonyl group; a di(C6-C30)arylboronyl group; a di(C1-C30)alkylboronyl group; a (C1-C30)alkyl(C6-C30)arylboronyl group; a (C6-C30)aryl(C1-C30)alkyl group; and a (C1-C30)alkyl(C6-C30)aryl group.

The compound of formula 1 as a first host compound may be selected from the group consisting of the following compounds, but is not limited thereto. Exceptions to this selection are detailed in the subsequent paragraph.

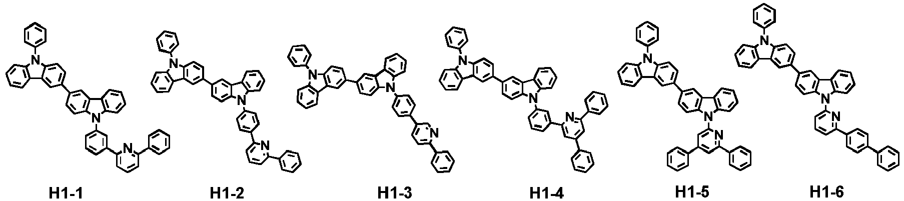

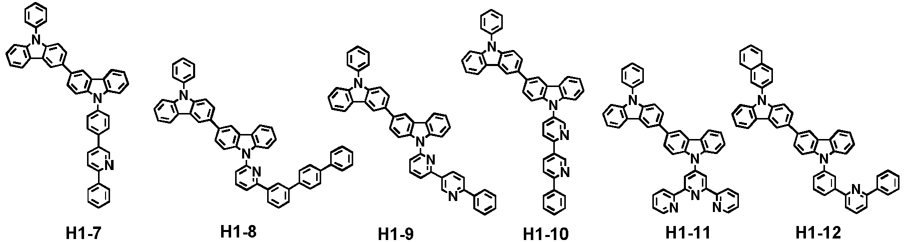

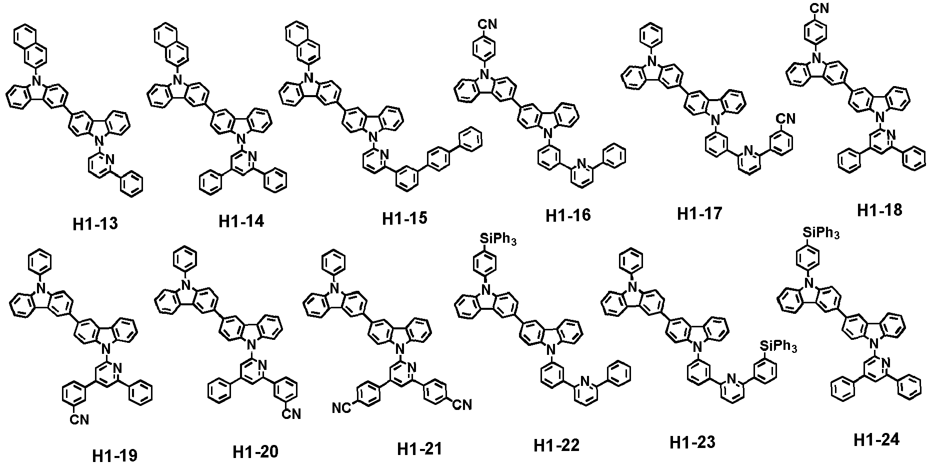

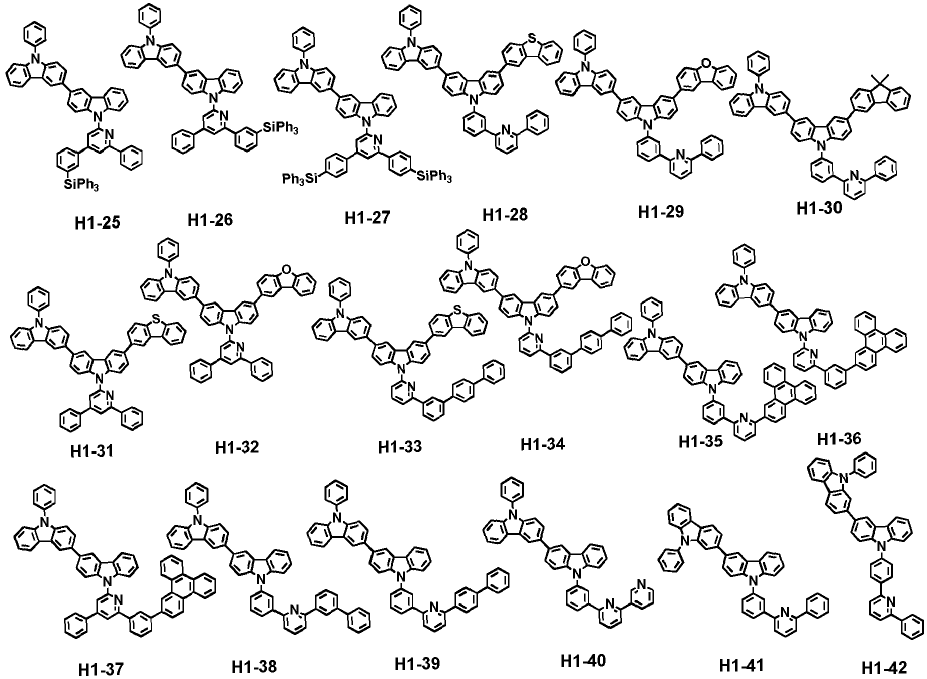

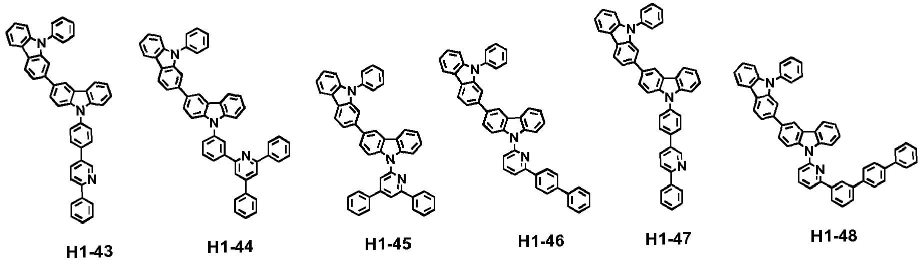

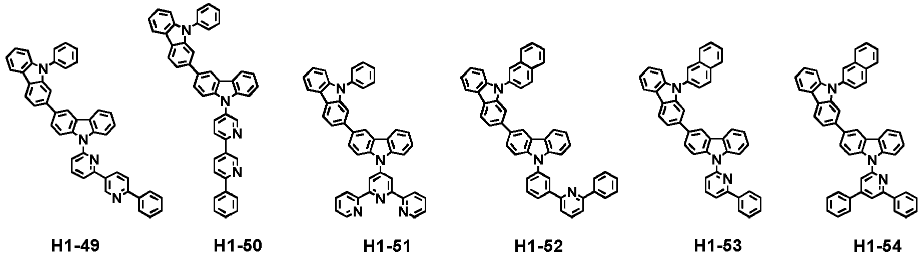

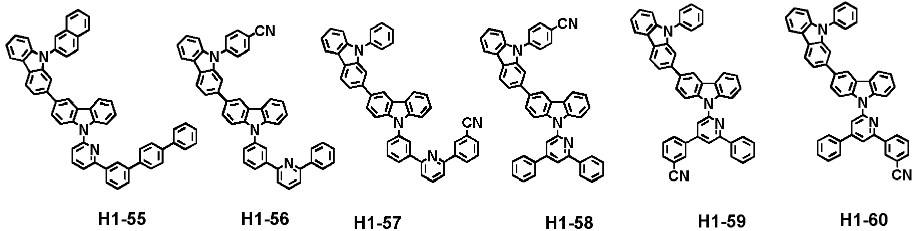

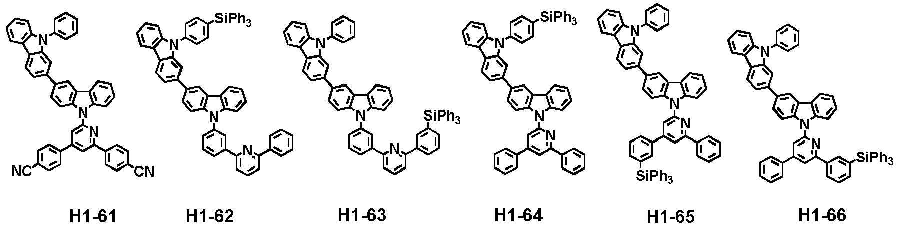

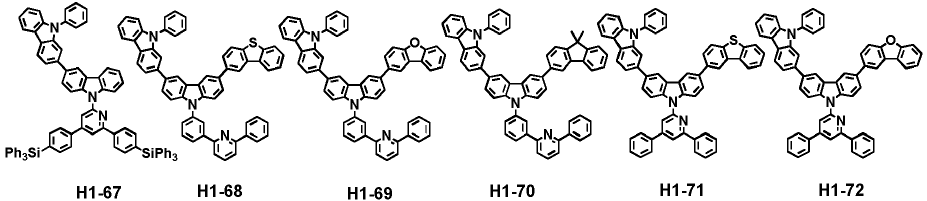

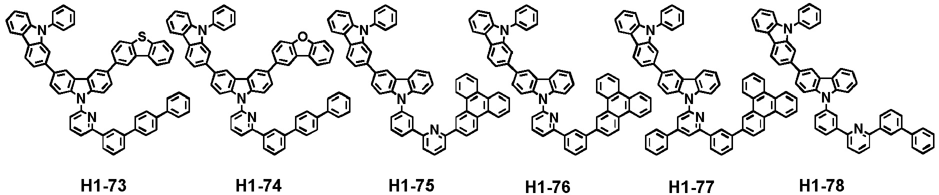

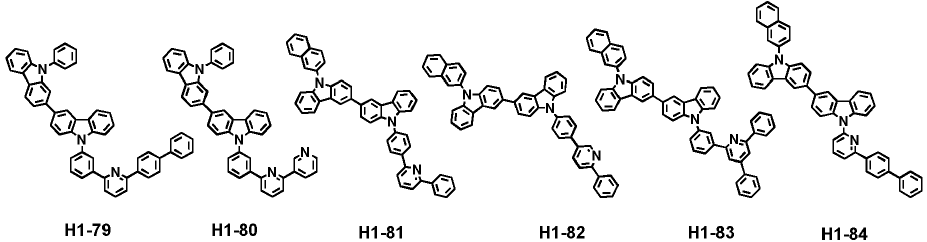

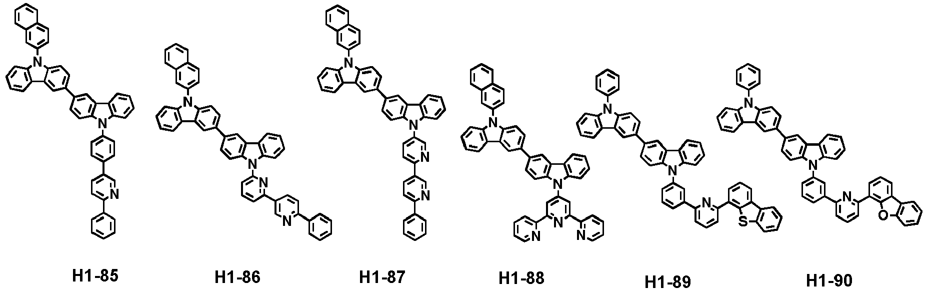

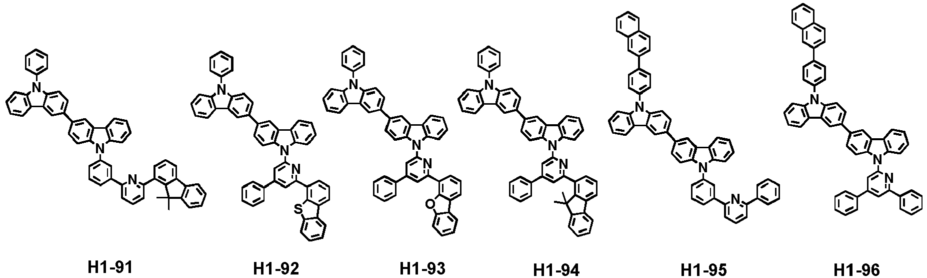

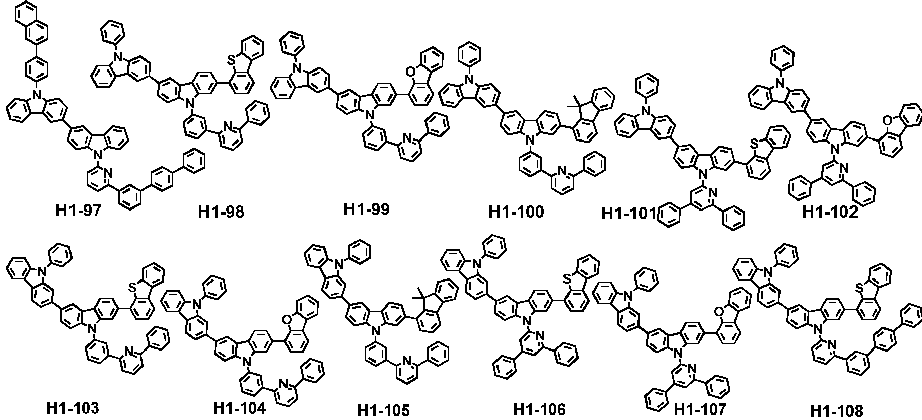

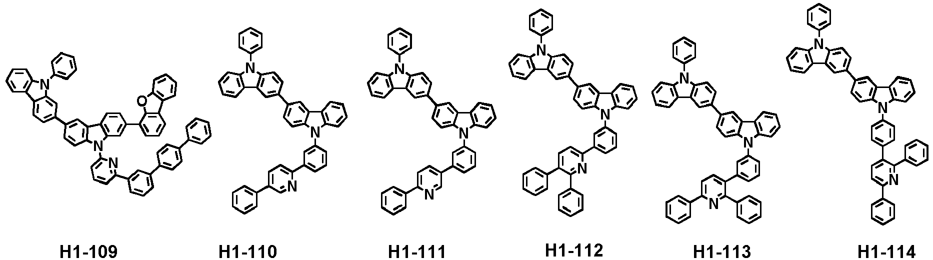

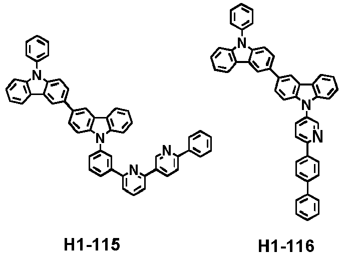

Compounds H1-4 to H1-6, H1-8 to H1-11, H1-13 to H1-15, H1-17 to H1-21, H1-23 to H1-34, H1-36 to H1-37, H1-44 to H1-46, H1-48 to H1-51, H1-53 to H1-69, H1-71 to H1-74, H1-76 to H1-77, H1-80, H1-84, H1-86 to H1-90, H1-92 to H1-94, H1-96 to H1-99, H1-101 to H1-104, H1-106 to H1-109 and H1-112 to H1-116 do not fall within the scope of the invention.

The compound of formula 2 as a second host compound may be selected from the group consisting of the following compounds, but is not limited thereto. Exceptions to this selection are detailed in the subsequent paragraph.

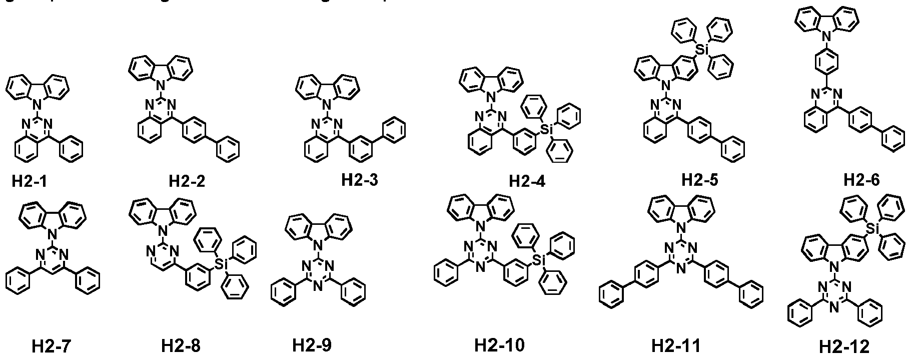

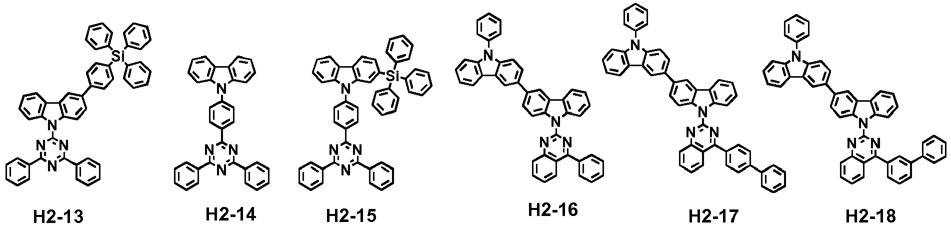

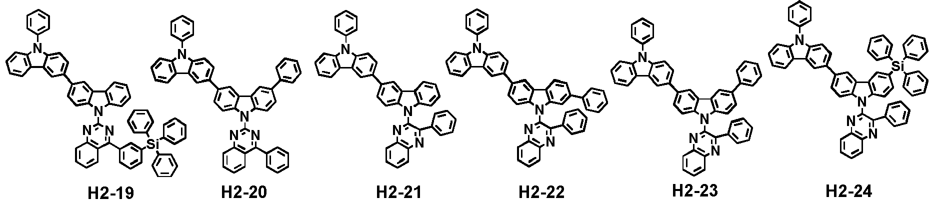

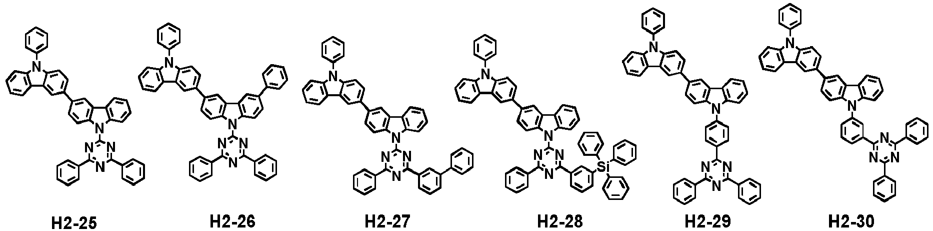

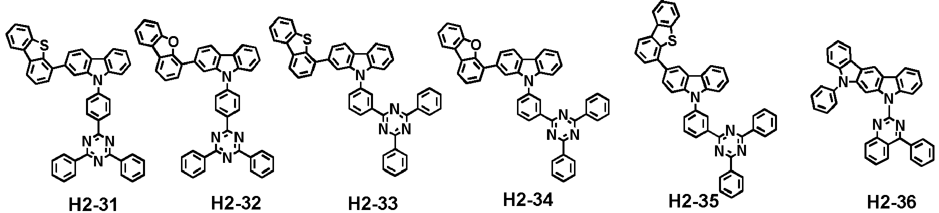

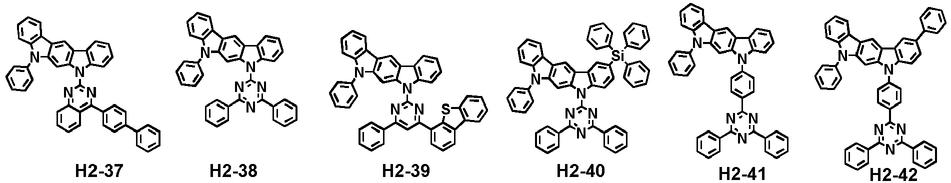

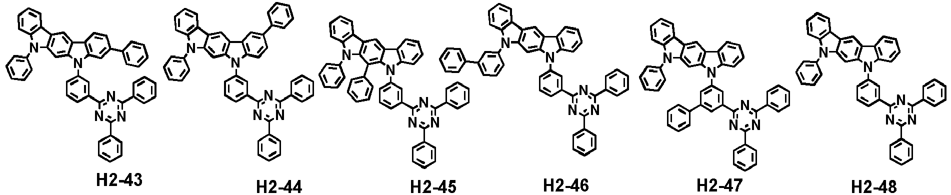

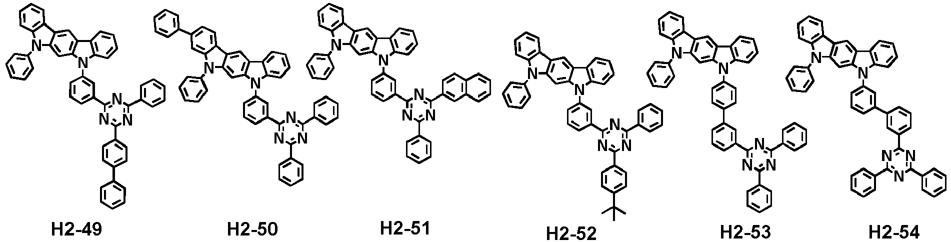

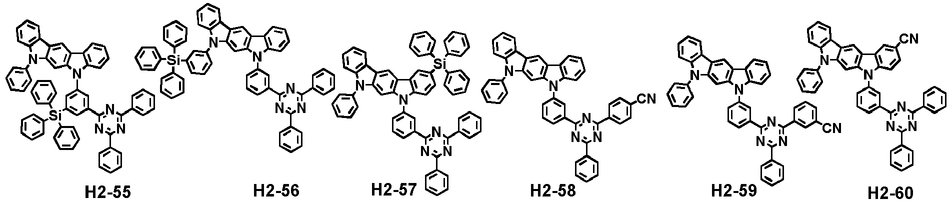

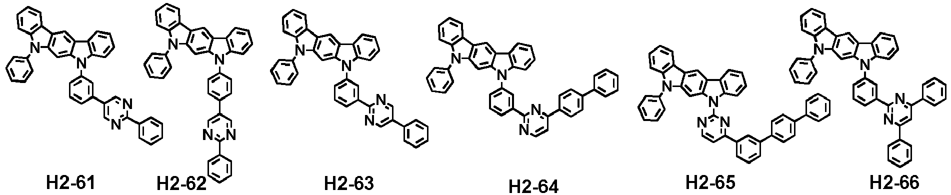

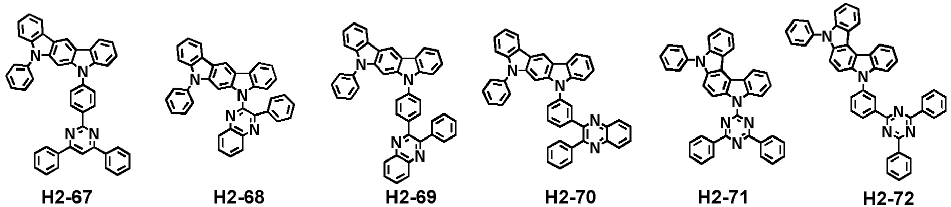

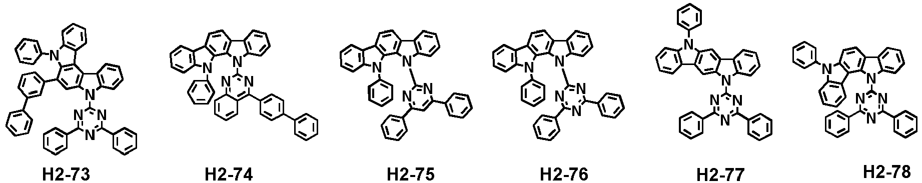

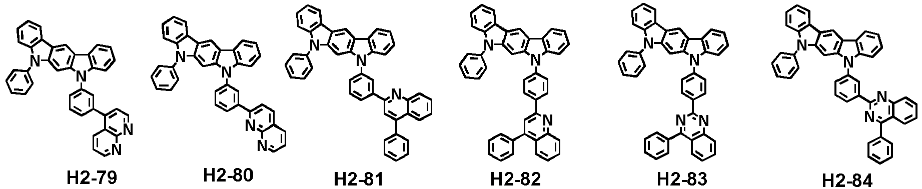

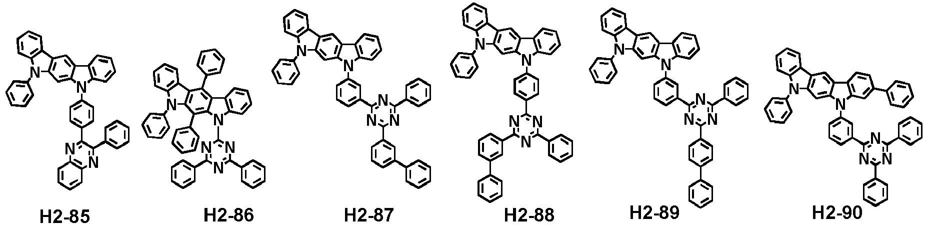

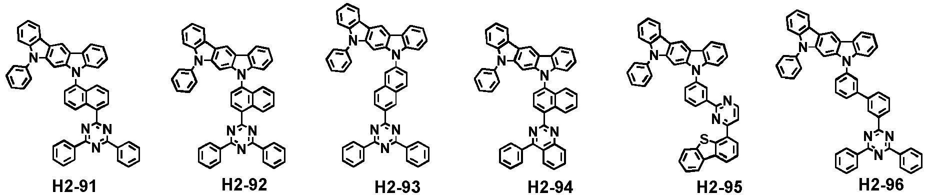

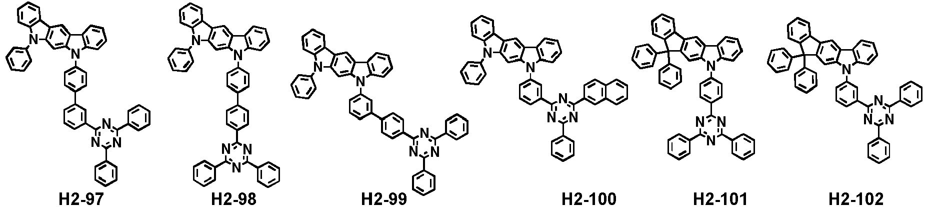

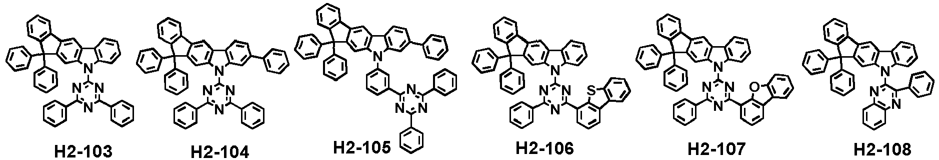

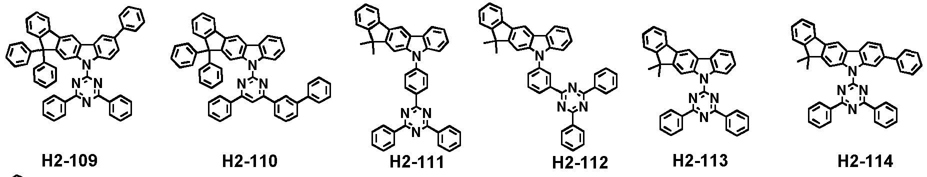

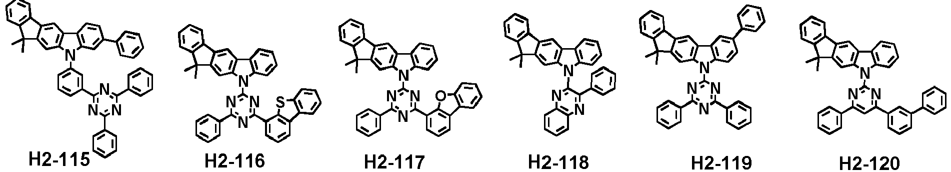

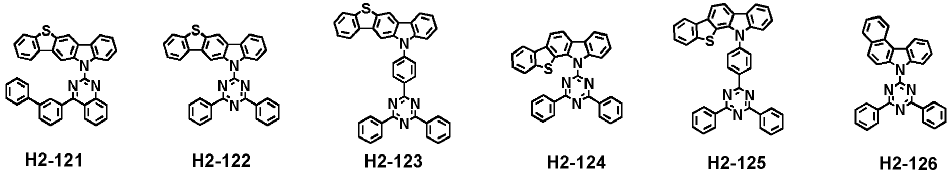

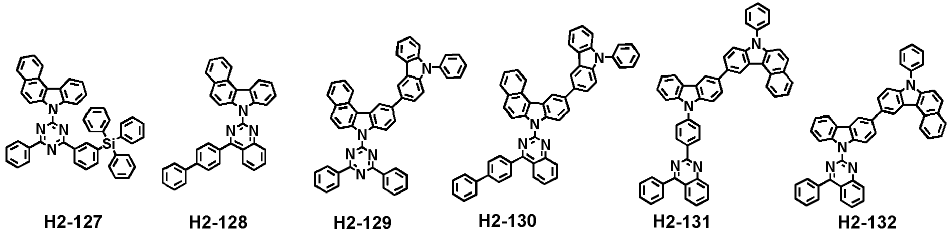

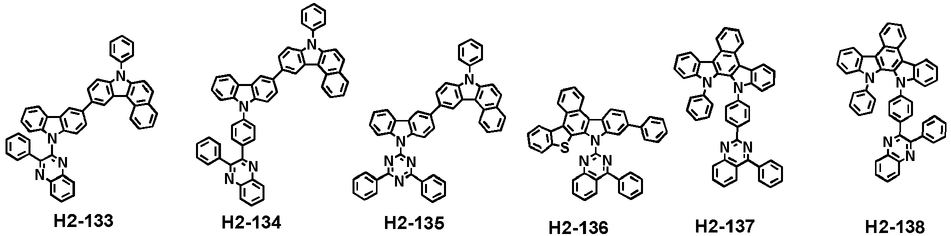

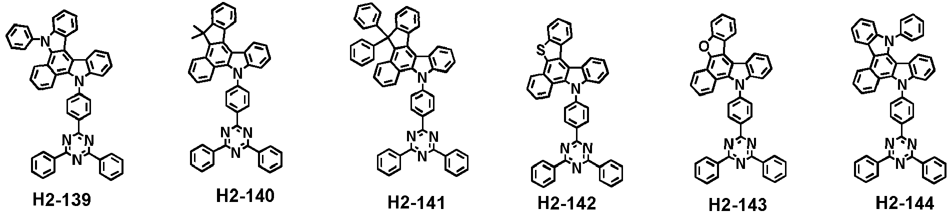

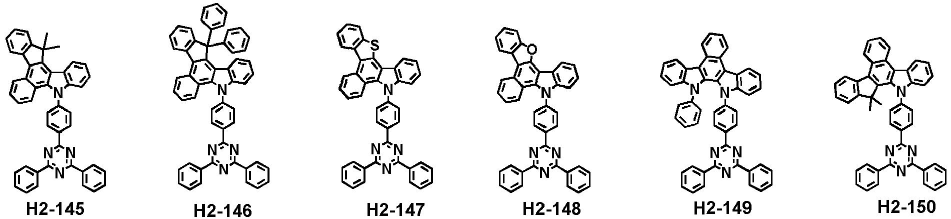

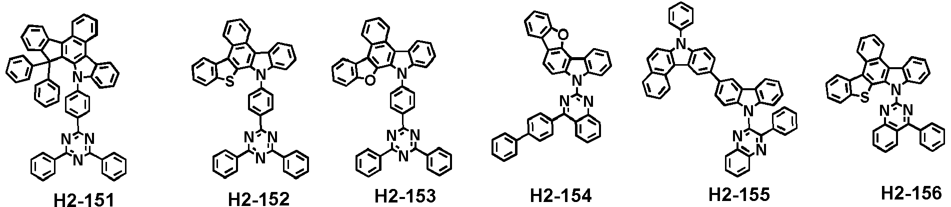

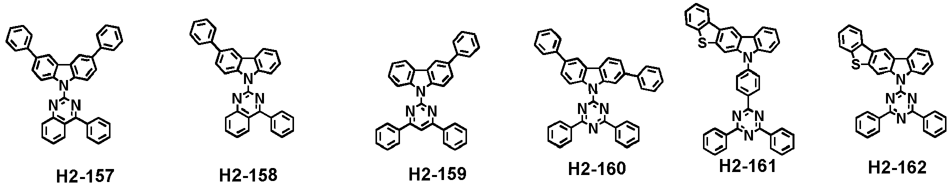

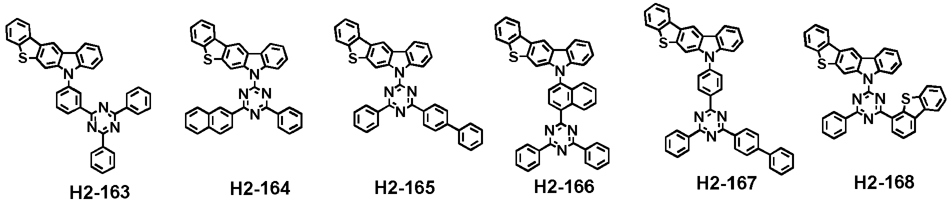

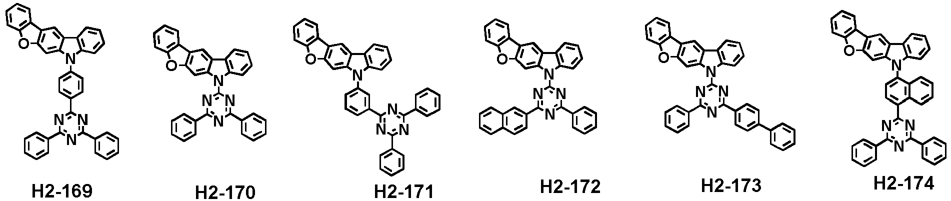

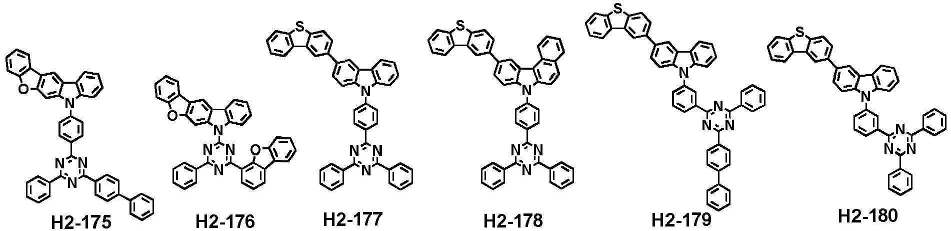

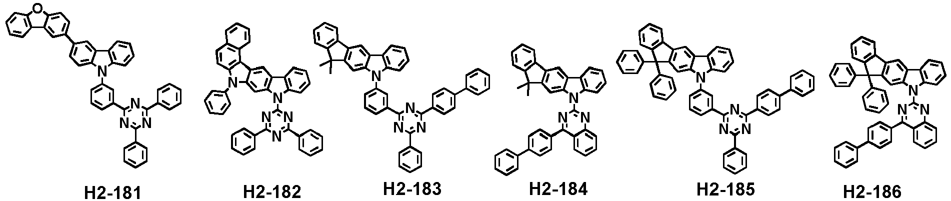

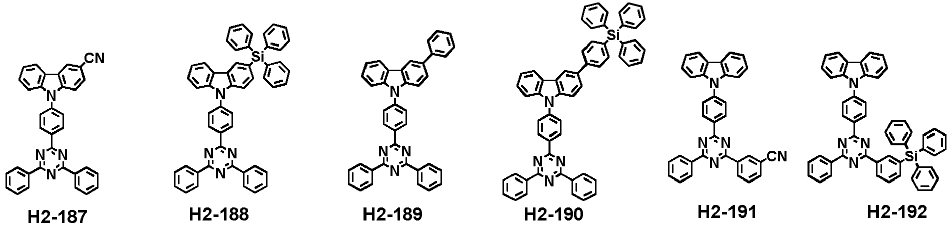

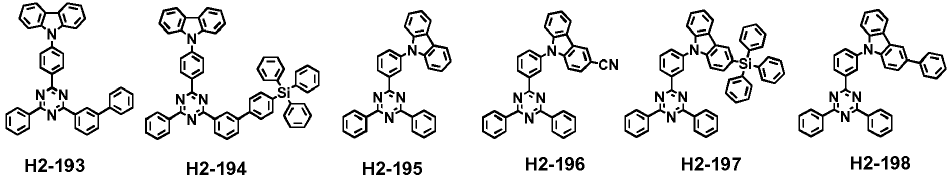

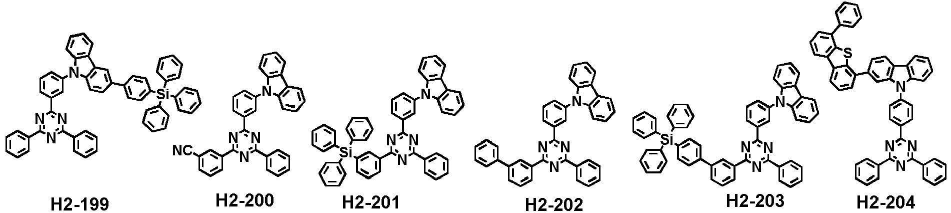

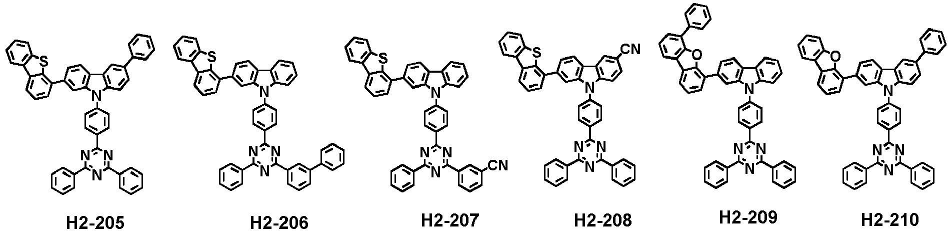

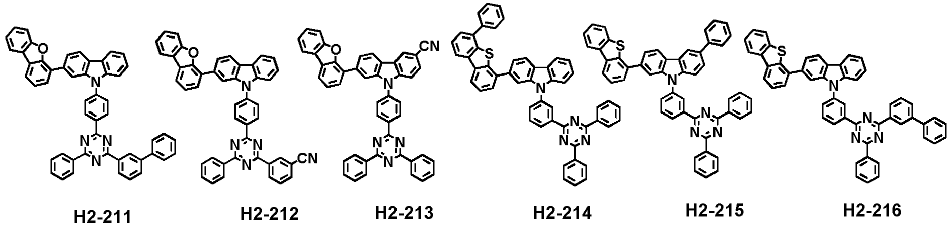

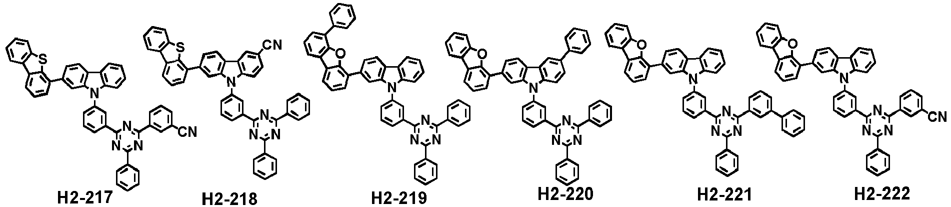

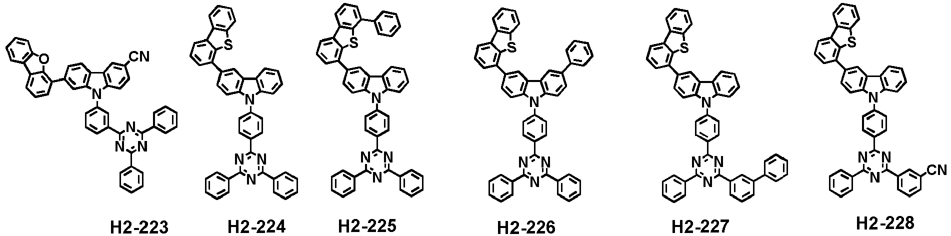

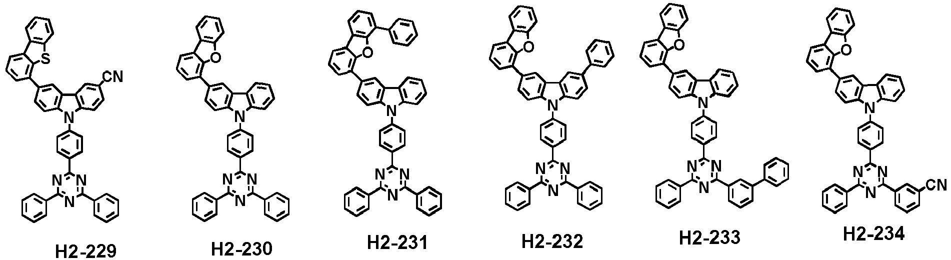

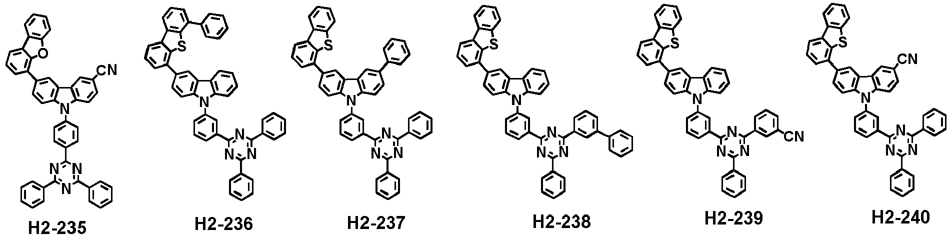

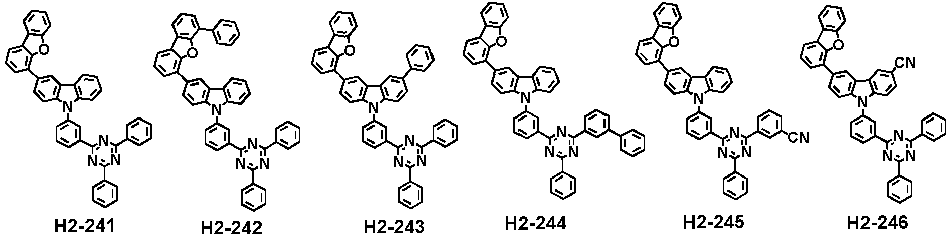

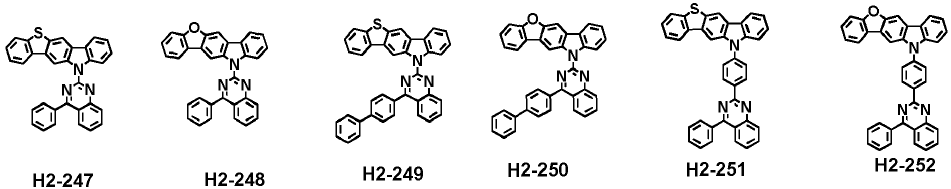

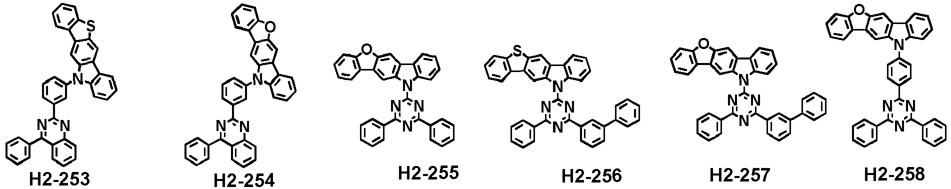

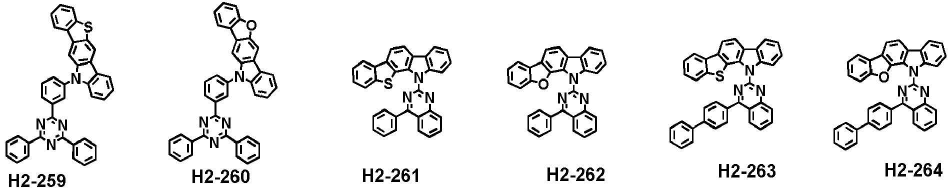

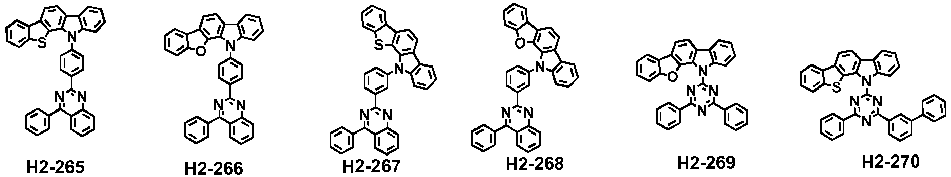

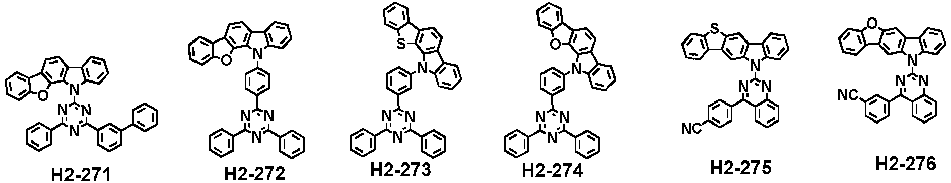

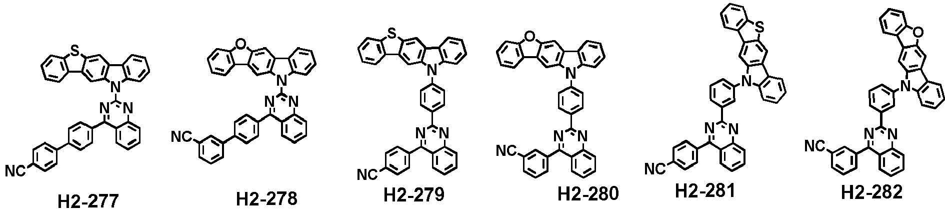

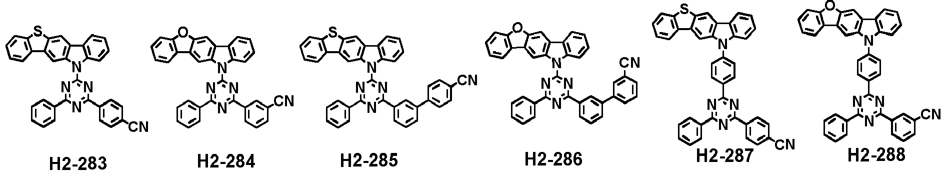

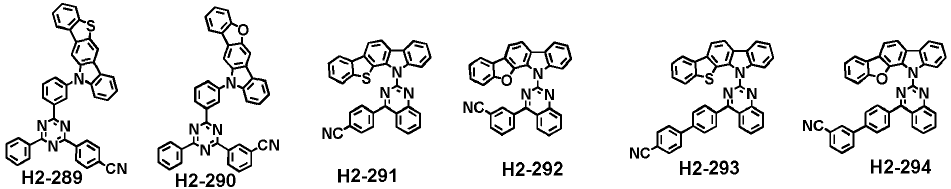

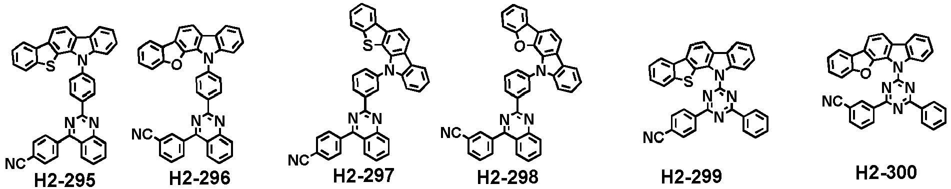

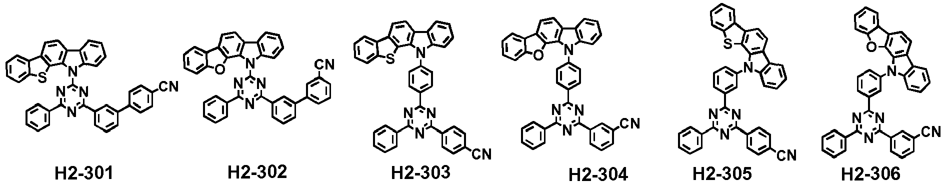

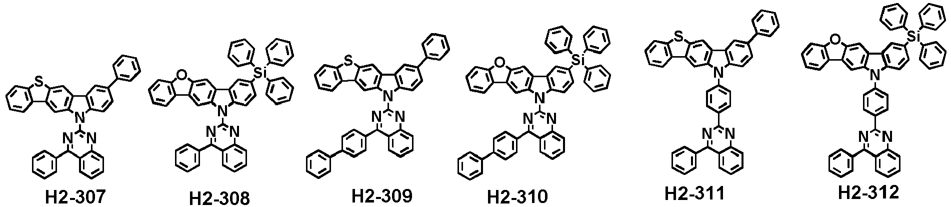

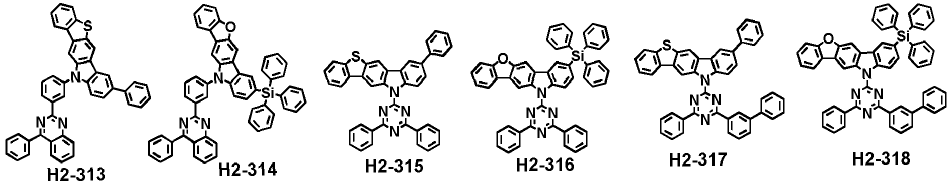

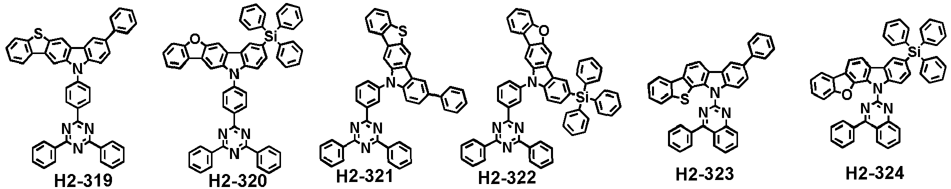

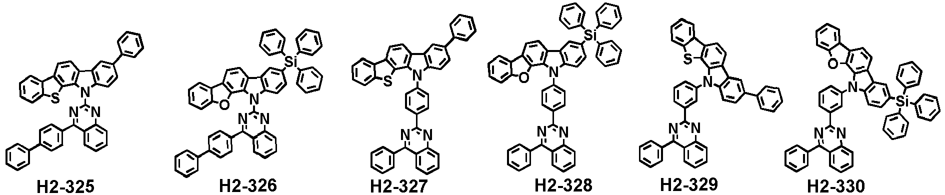

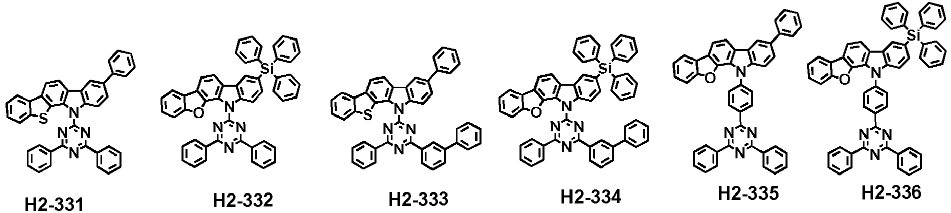

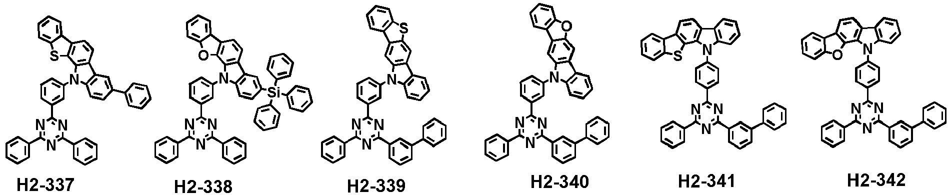

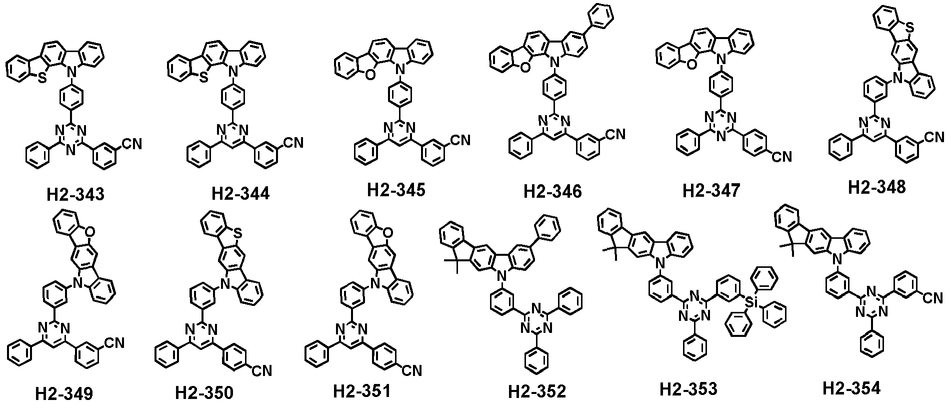

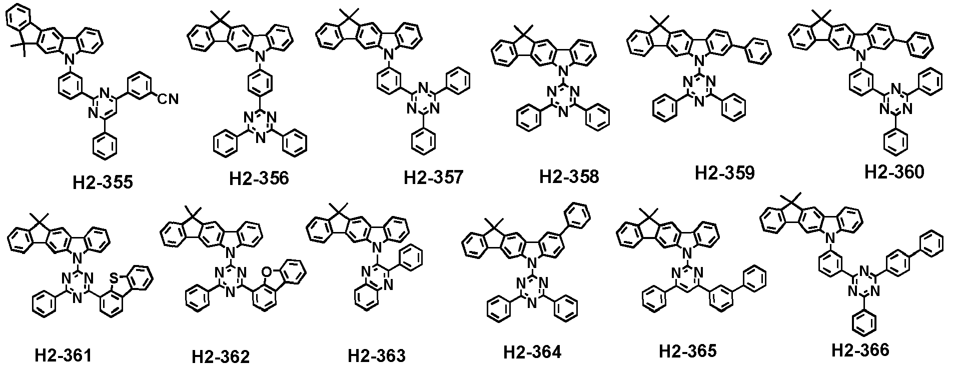

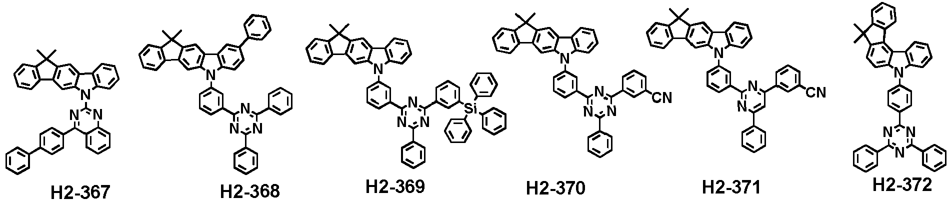

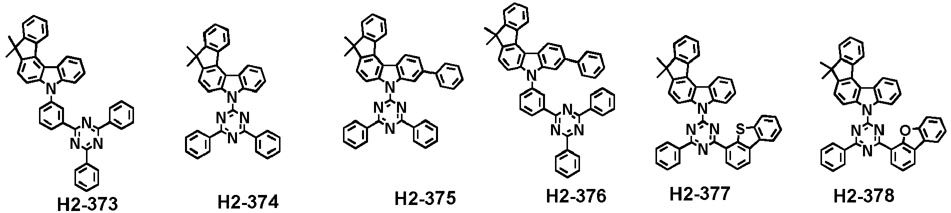

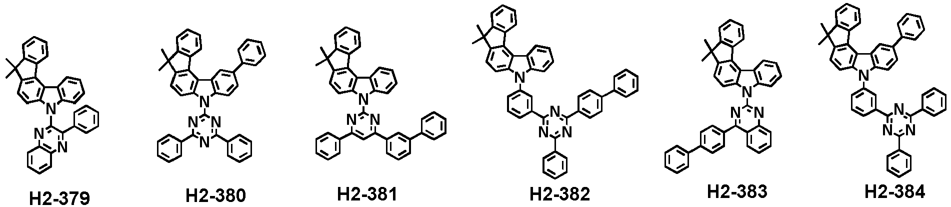

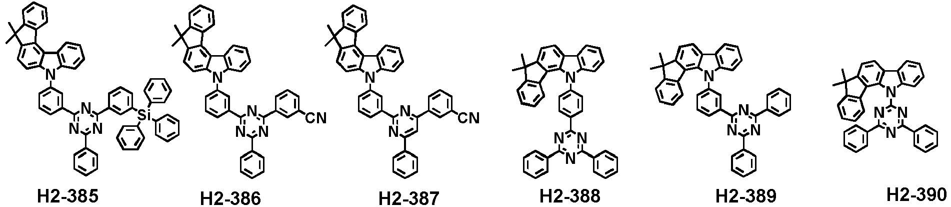

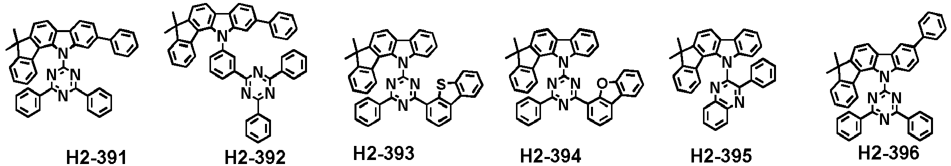

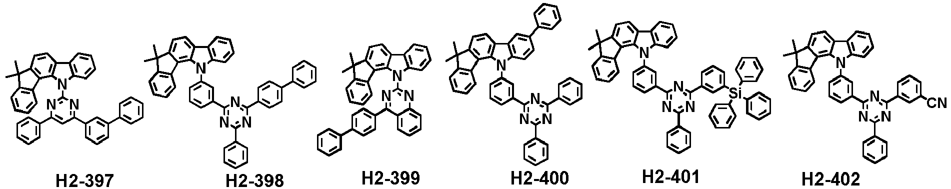

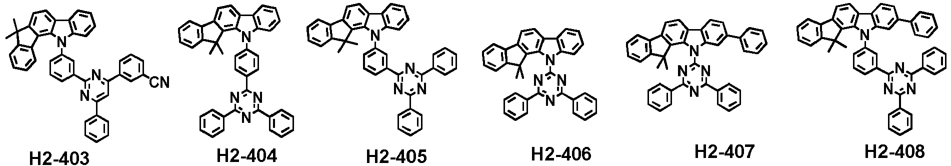

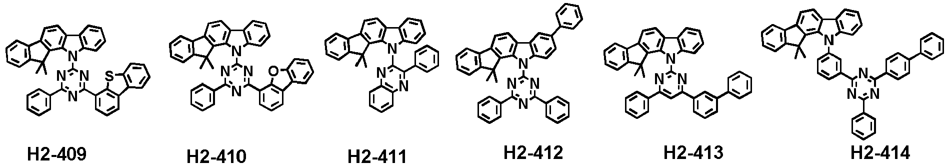

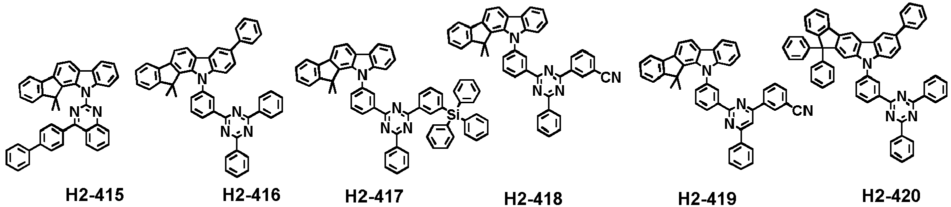

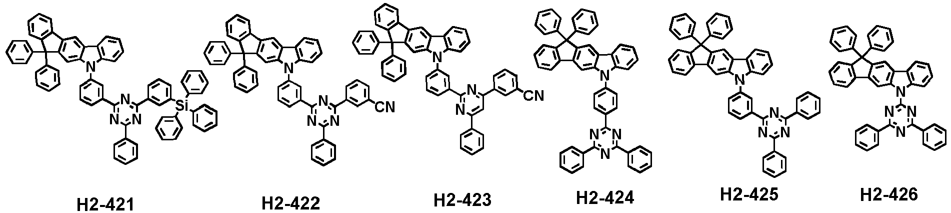

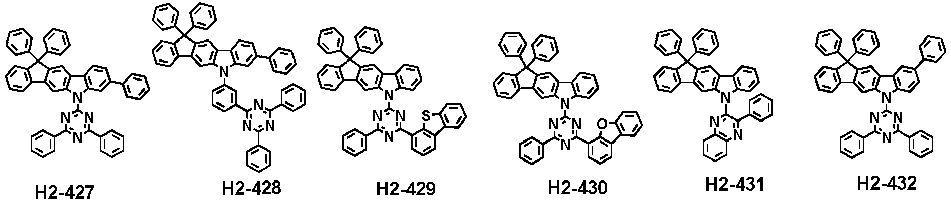

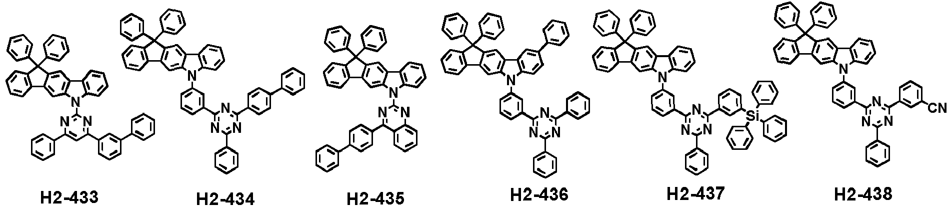

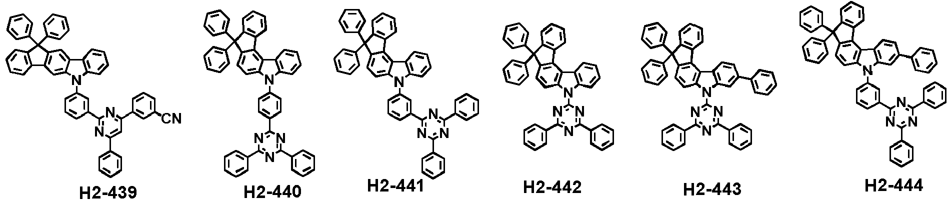

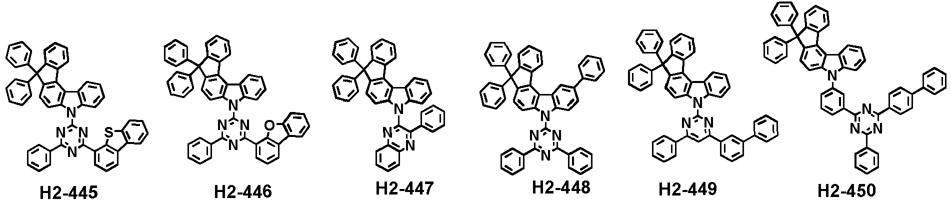

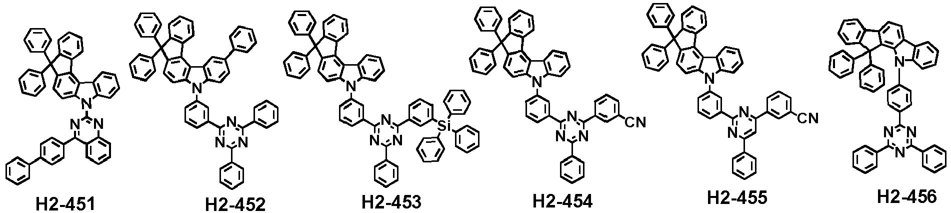

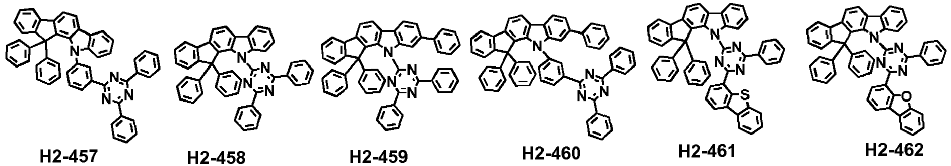

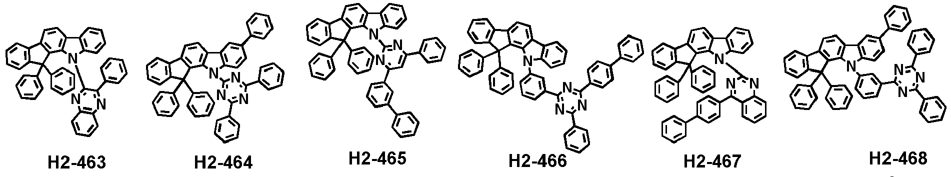

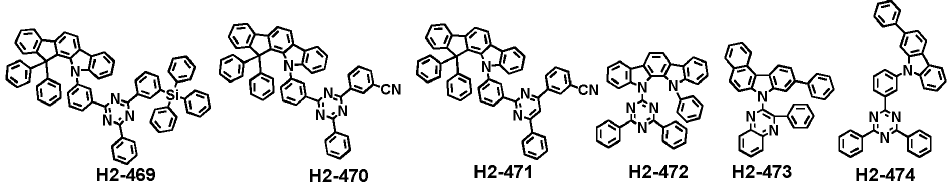

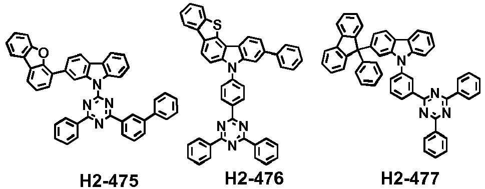

Compounds H2-1 to H2-5, H2-7 to H2-13, H2-15 to H2-30, H2-36 to H2-40, H2-55, H2-57, H2-60, H2-65, H2-68, H2-71, H2-73 to H2-78, H2-86, H2-103 to H2-104, H2-106 to H2-110, H2-113 to H2-114, H2-116 to H2-122, H2-124, H2-126 to H2-136, H2-154 to H2-162, H2-164 to H2-165, H2-168, H2-172 to H2-173, H2-176, H2-182, H2-184, H2-186 to H2-188, H2-196 to H2-197, H2-208, H2-213, H2-218, H2-223, H2-229, H2-235, H2-240, H2-246 to H2-250, H2-255 to H2-257, H2-261 to H2-264, H2-269 to H2-270, H2-275 to H2-278, H2-283 to H2-286, H2-291 to H2-294, H2-299 to H2-302, H2-306 to H2-310, H2-312, H2-314 to H2-318, H2-320, H2-322, H2-324, H2-326, H2-328, H2-330 to H2-334, H2-336, H2-338, H2-358 to H2-359, H2-361 to H2-365, H2-367, H2-374 to H2-375, H2-377 to H2-381, H2-383, H2-390 to H2-391, H2-393 to H2-397, H2-399, H2-406 to H2-407, H2-415, H2-426 to H2-427, H2-429 to H2-433, H2-435, H2-442 to H2-443, H2-445 to H2-459, H2-451, H2-458 to H2-459, H2-461 to H2-465, H2-467, H2-472 to H2-473 and H2-475 do not fall within the scope of the invention.

The organic EL device according to the present invention may comprise an anode, a cathode, and at least one organic layer between the two electrodes, wherein the organic layer comprises a light-emitting layer, the light-emitting layer comprises a host and a phosphorescent dopant; the host consists of multi-component host compounds; at least a first host compound of the multi-component host compounds is represented by formula 1 which is a bicarbazole derivative containing pyridine, and a second host compound is represented by formula 2 which is a carbazole derivative including a nitrogen-containing heteroaryl group.

The light-emitting layer means a layer that light is emitted therefrom and may be a single layer or multi-layers consisting of two or more layers. The doping concentration of dopant compounds to host compounds in the light-emitting layer is preferably less than 20 wt%.

The dopants included in the organic EL device of the present invention are preferably one or more phosphorescent dopants. The phosphorescent dopant material applied to the organic EL device of the present invention is not specifically limited, but preferably may be selected from complex compounds of iridium (Ir), osmium (Os), copper (Cu), and platinum (Pt), more preferably ortho metallated complex compounds of iridium (Ir), osmium (Os), copper (Cu), and platinum (Pt), and even more preferably ortho metallated iridium complex compounds.

The dopants included in the organic EL device of the present invention may be selected from the group consisting of the compounds represented by the following formulae 7 to 9: 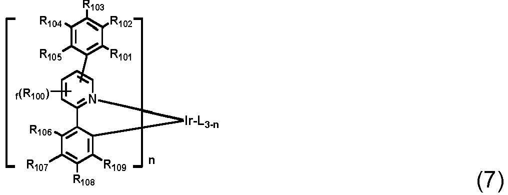 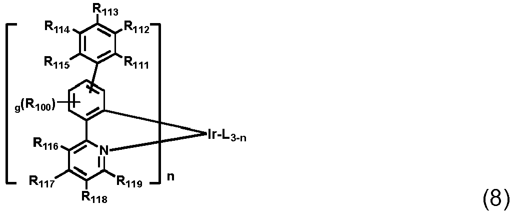 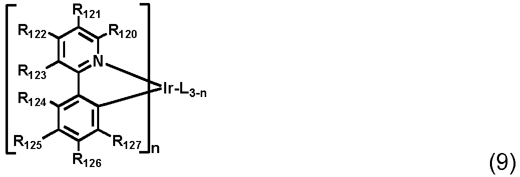 Wherein
L is selected from the following structures: 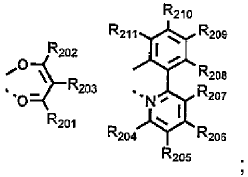
R₁₀₀ represents hydrogen, deuterium, a substituted or unsubstituted (C1-C30)alkyl group, or a substituted or unsubstituted (C3-C30)cycloalkyl group;
R₁₀₁ to R₁₀₉ and R₁₁₁ to R₁₂₃ each independently represent hydrogen, deuterium, a halogen, a (C1-C30)alkyl group unsubstituted or substituted with a halogen(s), a substituted or unsubstituted (C3-C30)cycloalkyl group, a cyano group, a substituted or unsubstituted (C1-C30)alkoxy group, or a substituted or unsubstituted (C6-C30)aryl group; R₁₂₀ to R₁₂₃ may be linked to an adjacent substituent(s) to form a substituted or unsubstituted fused ring, for example, quinoline;
R₁₂₄ to R₁₂₇ each independently represent hydrogen, deuterium, a halogen, a substituted or unsubstituted (C1-C30)alkyl group, or a substituted or unsubstituted (C6-C30)aryl group; when R₁₂₄ to R₁₂₇ are aryl groups, they may be linked to an adjacent substituent(s) to form a substituted or unsubstituted mono- or polycyclic, (C3-C30) alicyclic, aromatic, or a heteroaromatic ring, for example, fluorene, dibenzothiophene, or dibenzofuran;
R₂₀₁ to R₂₁₁ each independently represent hydrogen, deuterium, a halogen, a (C1-C30)alkyl group unsubstituted or substituted with a halogen(s), a substituted or unsubstituted (C3-C30)cycloalkyl group, or a substituted or unsubstituted (C6-C30)aryl group; R₂₀₈ to R₂₁₁ may be linked to an adjacent substituent(s) to form a substituted or unsubstituted mono- or polycyclic, (C3-C30) alicyclic, aromatic, or a heteroaromatic ring, for example, fluorene, dibenzothiophene, or dibenzofuran;
f and g each independently represent an integer of 1 to 3; where f or g is an integer of 2 or more, each of R₁₀₀ may be the same or different; and
n represents an integer of 1 to 3.

The dopant material includes the following:

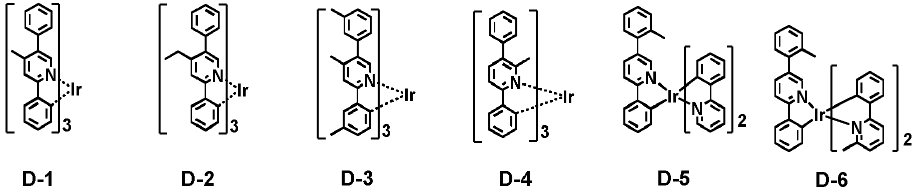

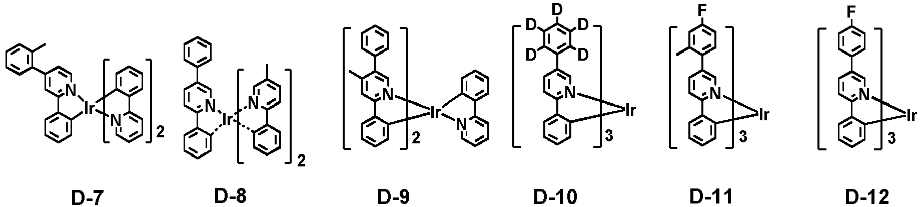

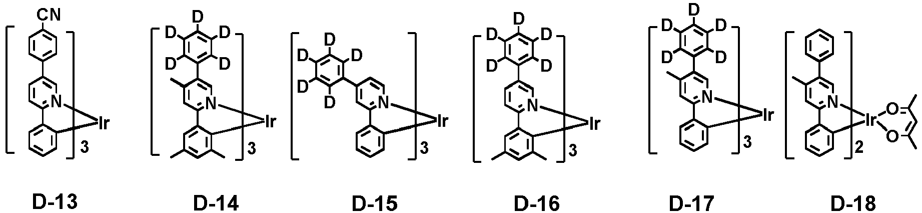

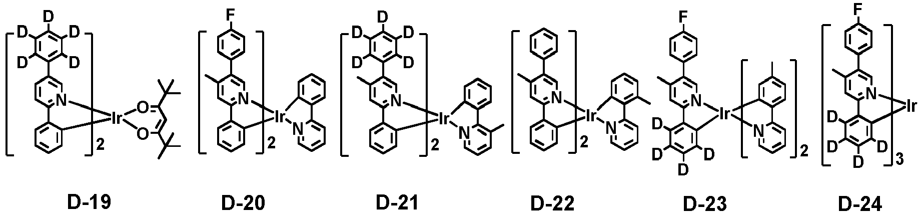

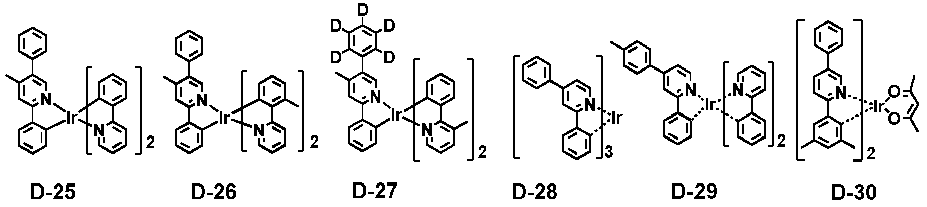

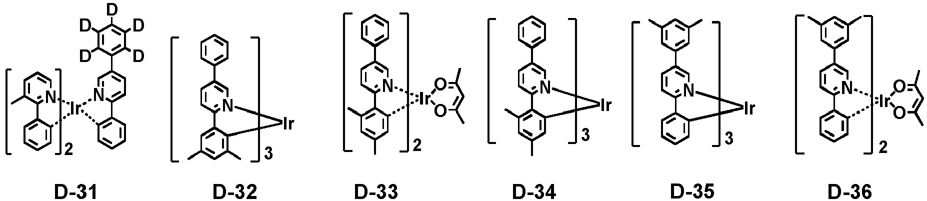

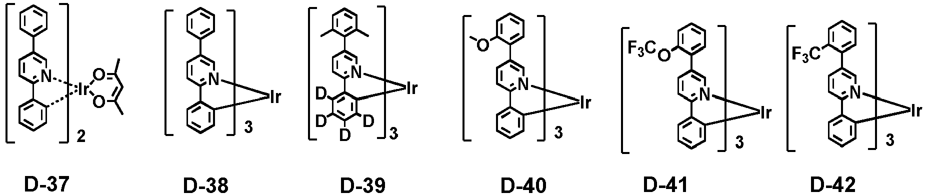

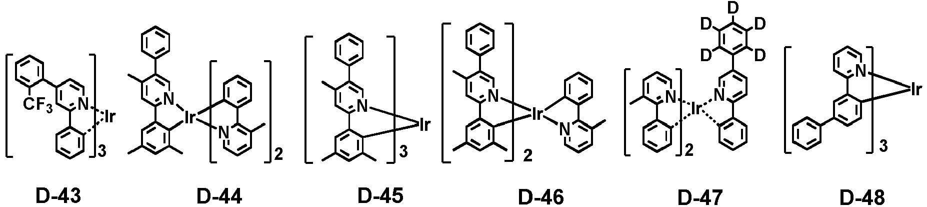

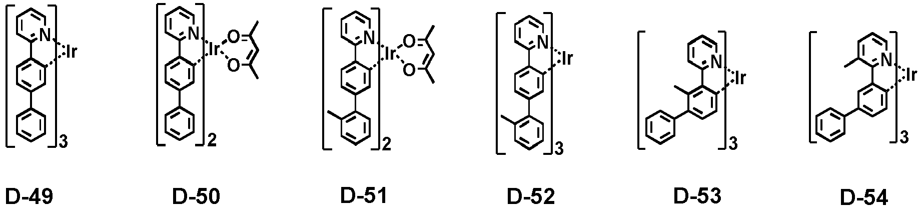

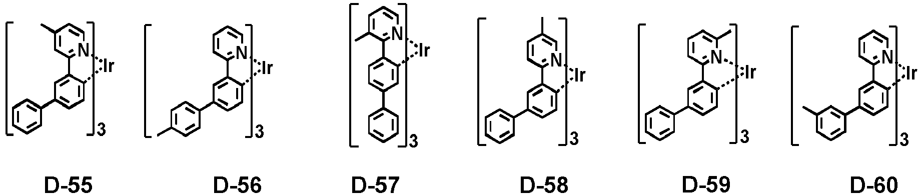

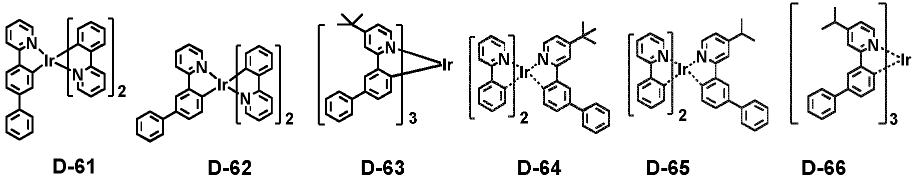

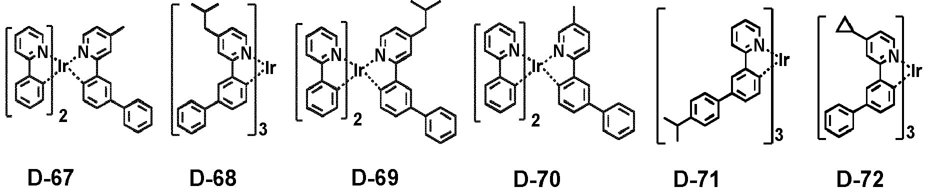

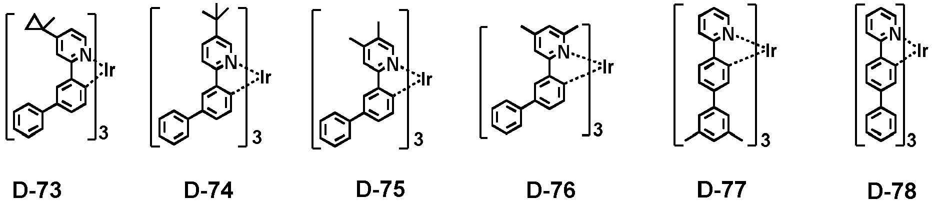

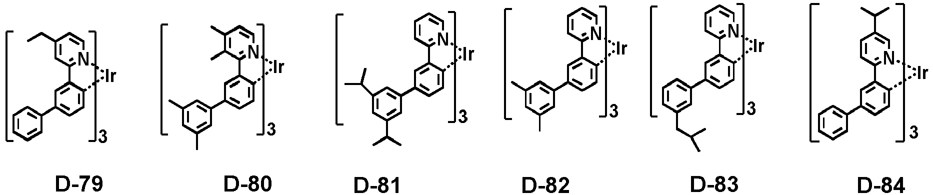

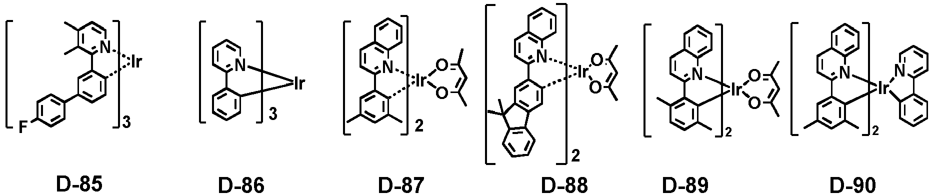

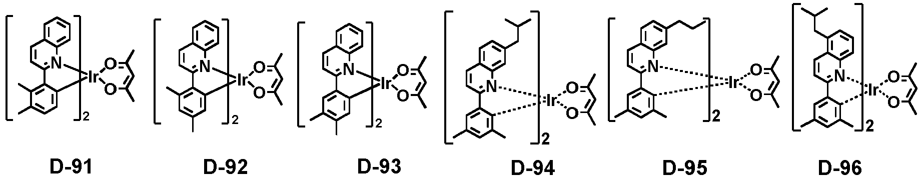

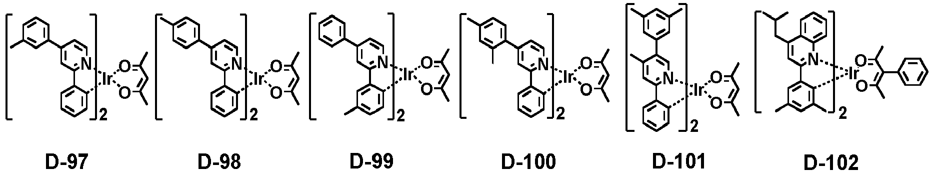

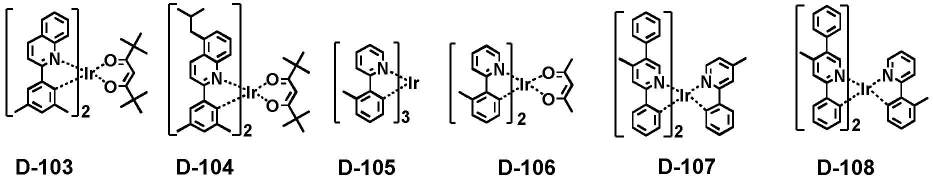

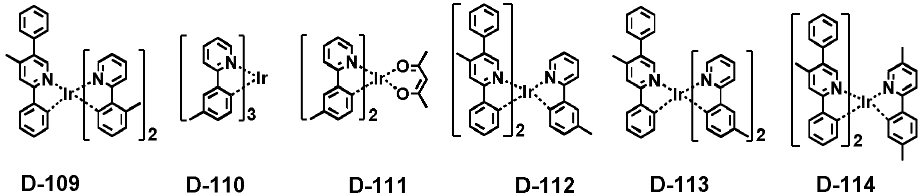

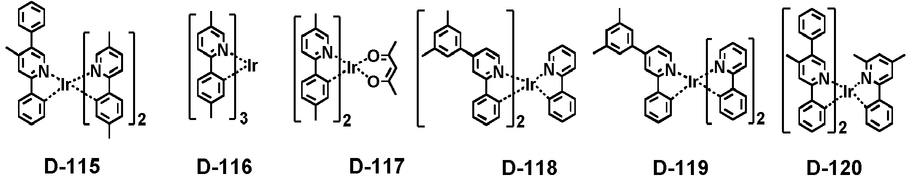

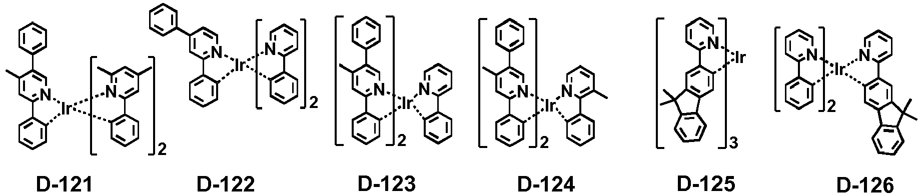

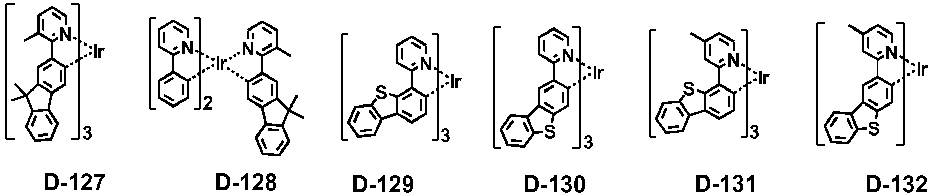

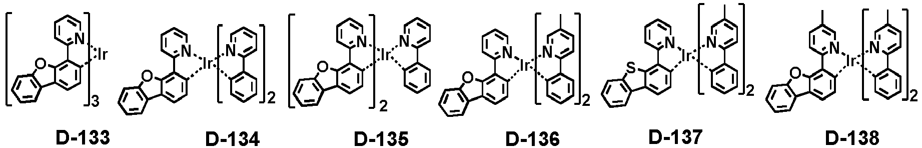

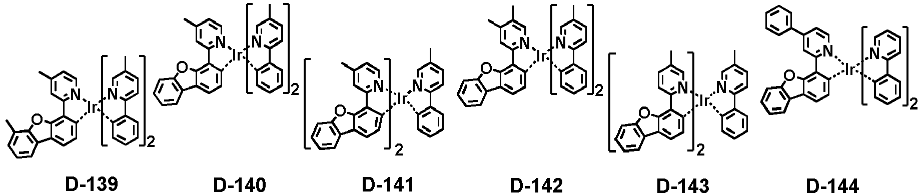

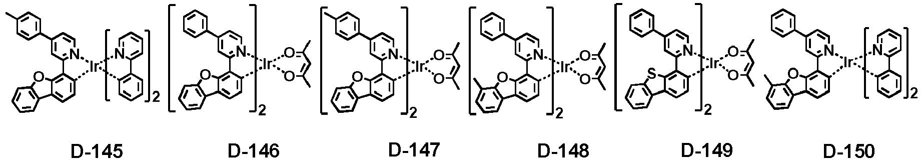

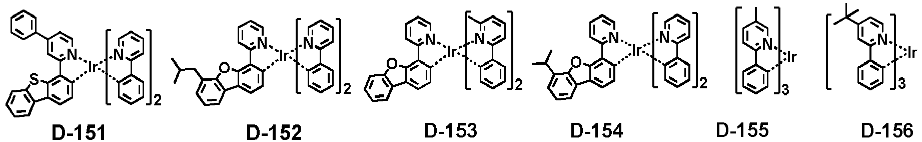

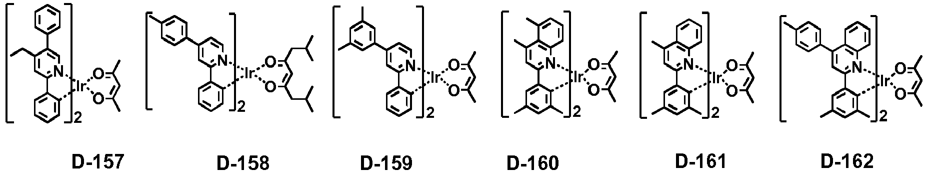

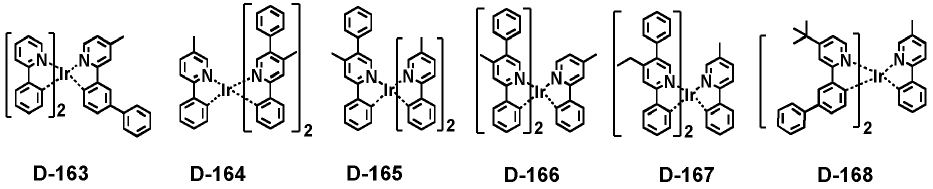

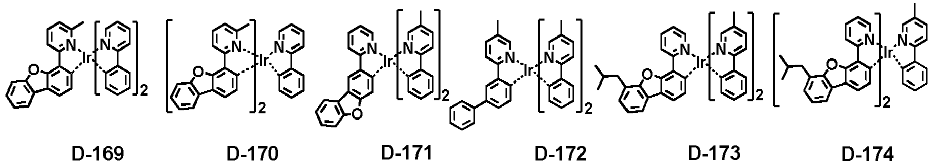

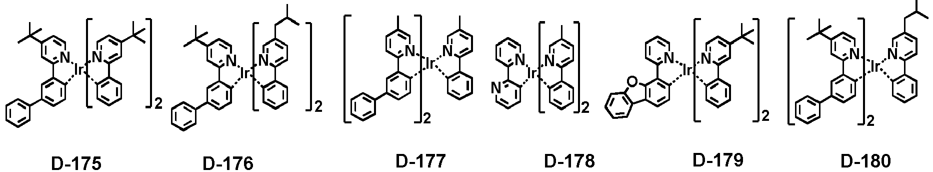

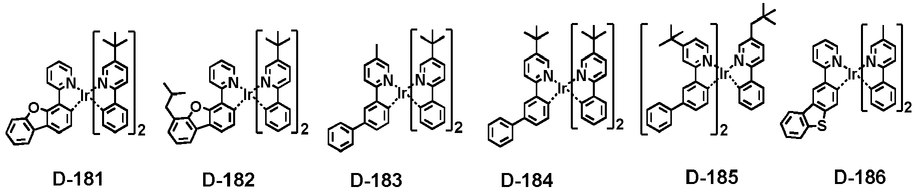

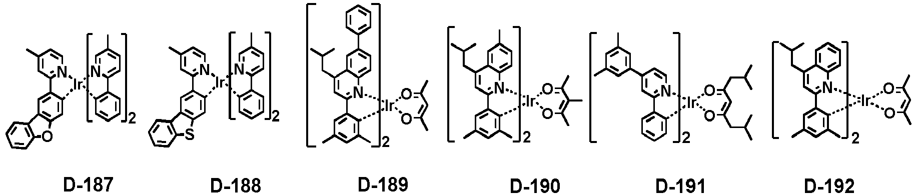

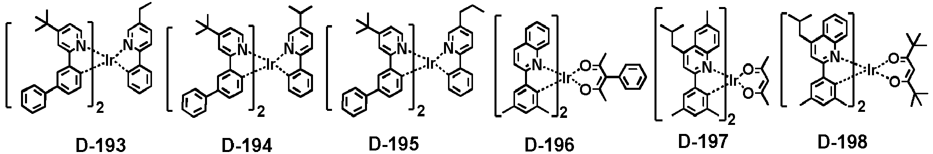

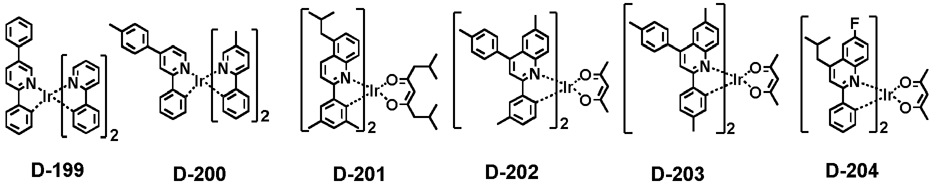

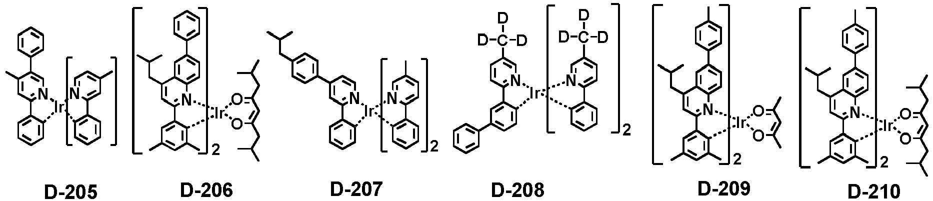

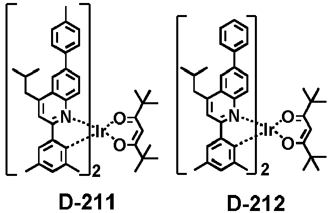

The organic EL device of the present invention may further include at least one compound selected from the group consisting of arylamine-based compounds and styrylarylamine-based compounds in the organic layer.

In the organic EL device of the present invention, the organic layer may further comprise at least one metal selected from the group consisting of metals of Group 1, metals of Group 2, transition metals of the 4^{th} period, transition metals of the 5^{th} period, lanthanides, and organic metals of d-transition elements of the Periodic Table, or at least one complex compound comprising the metal.

Preferably, in the organic EL device of the present invention, at least one layer (hereinafter, "a surface layer") selected from a chalcogenide layer, a metal halide layer and a metal oxide layer may be placed on an inner surface(s) of one or both electrode(s). Specifically, it is preferred that a chalcogenide (including oxides) layer of silicon or aluminum is placed on an anode surface of a light-emitting medium layer, and a metal halide layer or metal oxide layer is placed on a cathode surface of an electroluminescent medium layer. The surface layer provides operating stability for the organic EL device. Preferably, the chalcogenide includes SiO_{X}(1≤X≤2), AlO_{X}(1≤X≤1.5), SiON, SiAlON, etc.; the metal halide includes LiF, MgF₂, CaF₂, a rare earth metal fluoride, etc.; and the metal oxide includes CS₂O, Li₂O, MgO, SrO, BaO, CaO, etc.

A hole injection layer, a hole transport layer, an electron injection layer, or their combinations can be used between an anode and a light-emitting layer. The hole injection layer may be multi-layers in order to lower a hole injection barrier (or hole injection voltage) from an anode to a hole transport layer or electron blocking layer, wherein each of the multi-layers simultaneously may use two compounds. The hole transport layer or the electron blocking layer may also be multi-layers.

An electron buffer layer, a hole blocking layer, an electron transport layer, an electron injection layer, or their combinations can be used between a light-emitting layer and a cathode. The electron buffer layer may be multi-layers in order to control the injection of an electron and improve interface properties between the light-emitting layer and the electron injection layer, wherein each of the multi-layers simultaneously may use two compounds. The hole blocking layer or the electron transport layer may also be multi-layers, wherein each of the multi-layers may use a multi-component of compounds.

Preferably, in the organic EL device of the present invention, a mixed region of an electron transport compound and a reductive dopant, or a mixed region of a hole transport compound and an oxidative dopant may be placed on at least one surface of a pair of electrodes. In this case, the electron transport compound is reduced to an anion, and thus it becomes easier to inject and transport electrons from the mixed region to a light-emitting medium. Further, the hole transport compound is oxidized to a cation, and thus it becomes easier to inject and transport holes from the mixed region to a light-emitting medium. Preferably, the oxidative dopant includes various Lewis acids and acceptor compounds; and the reductive dopant includes alkali metals, alkali metal compounds, alkaline earth metals, rare-earth metals, and mixtures thereof. A reductive dopant layer may be employed as a charge-generating layer to prepare an organic EL device having two or more light-emitting layers and emitting white light.

In order to form each layer constituting the organic EL device of the present invention, dry film-forming methods, such as vacuum deposition, sputtering, plasma, ion plating methods, etc., or wet film-forming methods, such as ink jet printing, nozzle printing, slot printing, spin coating, dip coating, flow coating methods, etc., can be used. When forming a layer by using a first host and a second host according to the present invention, co-deposition or mixed-deposition may be used.

When using a wet film-forming method, a thin film is formed by dissolving or dispersing the material constituting each layer in suitable solvents, such as toluene, xylene, anisole, chlorobenzene, ethanol, chloroform, tetrahydrofuran, dioxane, etc. The solvents are not specifically limited as long as the material constituting each layer is soluble or dispersible in the solvents and the solvents do not cause any problems in forming a layer.

Furthermore, a display device or a light device can be produced by using the organic EL device of the present invention.

Hereinafter, luminous properties of the devices comprising the host compounds of the present invention will be explained in detail with reference to the following examples. According to the present invention, the organic EL devices having high efficiency and long lifespan are provided. The host materials comprising at least two kinds of the derivatives may be deposited by at least two methods including the following methods:
1. Co-deposition: At least two different materials are added into separate crucibles and electric current is simultaneously applied to the two or more cells to evaporate the materials.
2. Mixed-deposition: At least two different materials are mixed in one crucible prior to deposition and electric current is then applied to the one cell to evaporate the materials.

### Device Examples 1-1 to 1-9: Production of an OLED device by co-deposition of the first host compound and the second host compound according to the present invention as a host Device Examples 1-10 to 1-12 are not according to the invention.

OLED devices comprising the luminous material of the present invention were produced as follows: A transparent electrode indium tin oxide (ITO) thin film (10 Ω/sq) on a glass substrate for an OLED device (Samsung Corning, Republic of Korea) was subjected to an ultrasonic washing with trichloroethylene, acetone, ethanol, and distilled water, sequentially, and was then stored in isopropanol. Next, the ITO substrate was mounted on a substrate holder of a vacuum vapor depositing apparatus. HI-1 was introduced into a cell of the vacuum vapor depositing apparatus, and the pressure in the chamber of the apparatus was then controlled to 10⁻⁶ torr. Thereafter, an electric current was applied to the cell to evaporate the introduced material, thereby forming a first hole injection layer (HIL) HI-1 having a thickness of 80 nm on the ITO substrate. HI-2 was then introduced into another cell of the vacuum vapor depositing apparatus, and an electric current was applied to the cell to evaporate the introduced material, thereby forming a second hole injection layer (HIL) HI-2 having a thickness of 3 to 5 nm on the first hole injection layer (HIL) HI-1. HT-1 was introduced into another cell of the vacuum vapor depositing apparatus. Afterward, an electric current was applied to the cell to evaporate the introduced material, thereby forming a hole transport layer (HTL) HT-1 having a thickness of 25 to 40 nm on hole injection layer HI-2. After forming the hole injection layer and the hole transport layer, a light-emitting layer (EML) was then deposited as follows. The first and second host compounds disclosed in Table 1 below as a host were introduced into two cells of the vacuum vapor depositing apparatus, respectively, and a dopant material recited in Table 1 below was introduced into another cell. The two host materials were evaporated at the same rates of 1:1, and the dopant material was evaporated at a different rate and deposited in a doping amount of 15 wt%, based on the total weight of the host and dopant, to form a light-emitting layer having a thickness of 40 nm on the hole transport layer HT-1. Next, ET-1 or ET-2 and EI-1 were evaporated at the rates of 5:5 to 4:6 on another two cells to form an electron transport layer (ETL) having a thickness of 30 to 35 nm on the light-emitting layer. After depositing EI-1 having a thickness of 2 nm as an electron injection layer (EIL) on the electron transport layer, an Al cathode was then deposited by another vacuum vapor deposition apparatus on the electron injection layer. Thus, an OLED device was produced.

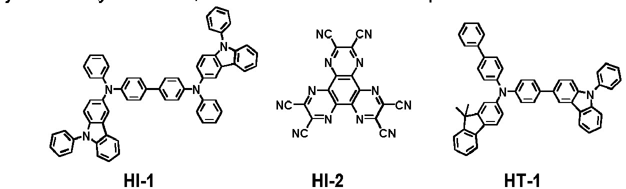

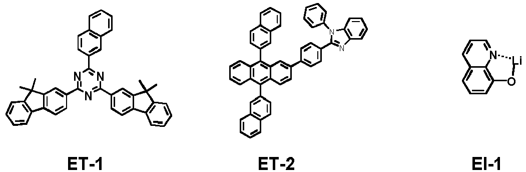

### Comparative Examples 1-1 to 1-4: Production of an OLED device by using only the first host compound according to the present invention as a host

OLED devices were produced in the same manner as in Device Examples 1-1 to 1-12, except that only the first host compounds of Comparative Examples 1-1 to 1-4 disclosed in Table 1 below were used as a host in a light-emitting layer.

### Comparative Examples 2-1 to 2-7: Production of an OLED device by using only the second host compound according to the present invention as a host

OLED devices were produced in the same manner as in Device Examples 1-1 to 1-12, except that only the second host compounds of Comparative Examples 2-1 to 2-7 disclosed in Table 1 below were used as a host in a light-emitting layer.

The detailed components for constituting the devices of the Device and Comparative Examples are as provided in Table 1 below.

**Table 1**

| | HIL (HI-1) (nm) | HIL (HI-2) (nm) | HTL (HT-1) (nm) | EML (Host + Dopant) | | ETL (ET-1 or ET-2:EI-(nm) | EIL (EI-1) (nm) |
|---|---|---|---|---|---|---|---|
| Device Example 1-1 | 80 | 3 | 40 | H1-1: H2-31 (1:1) | D-25 | ET-1:EI-1 (35, 4:6) | 2 |
| Device Example 1-2 | 80 | 3 | 40 | H1-1: H2-34 (1:1) | D-25 | ET-1:EI-1 (35, 4:6) | 2 |
| Device Example 1-3 | 80 | 3 | 40 | H1-1: H2-48 (1:1) | D-25 | ET-1:EI-1 (35, 4:6) | 2 |
| Device Example 1-4 | 80 | 3 | 40 | H1-1: H2-101 (1:1) | D-25 | ET-1:EI-1 (35, 4:6) | 2 |
| Device Example 1-5 | 80 | 3 | 40 | H1-1: H2-195 (1:1) | D-25 | ET-1:EI-1 (35, 4:6) | 2 |
| Device Example 1-6 | 80 | 3 | 40 | H1-1: H2-356 (1:1) | D-25 | ET-1:EI-1 (35, 4:6) | 2 |
| Device Example 1-7 | 80 | 3 | 40 | H1-1: H2-476 (1:1) | D-25 | ET-1:EI-1 (35, 4:6) | 2 |
| Device Example 1-8 | 80 | 3 | 40 | H1-1: H2-477 (1:1) | D-25 | ET-1:EI-1 (35,4:6) | 2 |
| Device Example 1-9 | 80 | 3 | 40 | H1-2: H2-31 (1:1) | D-25 | ET-1:EI-1 (35,4:6) | 2 |
| Device Example 1-10 | 80 | 3 | 40 | H1-5: H2-31 (1:1) | D-25 | ET-1:EI-1 (35,4:6) | 2 |
| Device Example 1-11 | 80 | 3 | 40 | H1-116: H2-31 (1:1) | D-25 | ET-1:EI-1 (35,4:6) | 2 |
| Device Example 1-12 | 80 | 3 | 40 | H1-8: H2-31 (1:1) | D-25 | ET-1:EI-1 (35,4:6) | 2 |
| Comparative Example 1-1 | 80 | 3 | 25 | H1-5 | D-1 | ET-2:EI-1 (35, 4:6) | 2 |
| Comparative Example 1-2 | 80 | 5 | 25 | H1-8 | D-1 | ET-2:EI-1 (30, 5:5) | 2 |
| Comparative Example 1-3 | 80 | 3 | 40 | H1-1 | D-25 | ET-1:EI-1 (35, 4:6) | 2 |
| Comparative Example 1-4 | 80 | 5 | 25 | H1-116 | D-25 | ET-2:EI-1 (30, 5:5) | 2 |
| Comparative Example 2-1 | 80 | 3 | 40 | H2-31 | D-25 | ET-1:EI-1 (35, 4:6) | 2 |
| Comparative Example 2-2 | 80 | 3 | 40 | H2-34 | D-25 | ET-1:EI-1 (35, 4:6) | 2 |
| Comparative Example 2-3 | 80 | 3 | 40 | H2-48 | D-25 | ET-1:EI-1 (35, 4:6) | 2 |
| Comparative Example 2-4 | 80 | 3 | 40 | H2-101 | D-25 | ET-1:EI-1 (35, 4:6) | 2 |
| Comparative Example 2-5 | 80 | 3 | 25 | H2-195 | D-1 | ET-2:EI-1 (35, 4:6) | 2 |
| Comparative Example 2-6 | 80 | 3 | 40 | H2-476 | D-1 | ET-1:EI-1 (35, 4:6) | 2 |
| Comparative Example 2-7 | 80 | 3 | 40 | H2-477 | D-1 | ET-1:EI-1 (35, 4:6) | 2 |

Device Examples 1-10 to 1-12 are not according to the invention.

The driving voltage at a luminance of 1,000 nit, luminous efficiency, CIE color coordinate, and the lifespan taken to be reduced from 100% to 90% of a luminance of 15,000 nit at the constant current of the OLED devices produced in Device Examples 1-1 to 1-12, Comparative Examples 1-1 to 1-4, and Comparative Examples 2-1 to 2-7 are as provided in Table 2 below.

**Table 2**

| | Host | Dopant | Voltage (V) | Efficiency (cd/A) | Color Coordinate (x, y) | | Lifespan (hr) |
|---|---|---|---|---|---|---|---|
| Device Example 1-1 | H1-1: H2-31 (1:1) | D-25 | 3.1 | 57.1 | 306 | 657 | 103 |
| Device Example 1-2 | H1-1: H2-34 (1:1) | D-25 | 3.3 | 52.3 | 306 | 656 | 65 |
| Device Example 1-3 | H1-1: H2-48 (1:1) | D-25 | 2.9 | 52.4 | 304 | 656 | 60 |
| Device Example 1-4 | H1-1: H2-101 (1:1) | D-25 | 3.1 | 53.6 | 307 | 653 | 41 |
| Device Example 1-5 | H1-1: H2-195 (1:1) | D-25 | 3.4 | 53.7 | 305 | 655 | 57 |
| Device Example 1-6 | H1-1: H2-356 (1:1) | D-25 | 3.4 | 54.7 | 308 | 655 | 39 |
| Device Example 1-7 | H1-1: H2-476 (1:1) | D-25 | 3.1 | 55.6 | 308 | 655 | 33 |
| Device Example 1-8 | H1-1: H2-477 (1:1) | D-25 | 3.2 | 53.8 | 307 | 653 | 52 |
| Device Example 1-9 | H1-2: H2-31 (1:1) | D-25 | 3.2 | 54 | 307 | 656 | 93 |
| Device Example 1-10 | H1-5: H2-31 (1:1) | D-25 | 2.9 | 51.3 | 302 | 657 | 132 |
| Device Example 1-11 | H1-116: H2-31 (1:1) | D-25 | 3.0 | 52.4 | 303 | 657 | 66 |
| Device Example 1-12 | H1-8: H2-31 (1:1) | D-25 | 3.3 | 52.2 | 305 | 656 | 110 |
| Comparative Example 1-1 | H1-5 | D-1 | 3.6 | 57.3 | 333 | 634 | 10 |
| Comparative Example 1-2 | H1-8 | D-1 | 5.0 | 37.2 | 353 | 616 | 68 |
| Comparative Example 1-3 | H1-1 | D-25 | 6.2 | 4.2 | 298 | 653 | X^{*} |
| Comparative Example 1-4 | H1-116 | D-25 | 4.0 | 26.3 | 305 | 652 | 10 |
| Comparative Example 2-1 | H2-31 | D-25 | 2.7 | 44.8 | 314 | 652 | 29 |
| Comparative Example 2-2 | H2-34 | D-25 | 2.7 | 49.2 | 312 | 652 | 38 |
| Comparative Example 2-3 | H2-48 | D-25 | 2.6 | 49.6 | 314 | 652 | 45 |
| Comparative Example 2-4 | H2-101 | D-25 | 2.8 | 50.3 | 315 | 651 | 6 |
| Comparative Example 2-5 | H2-195 | D-1 | 2.8 | 49.6 | 330 | 636 | 97 |
| Comparative Example 2-6 | H2-476 | D-1 | 3.2 | 32.6 | 333 | 648 | 15 |
| Comparative Example 2-7 | H2-477 | D-1 | 2.6 | 45 | 323 | 652 | 14 |

Device Examples 1-10 to 1-12 are not according to the invention.

Note: X* means "unmeasurable." (It was not possible to measure the lifespan at a luminance of 15,000 nit of the device of Comparative Example 1-3 of Table 2 above since the device of Comparative Example 1-3 has very low efficiency.)

## Claims

1. An organic electroluminescent device comprising at least one light-emitting layer between an anode and a cathode, wherein the light-emitting layer comprises a host and a phosphorescent dopant; the host consists of multi-component host compounds; at least a first host compound of the multi-component host compounds is represented by the following formula 1 which is a bicarbazole derivative containing pyridine, and a second host compound is represented by the following formula 2 which is a carbazole derivative including a nitrogen-containing heteroaryl group: 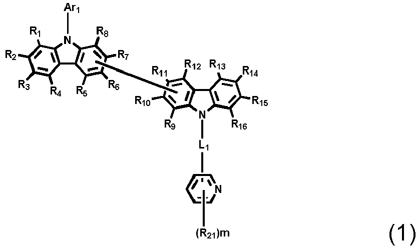 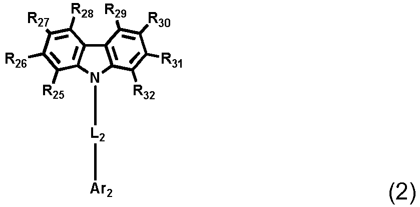 Wherein
Ar₁ represents a substituted or unsubstituted (C6-C30)aryl group;
L₁ and L₂ each independently represent a substituted or unsubstituted (C6-C18)arylene group, wherein the substituent(s) of the substituted arylene group of L₁ and L₂ is independently selected from the group consisting of hydrogen, deuterium, and an unsubstituted (C6-C60)aryl group;
R₁ to R₁₆ and R₂₁ each independently represent hydrogen, deuterium, or a substituted or unsubstituted (C6-C60)aryl group;
wherein the substituents of the substituted (C6-C60)aryl group of R₁ to R₁₆ and R₂₁ are selected from the group consisting of (C1-30)alkyl and (C6-C30)aryl;
one of R₅ to R₈ is linked to one of R₉ to R₁₂ via a single bond;
R₂₅ to R₃₂ each independently represent hydrogen, deuterium, a substituted or unsubstituted (C1-C30)alkyl group, a substituted or unsubstituted (C2-C30)alkenyl group, a substituted or unsubstituted (C2-C30)alkynyl group, a substituted or unsubstituted (C3-C30)cycloalkyl group, a substituted or unsubstituted (C6-C60)aryl group, a substituted or unsubstituted 3- to 30-membered heteroaryl group, wherein the 3- to 30- membered heteroaryl is selected from the group consisting of dibenzofuranyl and dibenzothiophenyl, or a substituted or unsubstituted mono- or di-(C6-C30)arylamino group; or are linked between adjacent substituents to form a substituted or unsubstituted mono- or polycyclic, (C3-C30) alicyclic or aromatic ring whose carbon atom(s) ring may be replaced with at least one hetero atom selected from nitrogen, oxygen, and sulfur;
Ar₂ represents a substituted or unsubstituted, nitrogen-containing 5- to 30-membered heteroaryl group;
m represents 1; and
the heteroaryl group of Ar₂ is selected from the group consisting of triazinyl, pyrimidinyl, pyridazinyl, benzoimidazolyl, quinolyl, isoquinolyl, quinazolinyl, quinoxalinyl, naphthyridinyl, and phenanthridinyl, which may be substituted with a (C6-C20)aryl group, a tri(C6-C12)arylsilyl group, a S- or O-containing 5- to 15-membered heteroaryl group, a (C6-C15)aryl group substituted with a (C1-C6)alkyl group, or a (C6-C15)aryl group substituted with a cyano group.

2. The organic electroluminescent device according to claim 1, wherein the compound of formula 1 is represented by one of the following formulae 3 to 6: 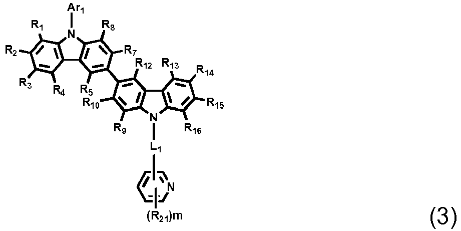 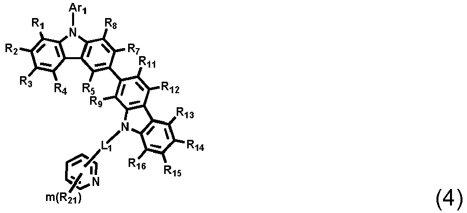 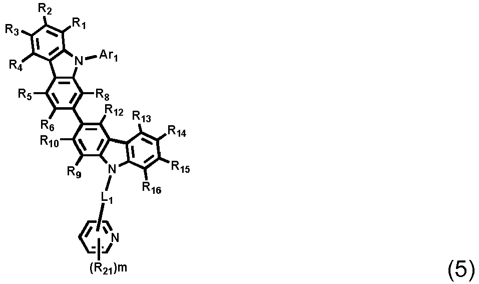 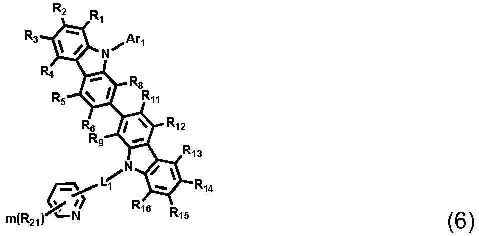 Wherein
Ar₁, L₁, R₁ to R₁₆, R₂₁ and m are as defined in claim 1.

3. The organic electroluminescent device according to claim 1, wherein L₁ and L₂ in formula 1 and 2 represents an unsubstituted (C6-C18)arylene group.

4. The organic electroluminescent device according to claim 1, wherein Ar₂ in formula 2 is triazinyl, pyrimidinyl, quinolyl, quinazolinyl, quinoxalinyl, or naphthyridinyl.

5. The organic electroluminescent device according to claim 1, wherein the first host compound represented by formula 1 is selected from the group consisting of the following compounds:

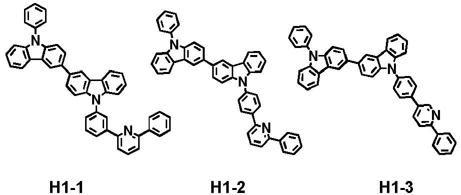

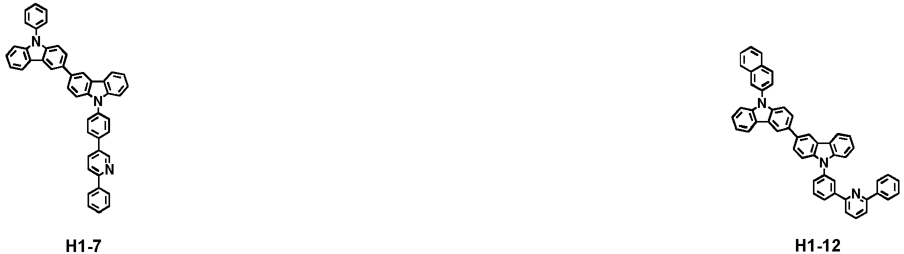

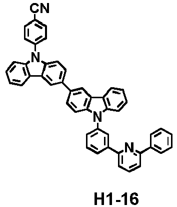

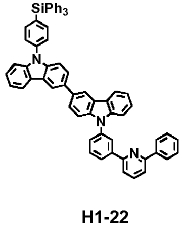

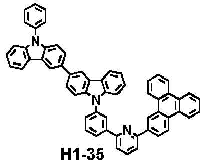

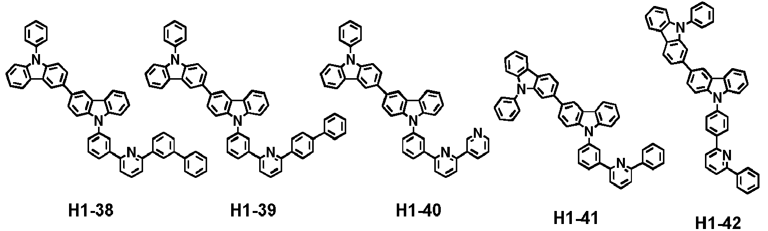

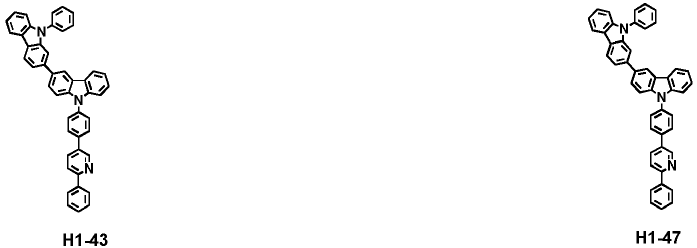

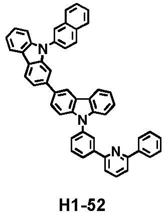

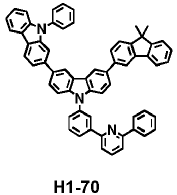

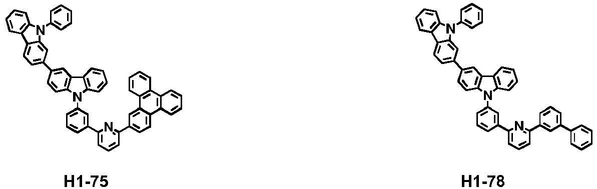

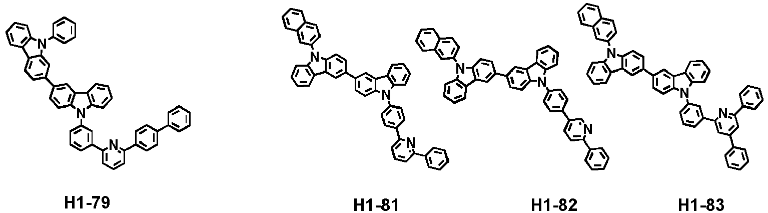

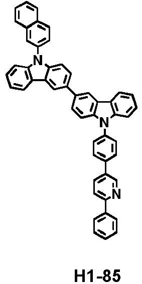

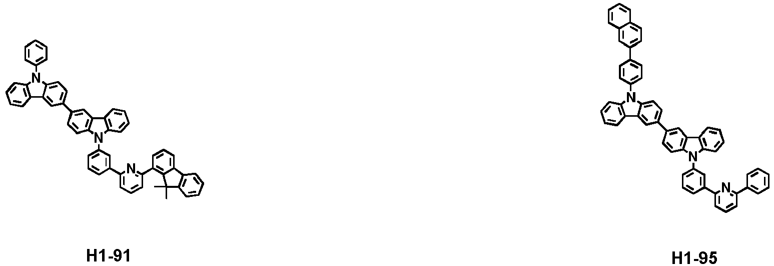

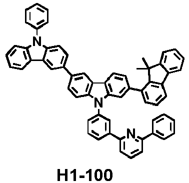

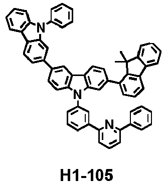

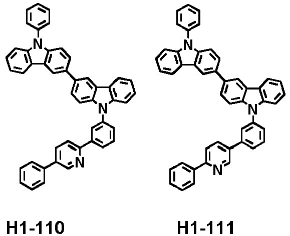

6. The organic electroluminescent device according to claim 1, wherein the second host compound represented by formula 2 is selected from the group consisting of the following compounds:

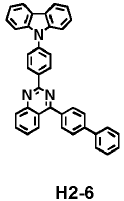

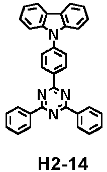

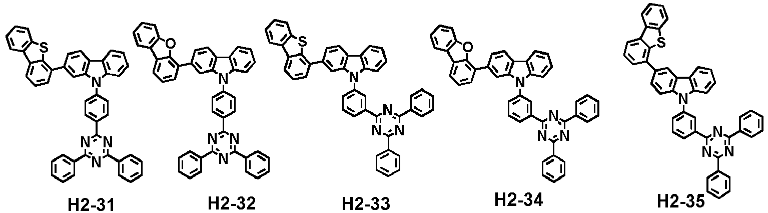

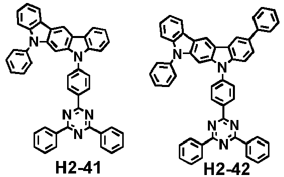

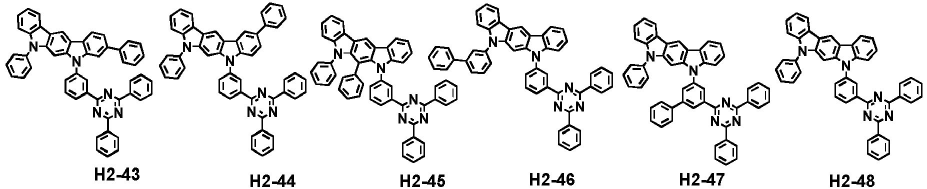

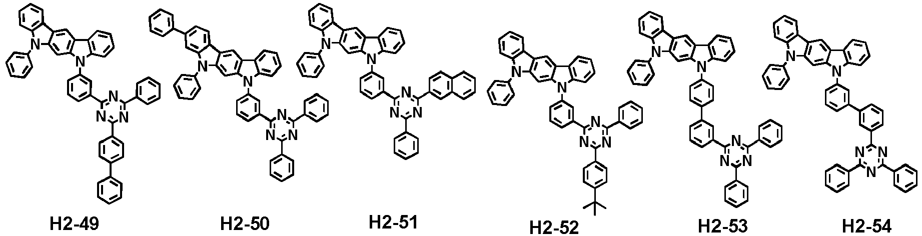

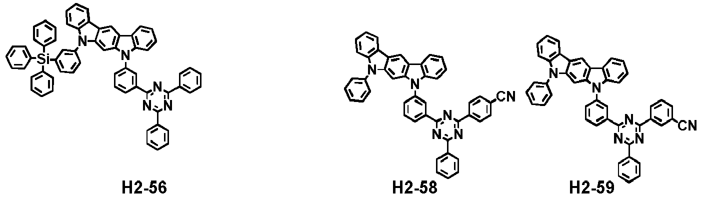

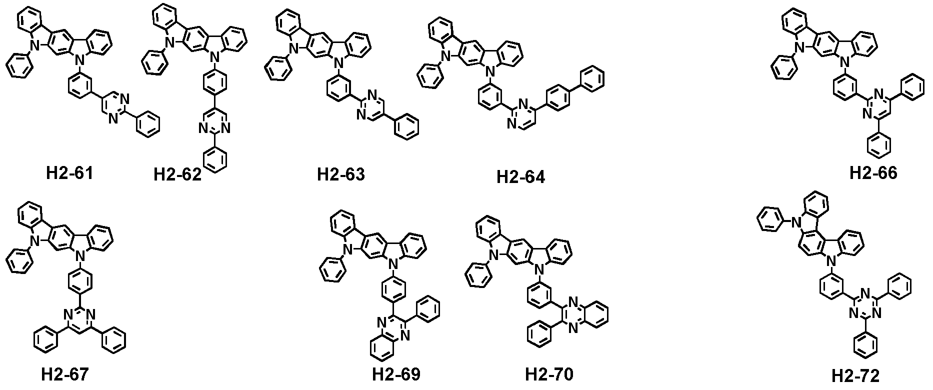

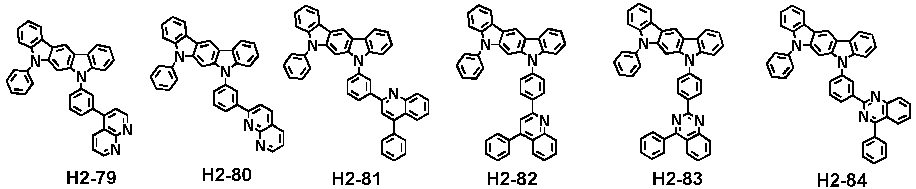

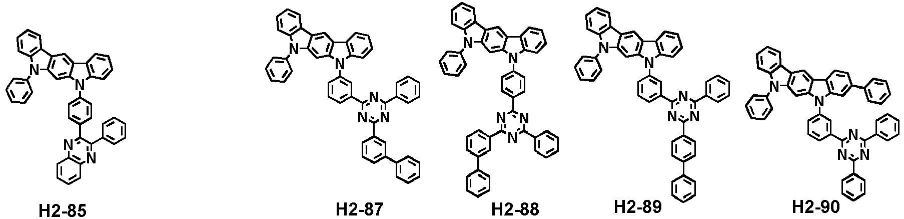

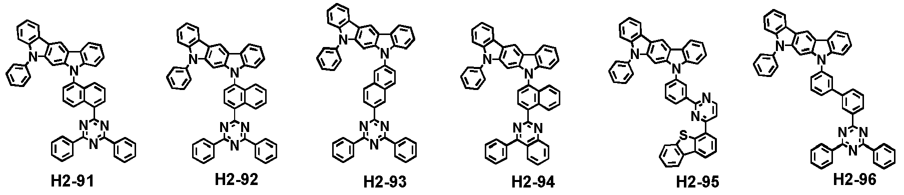

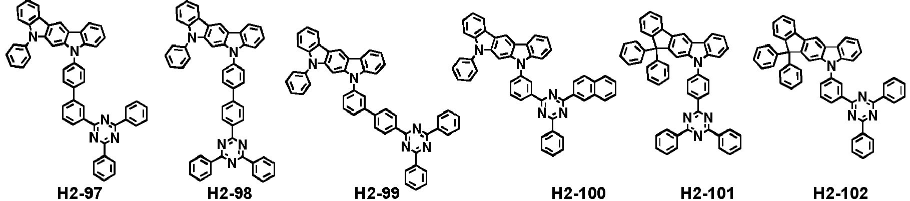

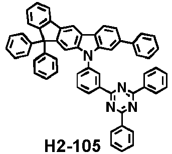

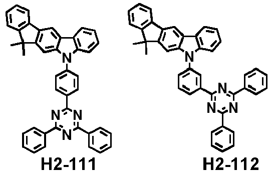

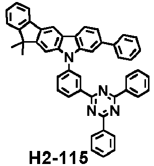

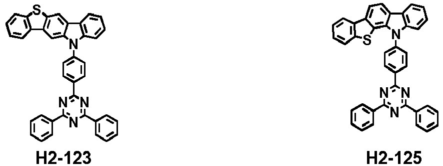

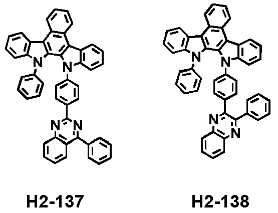

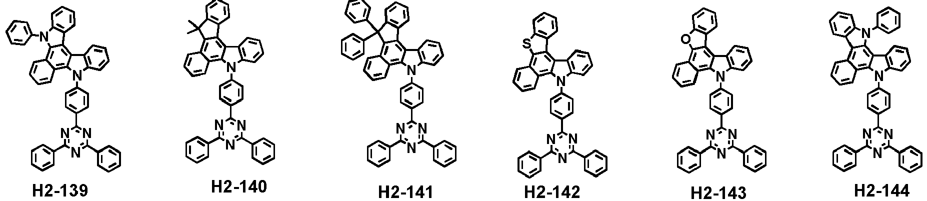

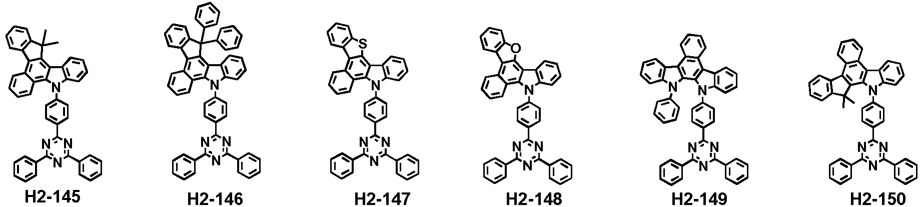

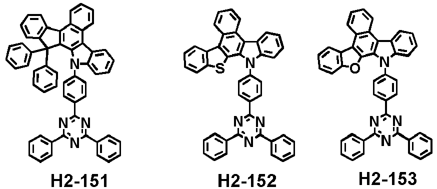

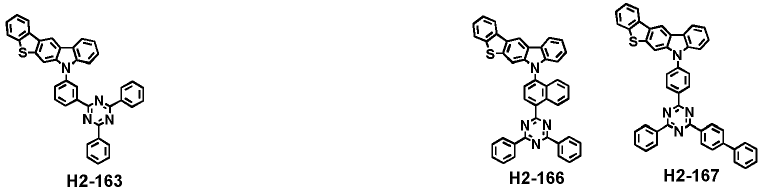

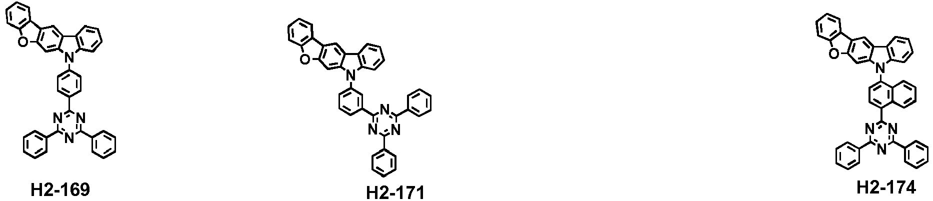

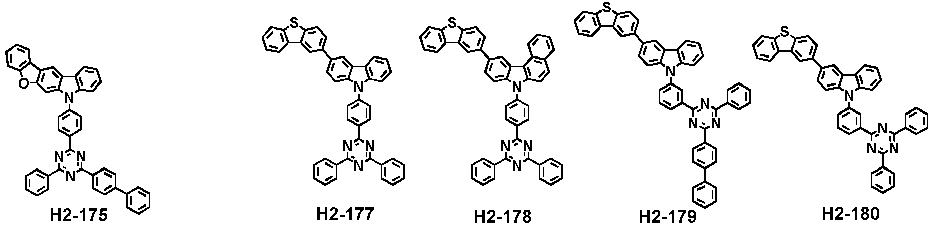

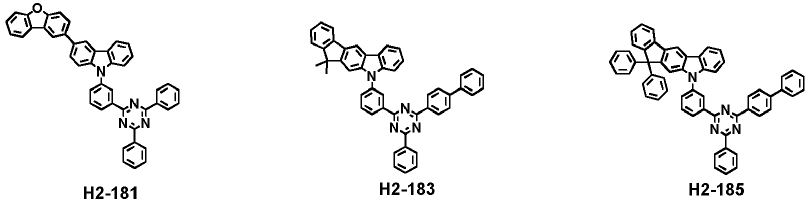

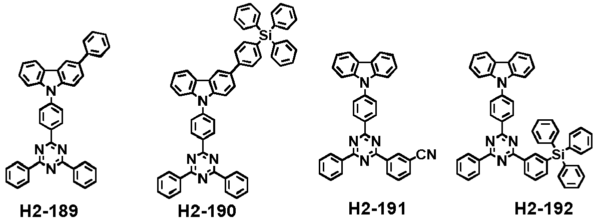

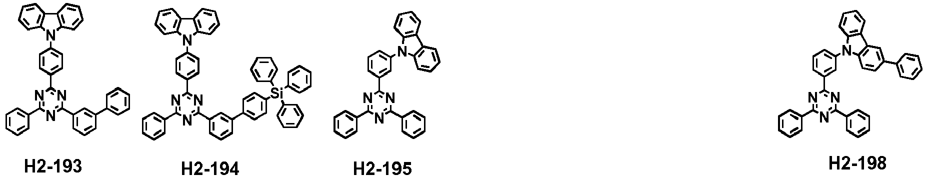

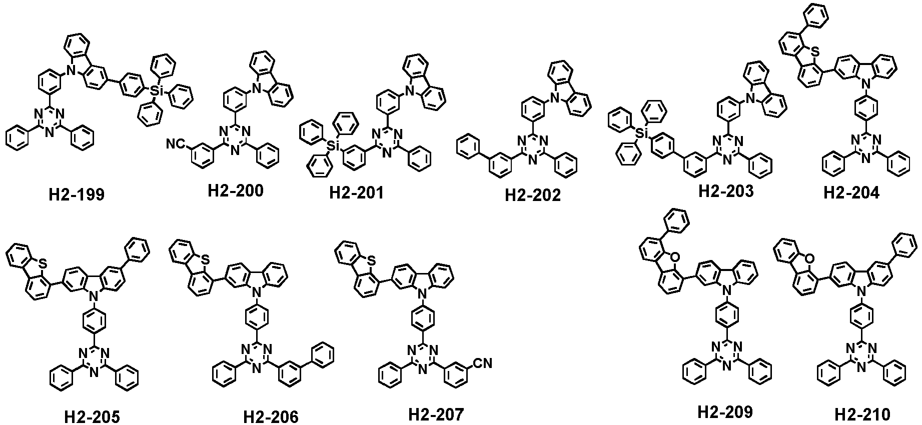

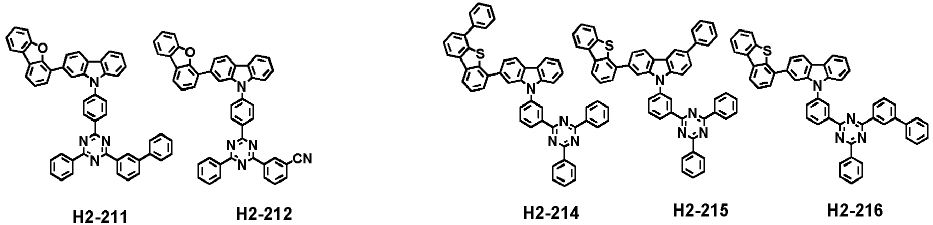

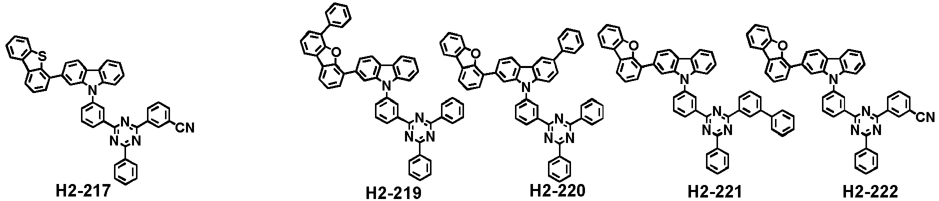

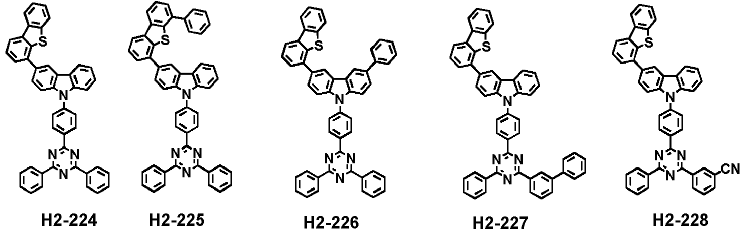

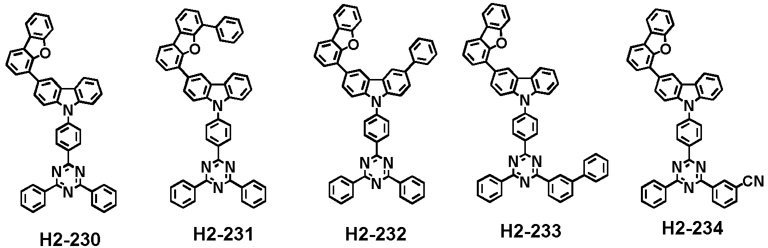

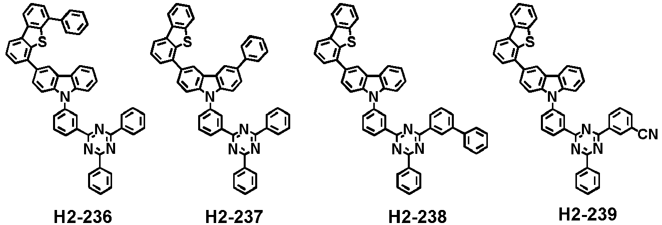

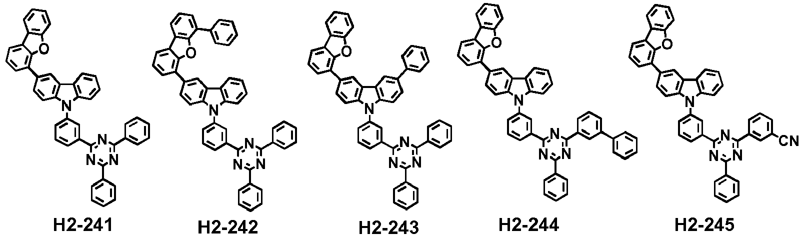

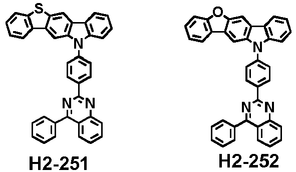

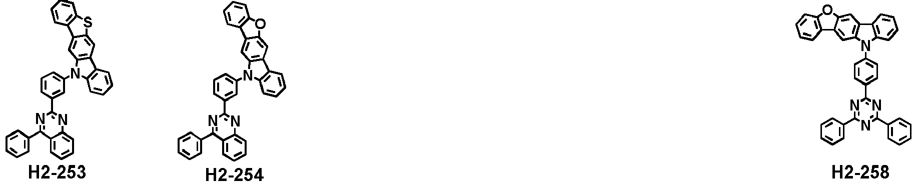

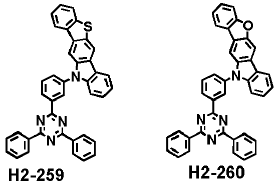

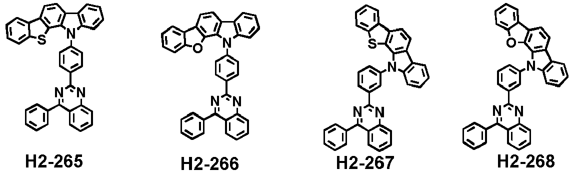

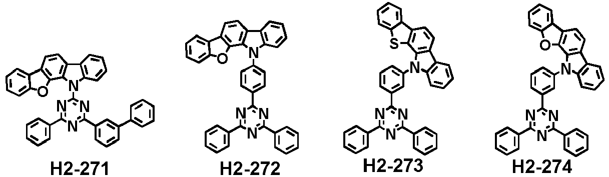

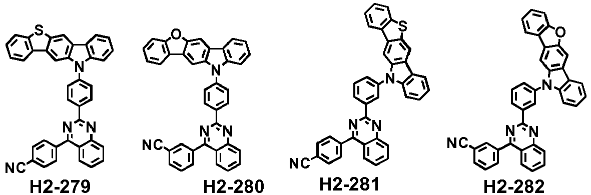

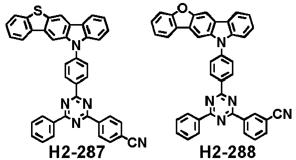

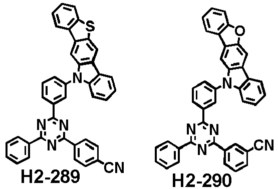

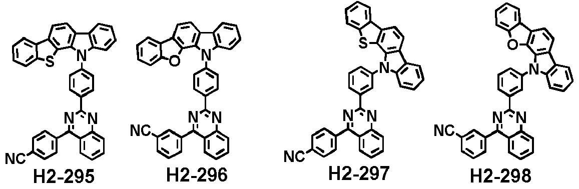

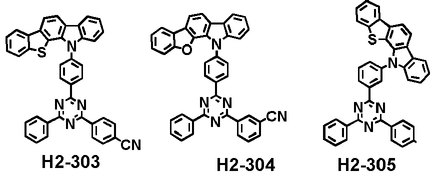

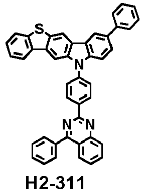

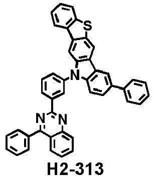

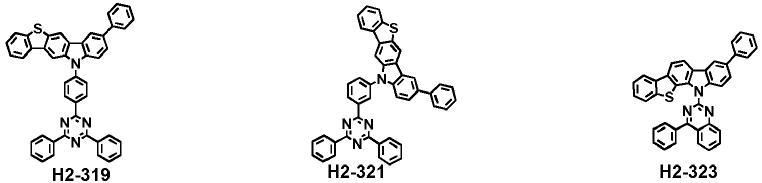

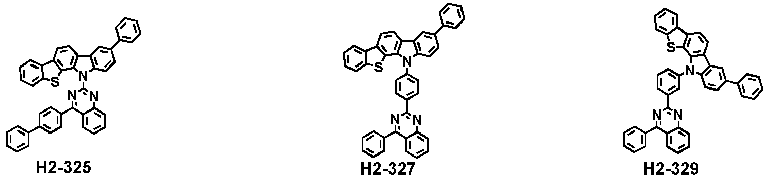

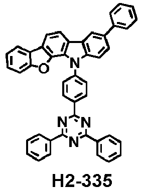

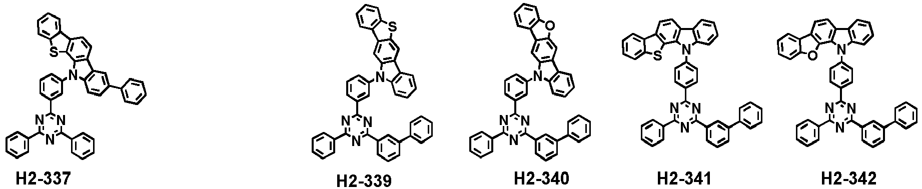

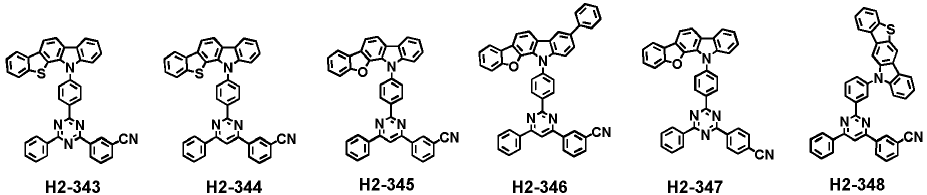

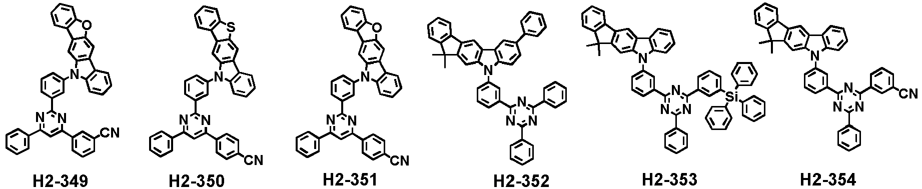

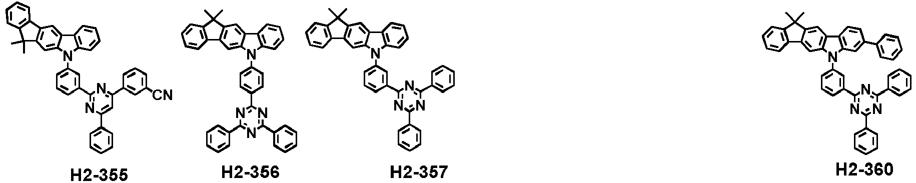

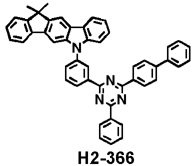

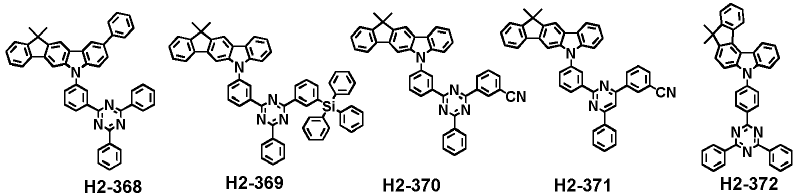

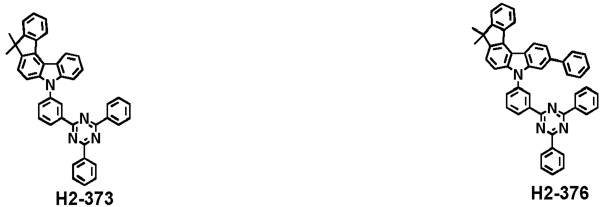

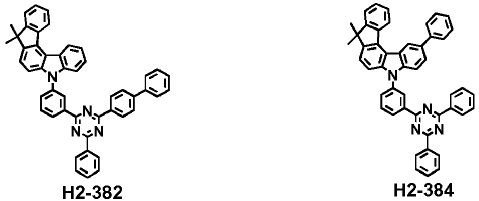

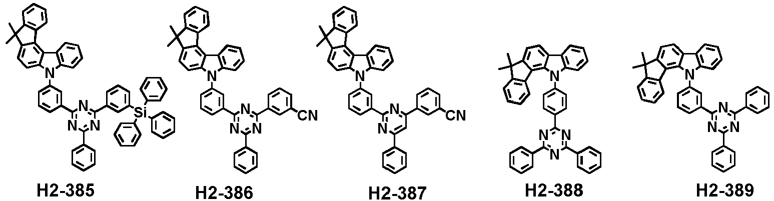

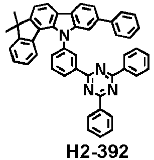

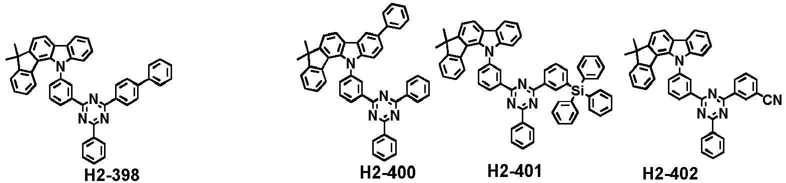

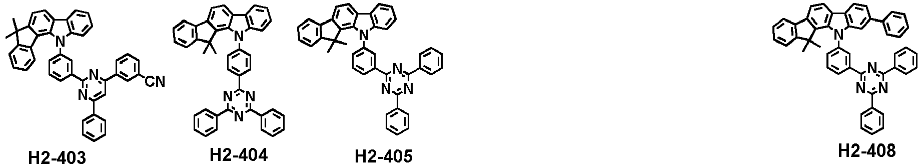

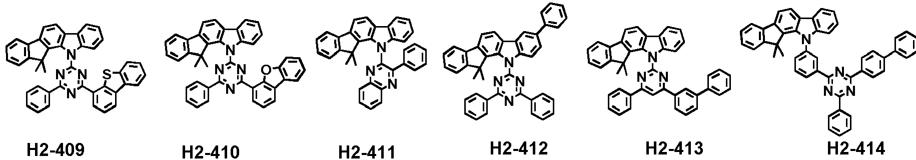

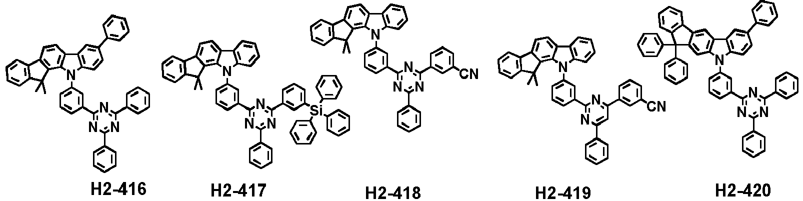

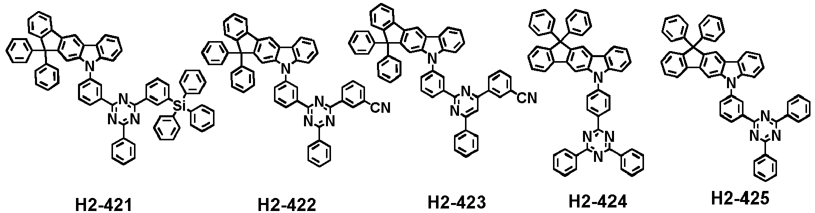

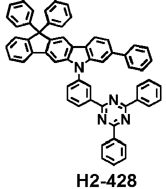

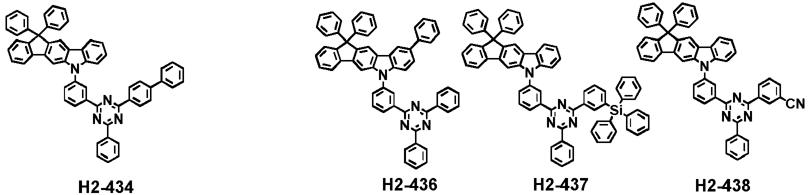

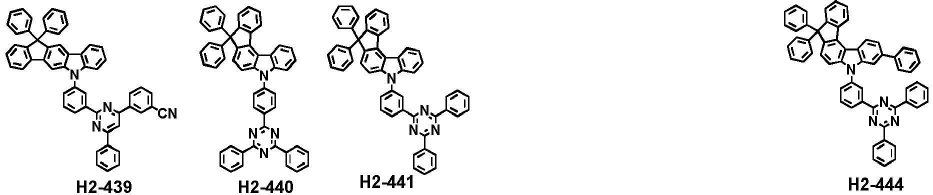

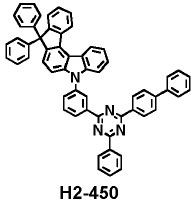

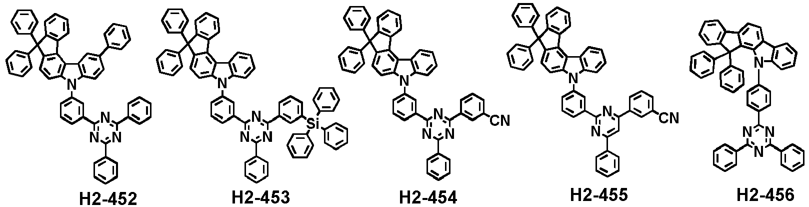

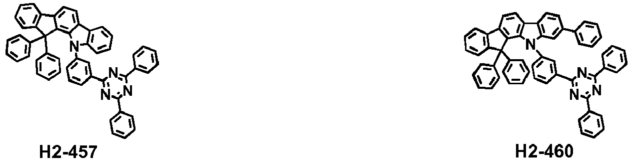

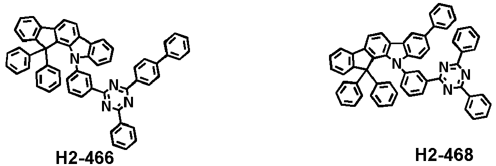

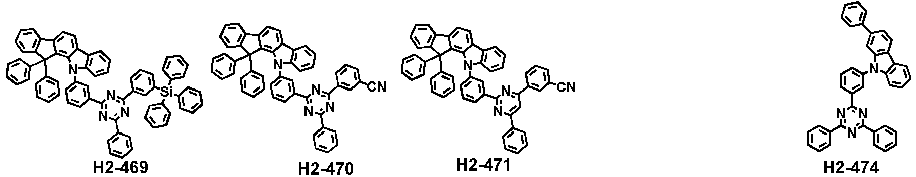

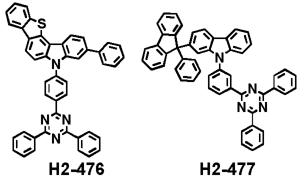

## Patentansprüche

1. Organische elektrolumineszente Vorrichtung, umfassend zumindest eine lichtemittierende Schicht zwischen einer Anode und einer Kathode, wobei die lichtemittierende Schicht einen Wirt und ein phosphoreszierendes Dotierungsmittel umfasst; der Wirt aus Mehrkomponenten-Wirtsverbindungen besteht; zumindest eine erste Wirtsverbindung der Mehrkomponenten-Wirtsverbindungen durch die folgende Formel 1 dargestellt ist, die ein Pyridin enthaltendes Bicarbazolderivat ist, und eine zweite Wirtsverbindung durch die folgende Formel 2 dargestellt ist, die ein Carbazolderivat einschließlich einer stickstoffhaltigen Heteroarylgruppe ist: 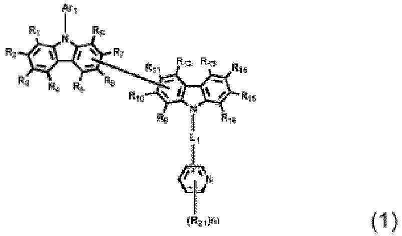 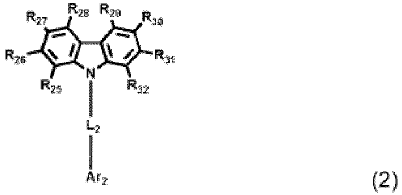 wobei
Ar₁ steht für eine substituierte oder unsubstituierte (C6-C30)Arylgruppe;
L₁ und L₂ jeweils unabhängig stehen für eine substituierte oder unsubstituierte (C6-C18)Arylengruppe, wobei der bzw. die Substituenten der substituierten Arylengruppe von L₁ und L₂ unabhängig aus der Gruppe ausgewählt sind, die aus Wasserstoff, Deuterium und einer unsubstituierten (C6-C60)Arylgruppe besteht;
R₁ bis R₁₆ und R₂₁ jeweils unabhängig stehen für Wasserstoff, Deuterium oder eine substituierte oder unsubstituierte (C6-C60)Arylgruppe;
wobei die Substituenten der substituierten (C6-C60)Arylgruppe von R₁ bis R₁₆ und R₂₁ aus der Gruppe ausgewählt sind, die aus (C1-C30)Alkyl und (C6-C30)Aryl besteht;
eines von R₅ bis R₈ mit einem von R₉ bis R₁₂ via eine Einfachbindung verknüpft ist;
R₂₅ bis R₃₂ jeweils unabhängig stehen für Wasserstoff, Deuterium, eine substituierte oder unsubstituierte (C1-C30)Alkylgruppe, eine substituierte oder unsubstituierte (C2-C30)Alkenylgruppe, eine substituierte oder unsubstituierte (C2-C30)Alkinylgruppe, eine substituierte oder unsubstituierte (C3-C30)Cycloalkylgruppe, eine substituierte oder unsubstituierte (C6-C60)Arylgruppe, eine substituierte oder unsubstituierte 3- bis 30-gliedrige Heteroarylgruppe, wobei das 3- bis 30-gliedrige Heteroaryl aus der Gruppe ausgewählt ist, die aus Dibenzofuranyl und Dibenzothiophenyl besteht, oder eine substituierte oder unsubstituierte Mono- oder Di-(C6-C30)arylaminogruppe; oder zwischen benachbarten Substituenten verknüpft sind, unter Bildung eines substituierten oder unsubstituierten mono- oder polycyclischen, (C3-C30) alicyclischen oder aromatischen Rings, dessen Ring aus Kohlenstoffatom(en) durch zumindest ein Heteroatom, ausgewählt aus Stickstoff, Sauerstoff und Schwefel, ersetzt sein kann;
Ar₂ steht für eine substituierte oder unsubstituierte, stickstoffhaltige 5- bis 30-gliedrige Heteroarylgruppe;
m steht für 1; und
die Heteroarylgruppe von Ar₂ aus der Gruppe ausgewählt ist, die aus Triazinyl, Pyrimidinyl, Pyridazinyl, Benzoimidazolyl, Chinolyl, Isochinolyl, Chinazolinyl, Chinoxalinyl, Naphthyridinyl und Phenanthridinyl besteht, das substituiert sein kann mit einer (C6-C20)Arylgruppe, einer Tri(C6-C12)arylsilylgruppe, einer S- oder O-haltigen 5-bis 15-gliedrigen Heteroarylgruppe, einer (C6-C15)Arylgruppe, substituiert mit einer (C1-C6)Alkylgruppe, oder einer (C6-C15)Arylgruppe, substituiert mit einer Cyanogruppe.

2. Organische elektrolumineszente Vorrichtung nach Anspruch 1, wobei die Verbindung der Formel 1 durch eine der folgenden Formeln 3 bis 6 dargestellt ist: 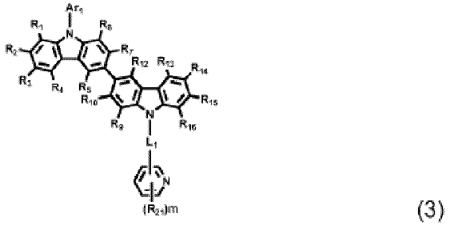 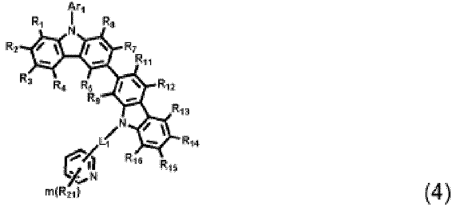 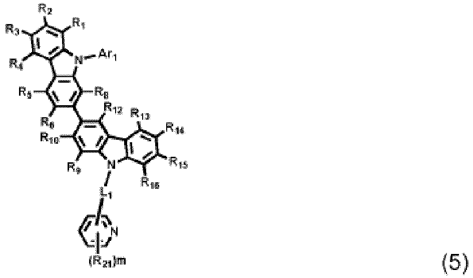 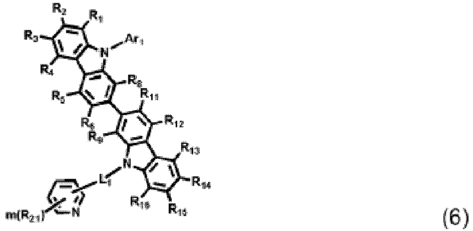 wobei
Ar₁, L₁, R₁ bis R₁₆, R₂₁ und m wie in Anspruch 1 definiert sind.

3. Organische elektrolumineszente Vorrichtung nach Anspruch 1, wobei L₁ und L₂ in Formel 1 und 2 für eine unsubstituierte (C6-C18)Arylengruppe stehen.

4. Organische elektrolumineszente Vorrichtung nach Anspruch 1, wobei Ar₂ in Formel 2 Triazinyl, Pyrimidinyl, Chinolyl, Chinazolinyl, Chinoxalinyl oder Naphthyridinyl ist.

5. Organische elektrolumineszente Vorrichtung nach Anspruch 1, wobei die erste Wirtsverbindung, die durch Formel 1 dargestellt ist, aus der Gruppe ausgewählt ist, die aus den folgenden Verbindungen besteht:

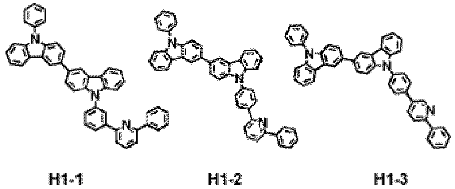

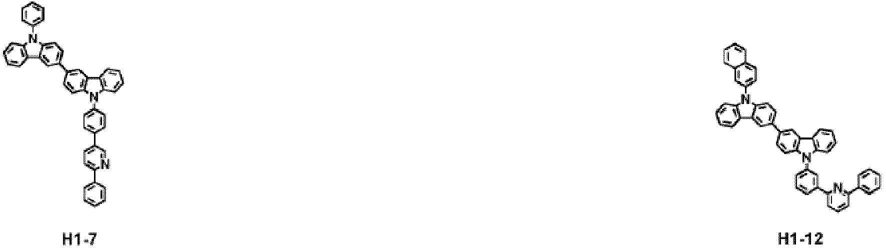

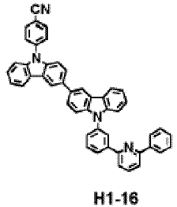

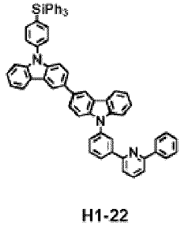

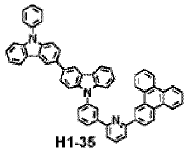

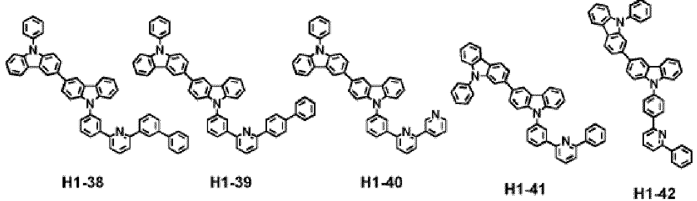

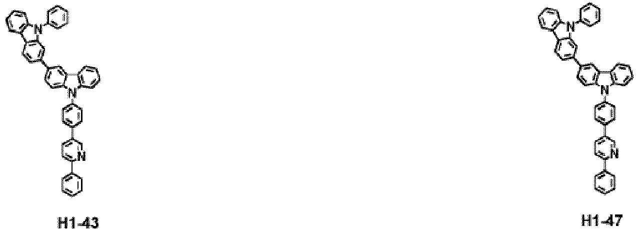

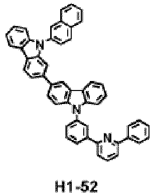

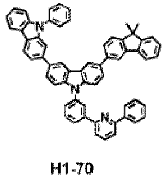

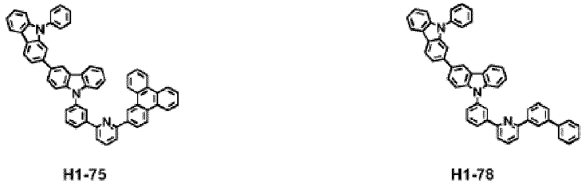

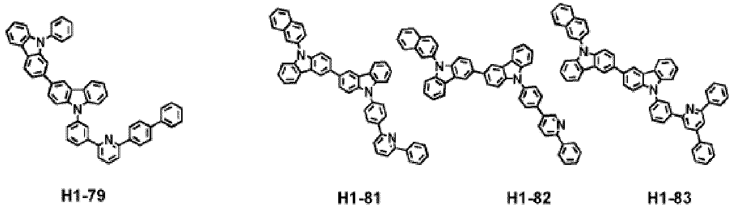

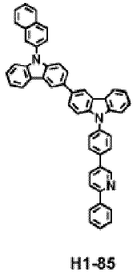

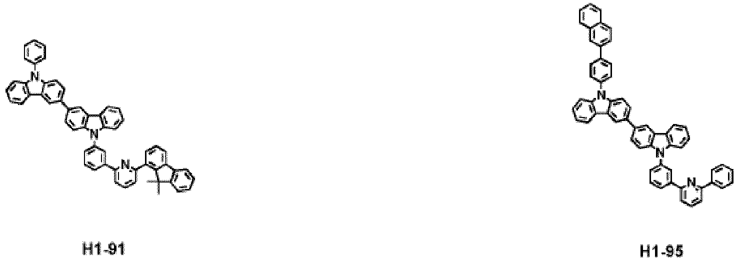

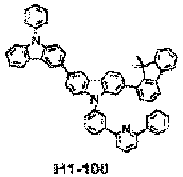

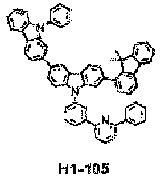

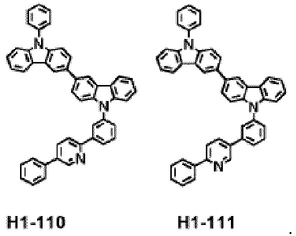

6. Organische elektrolumineszente Vorrichtung nach Anspruch 1, wobei die zweite Wirtsverbindung, die durch Formel 2 dargestellt ist, aus der Gruppe ausgewählt ist, die aus den folgenden Verbindungen besteht:

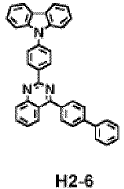

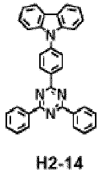

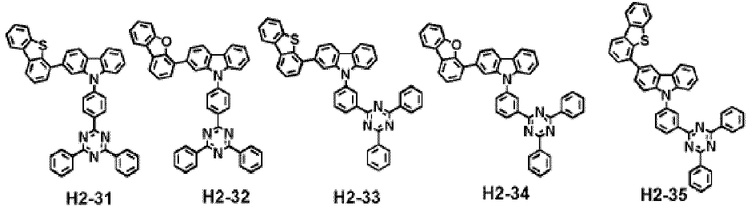

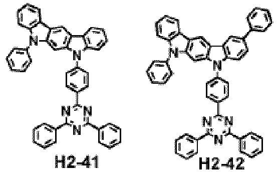

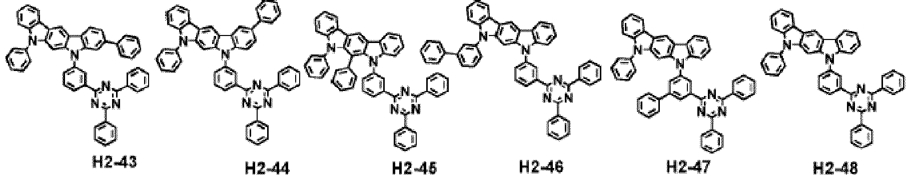

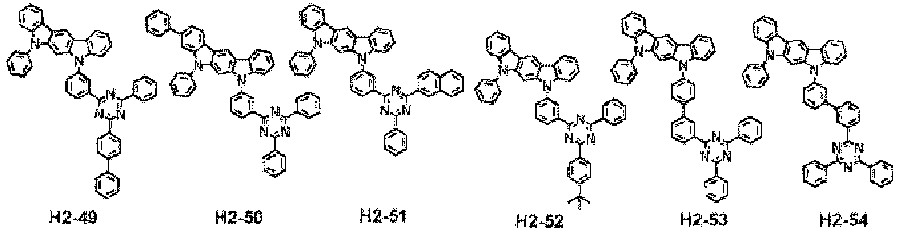

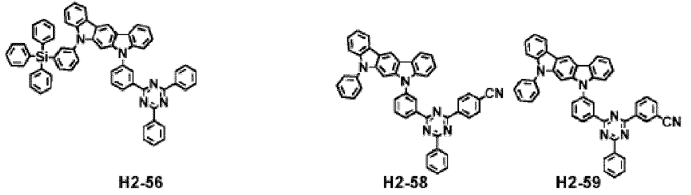

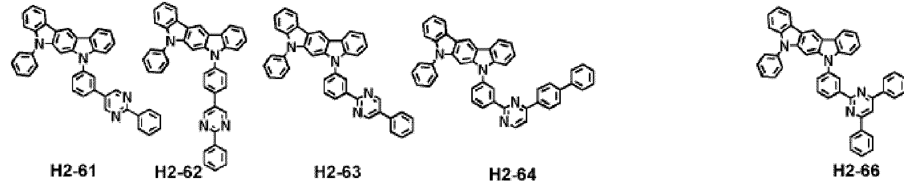

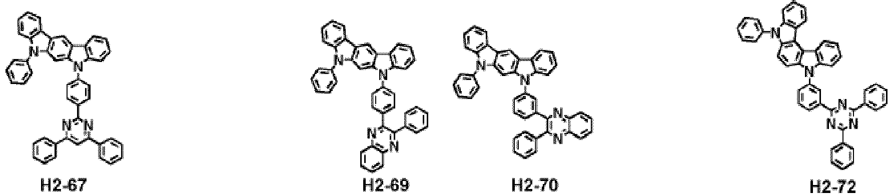

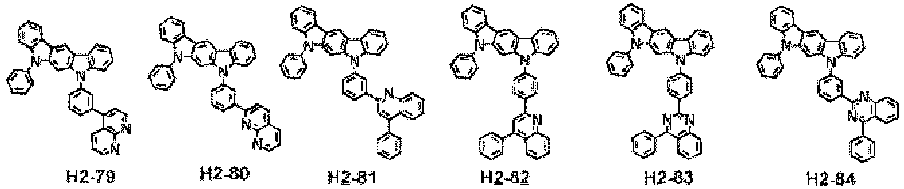

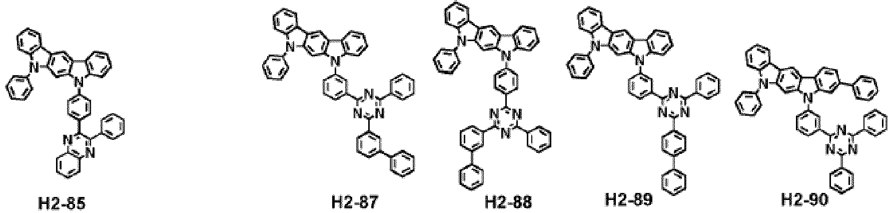

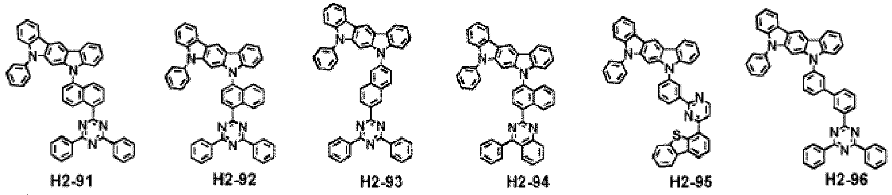

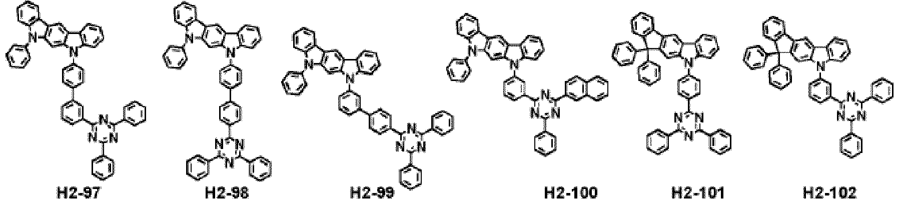

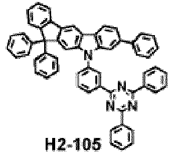

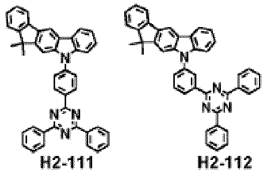

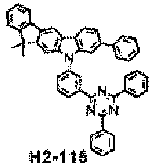

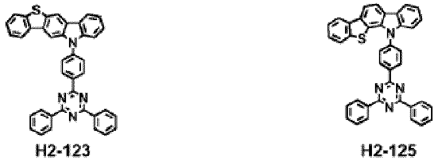

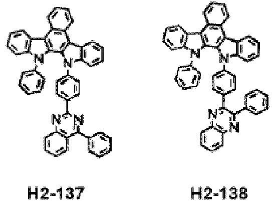

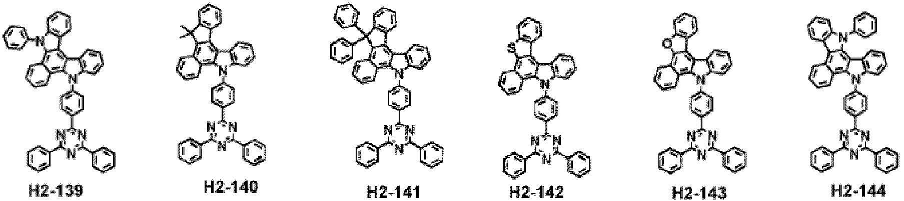

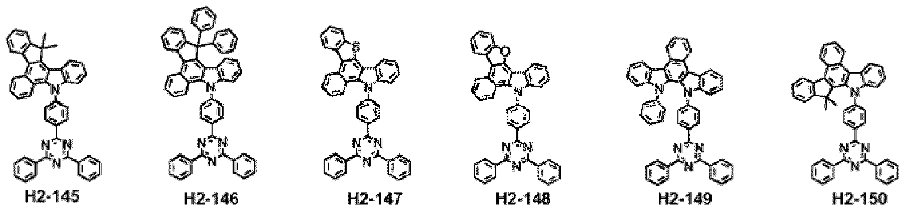

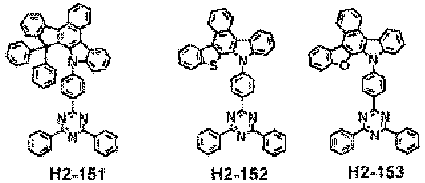

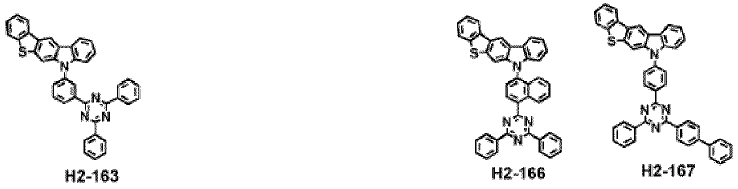

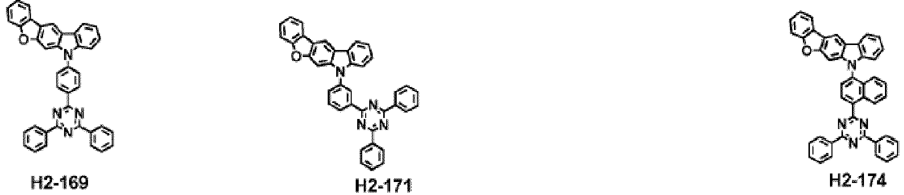

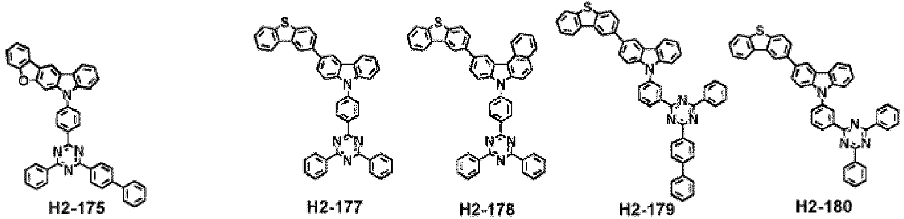

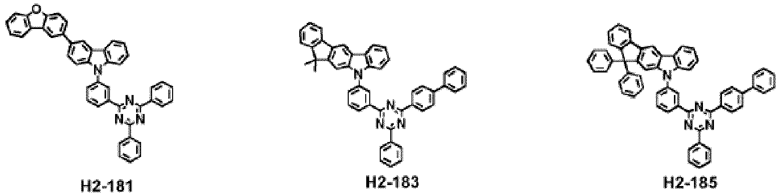

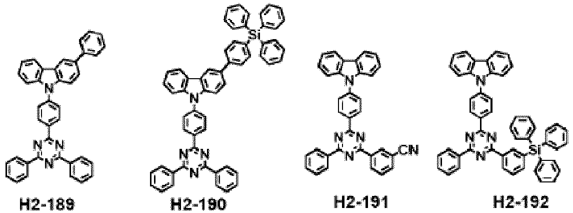

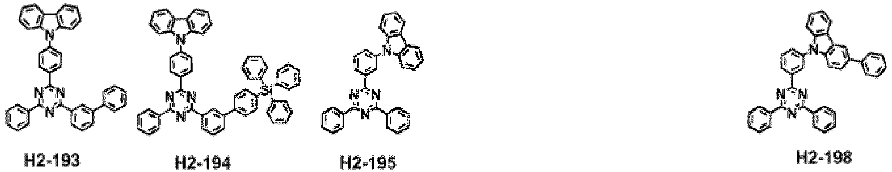

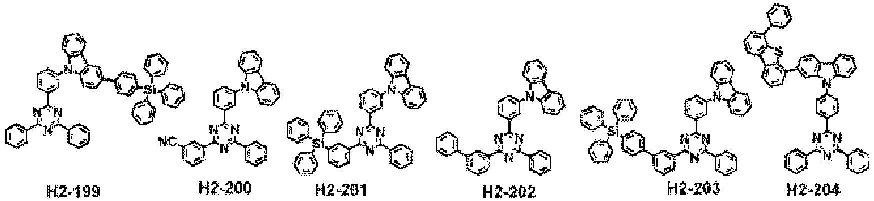

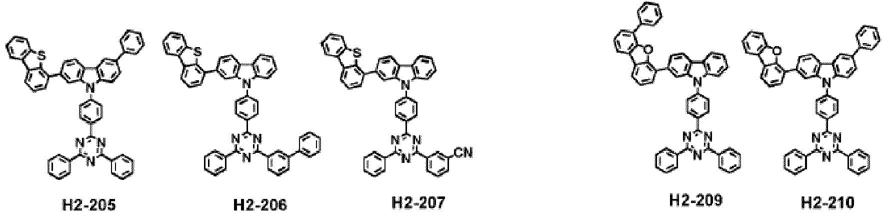

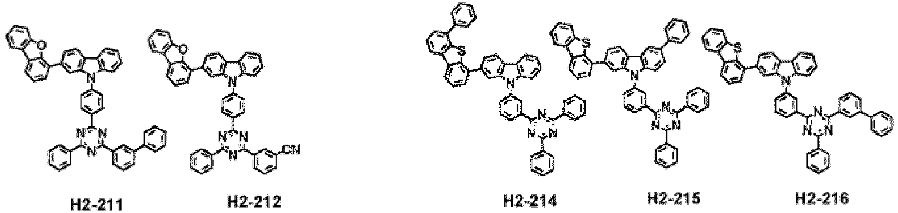

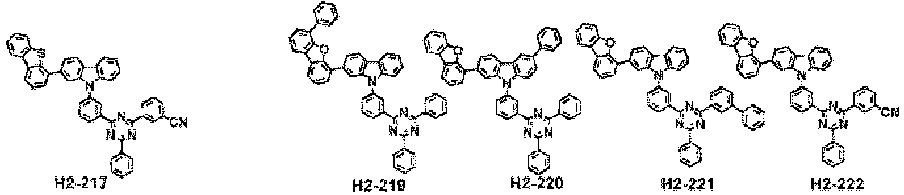

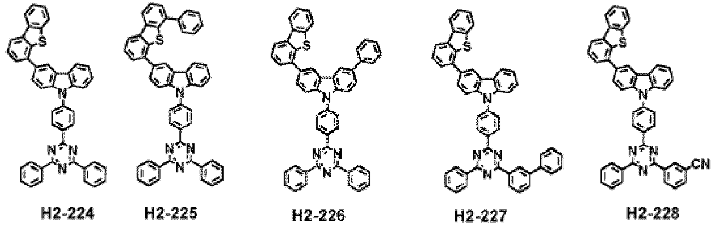

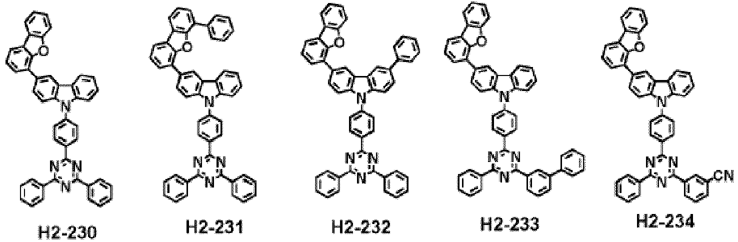

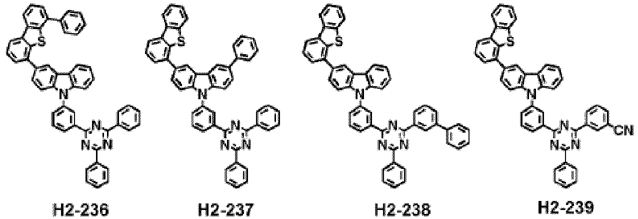

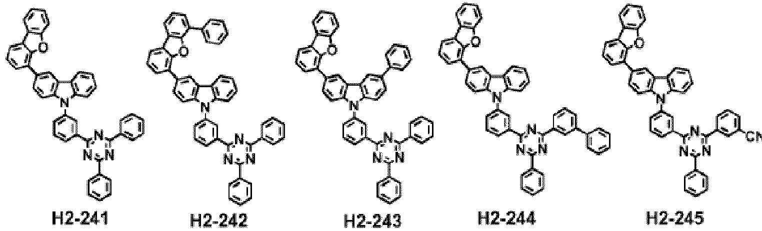

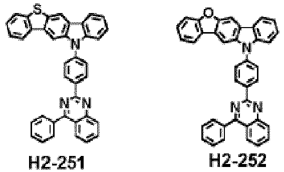

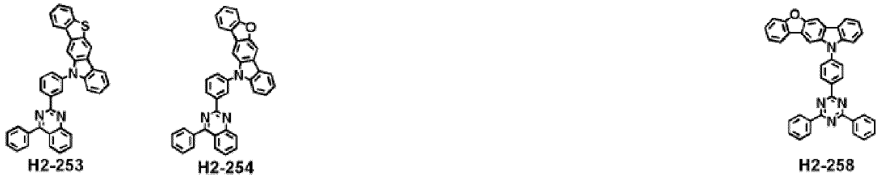

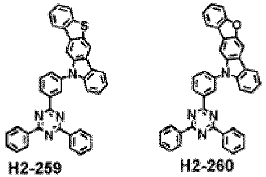

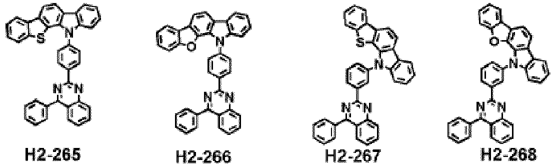

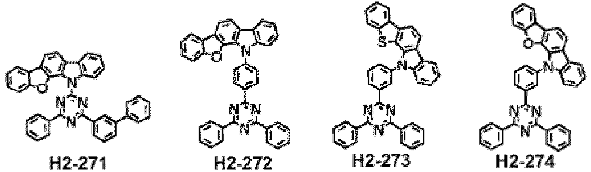

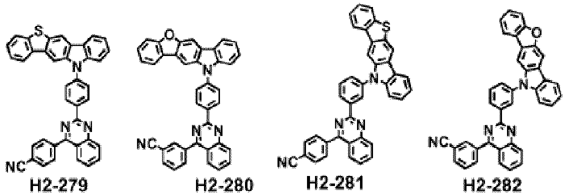

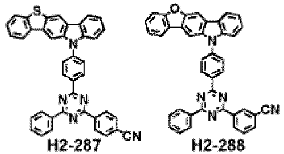

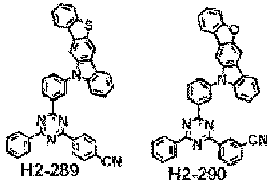

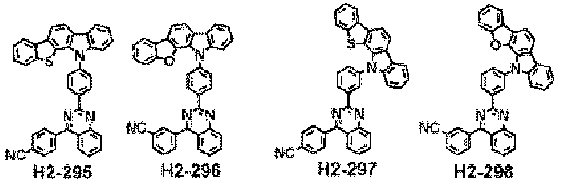

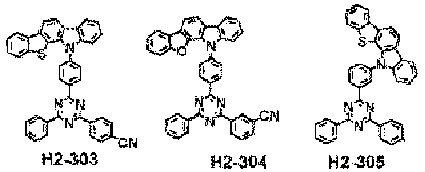

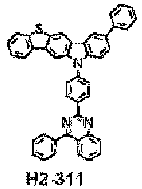

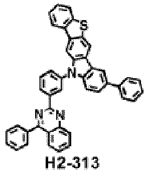

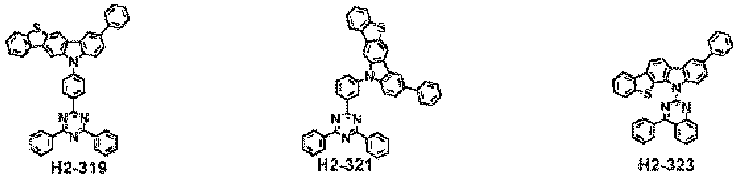

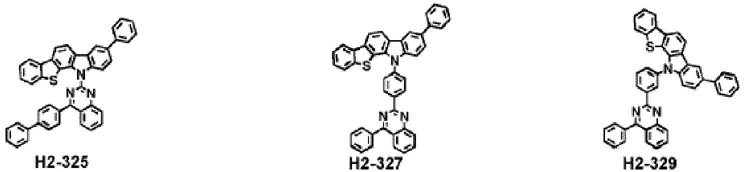

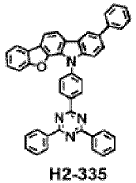

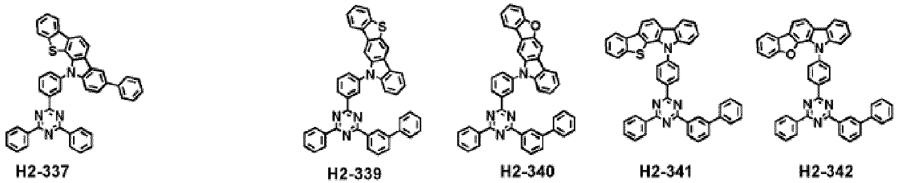

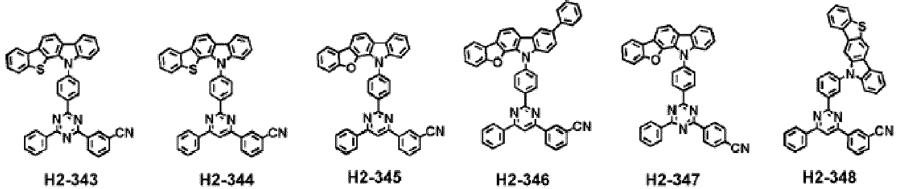

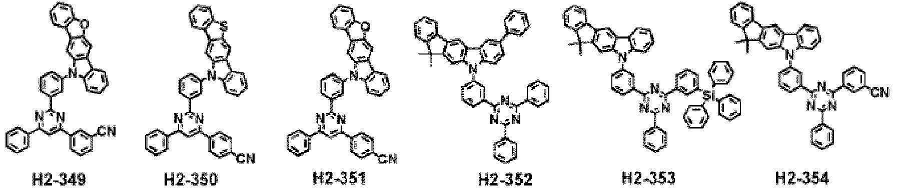

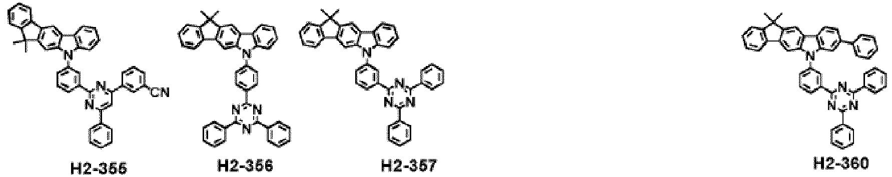

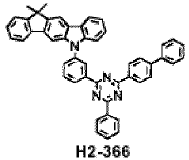

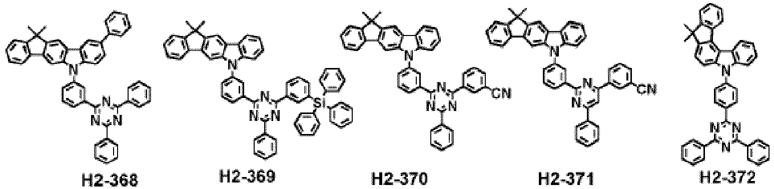

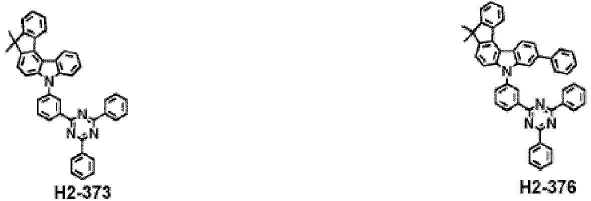

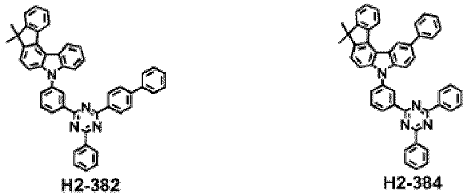

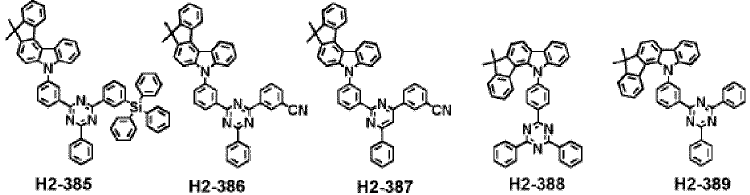

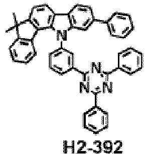

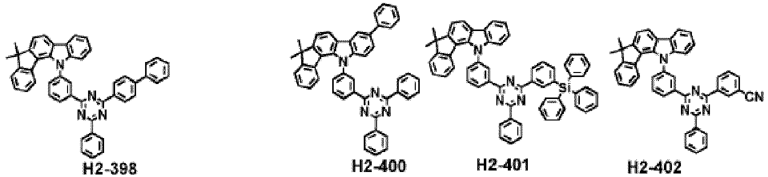

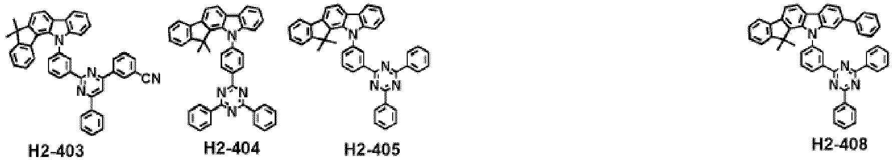

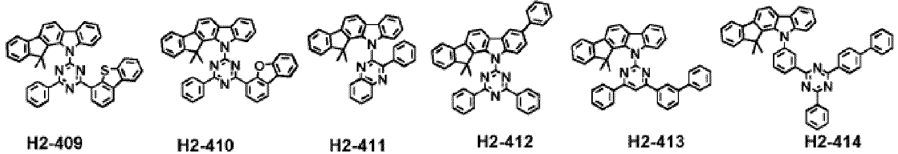

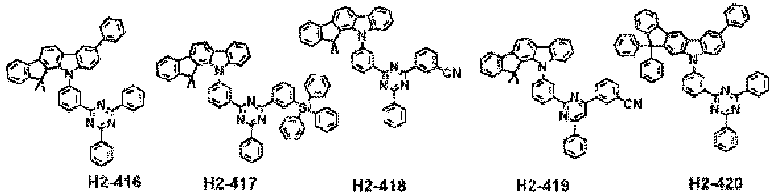

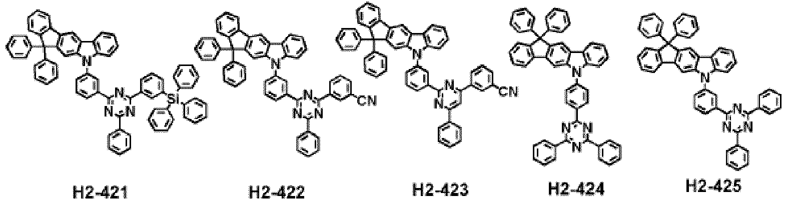

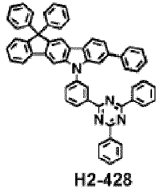

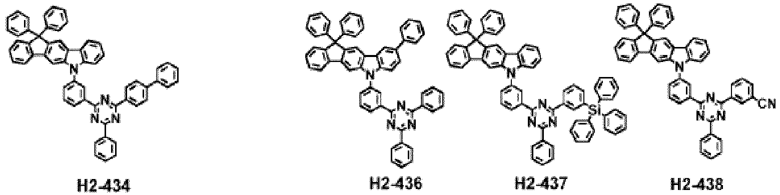

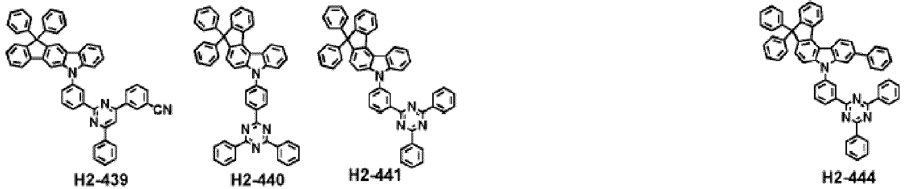

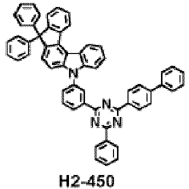

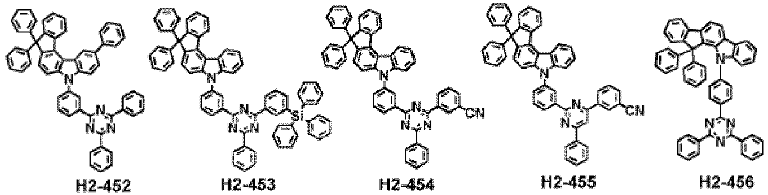

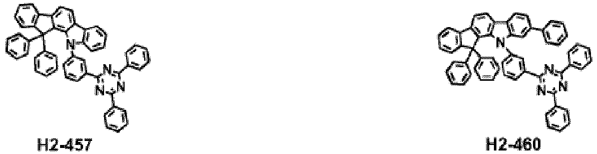

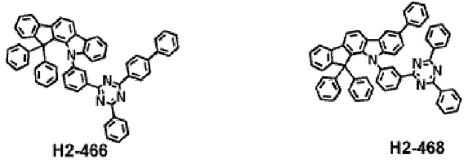

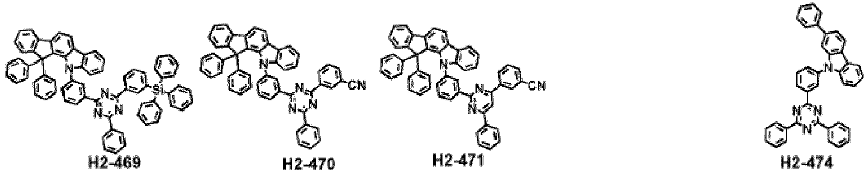

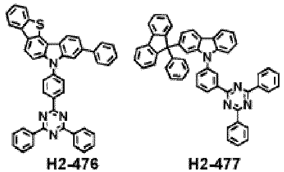

## Revendications

1. Dispositif électroluminescent organique comprenant au moins une couche émettant une lumière entre une anode et une cathode, dans lequel la couche émettant une lumière comprend un hôte et un dopant phosphorescent; l'hôte étant constitué de composés d'hôte à constituants multiples; au moins un premier composé d'hôte des composés d'hôte à constituants multiples est représenté par la formule 1 suivante qui est un dérivé de bicarbazole contenant une pyridine et un deuxième composé d'hôte est représenté par la formule 2 suivante qui est un dérivé de carbazole incluant un groupe hétéroaryle contenant de l'azote: 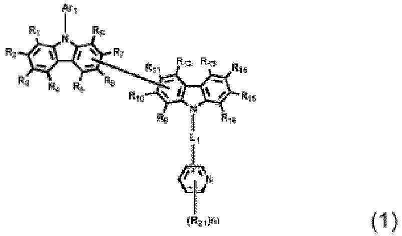 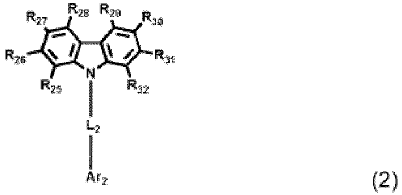 dans lesquelles:
Ar₁ représente un groupe (C6-C30)aryle substitué ou non substitué;
L₁ et L₂ représentent chacun indépendamment un groupe (C6-C18)arylène substitué ou non substitué, dans lequel le ou les substituant(s) du groupe arylène substitué de L₁ et L₂ est (sont) indépendamment choisi(s) dans le groupe constitué de: un hydrogène, un deutérium et un groupe (C6-C60)aryle non substitué;
R₁ à R₁₆ et R₂₁ représentent chacun indépendamment un hydrogène, un deutérium ou un groupe (C6-C60)aryle substitué ou non substitué;
dans lequel les substituants du groupe (C6-C60)aryle substitué de R₁ à R₁₆ et R₂₁ sont choisis dans le groupe constitué de: un (C1-C30)alkyle et un (C6-C30)aryle;
un de R₅ à R₈ est lié à un de R₉ à R₁₂ via une liaison simple;
R₂₅ à R₃₂ représentent chacun indépendamment un hydrogène, un deutérium, un groupe (C1-C30)alkyle substitué ou non substitué, un groupe (C2-C30)alcényle substitué ou non substitué, un groupe (C2-C30)alcynyle substitué ou non substitué, un groupe (C3-C30)cycloalkyle substitué ou non substitué, un groupe (C6-C60)aryle substitué ou non substitué, un groupe hétéroaryle de 3 à 30 membres substitué ou non substitué, dans lequel l'hétéroaryle de 3 à 30 membres est choisi dans le groupe constitué de dibenzofuranyle et de dibenzothiophényle, ou un groupe mono- ou di-(C6-C30)arylamino substitué ou non substitué; ou sont liés entre des substituants adjacents pour former un cycle (C3-C30) alicyclique ou aromatique, mono- ou polycyclique, substitué ou non substitué dont le cycle d'atome(s) de carbone peut être remplacé avec au moins un hétéroatome choisi parmi azote, oxygène et soufre;
Ar₂ représente un groupe hétéroaryle de 5 à 30 membres contenant de l'azote, substitué ou non substitué;
m représente 1; et
le groupe hétéroaryle de Ar₂ est choisi dans le groupe constitué de: triazinyle, pyrimidinyle, pyridazinyle, benzoimidazolyle, quinoléyle, isoquinoléyle, quinazolinyle, quinoxalinyle, naphtyridinyle et phénanthridinyle, qui peuvent être substitués avec un groupe (C6-C20)aryle, un groupe tri(C6-C12)arylsilyle, un groupe hétéroaryle de 5 à 15 membres contenant S ou O, un groupe (C6-C15)aryle substitué avec un groupe (C1-C6)alkyle ou un groupe (C6-C15)aryle substitué avec un groupe cyano.

2. Dispositif électroluminescent organique selon la revendication 1, dans lequel le composé de la formule 1 est représenté par l'une des formules 3 à 6 suivantes: 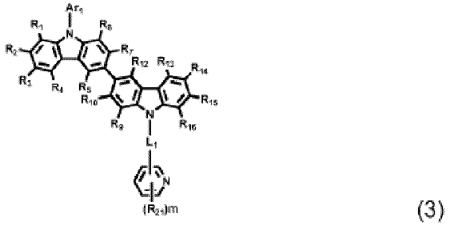 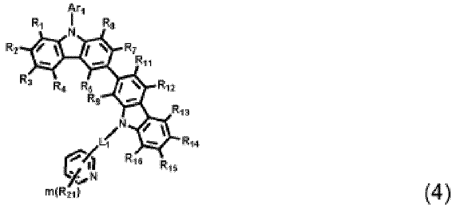 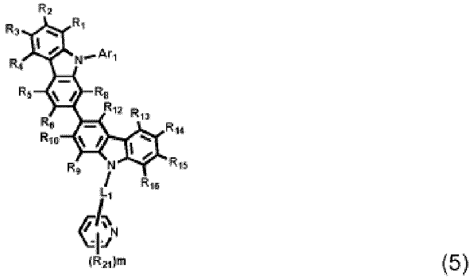 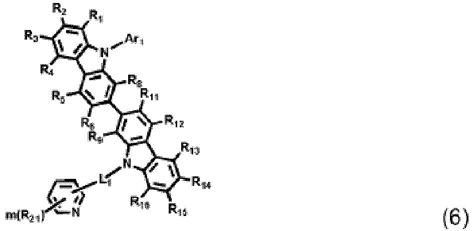 dans lesquelles:
Ar₁, L₁, R₁ à R₁₆, R₂₁ et m sont tels que définis dans la revendication 1.

3. Dispositif électroluminescent organique selon la revendication 1, dans lequel L₁ et L₂ dans les formules 1 et 2 représente un groupe (C6-C18)arylène non substitué.

4. Dispositif électroluminescent organique selon la revendication 1, dans lequel Ar₂ dans la formule 2 est: triazinyle, pyrimidinyle, quinoléyle, quinazolinyle, quinoxalinyle ou naphtyridinyle.

5. Dispositif électroluminescent organique selon la revendication 1, dans lequel le premier composé d'hôte représenté par la formule 1 est choisi dans le groupe constitué des composés suivants:

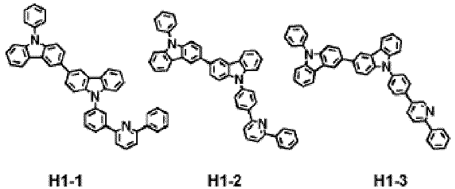

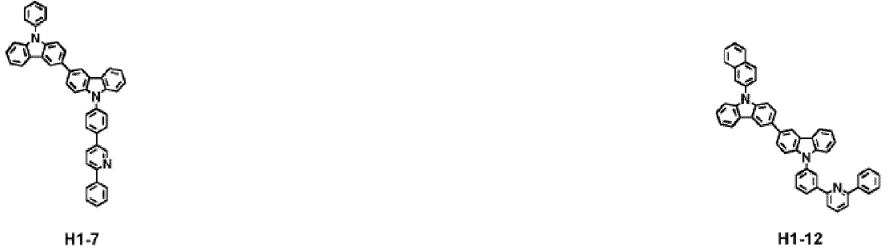

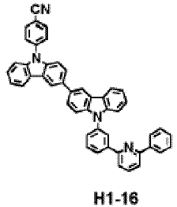

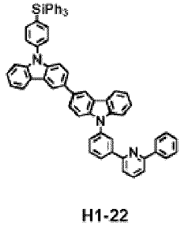

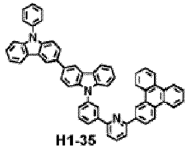

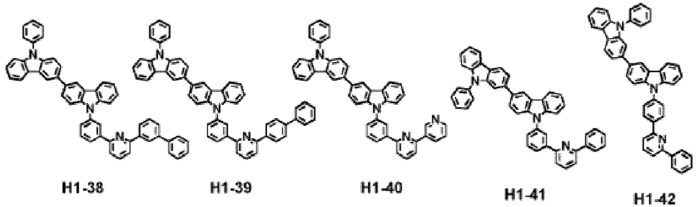

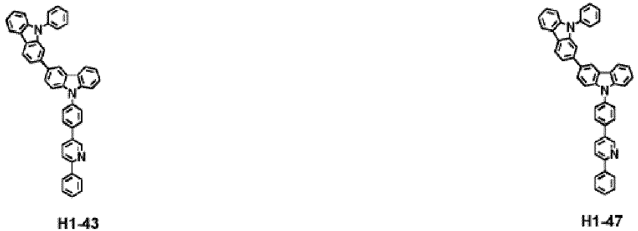

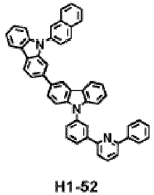

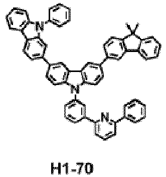

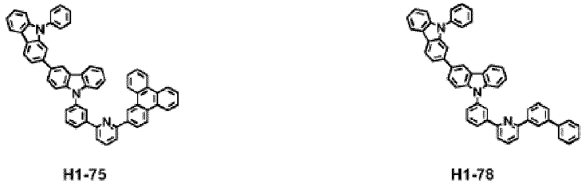

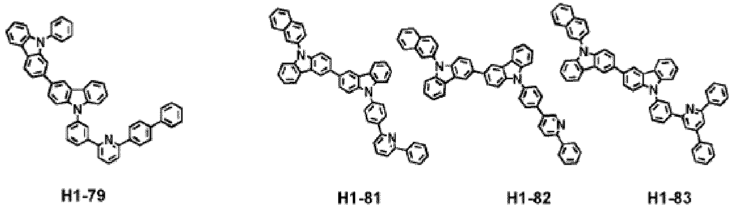

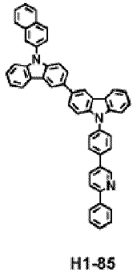

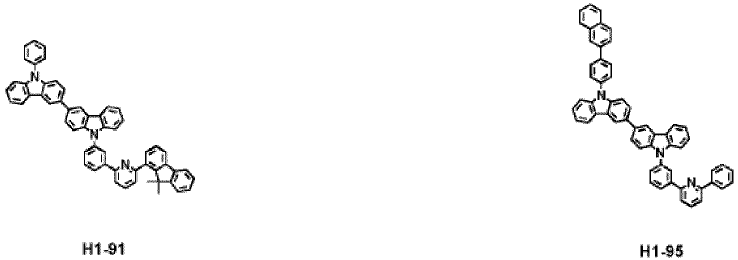

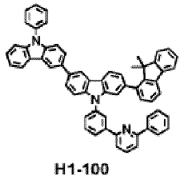

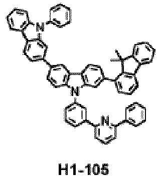

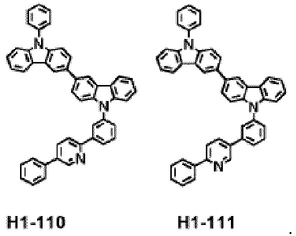

6. Dispositif électroluminescent organique selon la revendication 1, dans lequel le deuxième composé d'hôte représenté par la formule 2 est choisi dans le groupe constitué des composés suivants:
